# EUROPEAN PATENT APPLICATION

(11) **EP 2 905 820 A1**
(43) Date of publication of application: **12.08.2015**
(21) Application number: 13843402.2
(22) Date of filing: 30.09.2013
(51) Int. Cl.: H01L 51/50, C07D 215/12, C07D 401/04, C07D 401/14, C07D 403/14, C09K 11/06, G09F 9/30, H01L 27/32, H05B 33/10, H05B 33/12

(54) **ORGANIC ELECTROLUMINESCENT ELEMENT, ORGANIC EL LIGHTING AND ORGANIC EL DISPLAY DEVICE**

(30) Priority: 02.10.2012 JP 2012220399; 12.07.2013 JP 2013146649
(71) Applicant: Mitsubishi Chemical Corporation, Chiyoda-ku Tokyo 100-8251 (JP)
(72) Inventor: SHOUJI Yoshiko, Yokohama-shi Kanagawa 227-8502 (JP); NODA Yoshihiro, Yokohama-shi Kanagawa 227-8502 (JP); OKABE Kazuki, Yokohama-shi Kanagawa 227-8502 (JP); TAKAHASHI Atsushi, Yokohama-shi Kanagawa 227-8502 (JP)
(74) Representative: Vossius & Partner Patentanwälte Rechtsanwälte mbB
(86) International application number: PCT/JP2013/076591
(87) International publication number: WO 2014/054596

(57) **Abstract**

The object of the invention is to provide an organic electroluminescent element comprising a hole blocking layer capable of achieving a lower driving voltage. The invention relates to an organic electroluminescent element comprising: an anode, a cathode, a first luminescent layer formed by a wet film forming method, and a second luminescent layer formed by a vacuum evaporation method, wherein the first luminescent layer contains a phosphorescent material of a low-molecular-weight compound and a first charge transporting material, and the second luminescent layer contains a fluorescent material of a low-molecular-weight compound and a second charge transporting material, and the hole blocking layer, which is adjacent to the cathode side of the second luminescent layer, contains a specific compound.

## Description

### Technical Field

The present invention relates to an organic electroluminescent element, and an organic EL lighting and organic EL display that include the organic electroluminescent element.

### Background Art

Organic electroluminescent elements have been the subject of active development for light emitting devices such as displays and lighting. Such organic electroluminescent elements include organic thin films between electrodes, and positive and negative charges are injected into the organic thin films to extract light produced by the excited state resulting from the recombination of the charges.

Organic electroluminescent elements that use phosphorescence (emission by triplet excitons) instead of fluorescence (emission by singlet excitons) have been studied to improve emission efficiency. Phosphorescence is believed to improve efficiency about 3 fold from elements using fluorescence, and use of materials such as europium complexes, and platinum complexes as phosphorescence molecules has been reported. Organic electroluminescent elements using conventional phosphorescence molecules can achieve high-efficiency emission, but are insufficient for practical applications in terms of drive stability. It has been difficult to realize a high efficiency, long-life element.

Phosphorescence-based organic electroluminescent elements typically include a hole blocking layer on the cathode side of a light emitting layer to improve efficiency and lifetime. Conceivably, this improves efficiency by virtue of the confined excitons in the light emitting layer (Patent Literature 1), and achieves a longer life by preventing the holes from deteriorating the layers that are closer to the cathode than the light emitting layer. The preferred materials of the hole blocking layer are, for example, pyridine compounds

### (Patent Literature 2).

Deterioration of emission characteristics and lifetime may be prevented by not providing a hole blocking layer in a fluorescence-based organic electroluminescent element (Patent Literature 3). In terms of driving voltage, there appears to be cases where the driving voltage decreases by not providing a hole blocking layer.

There have been studies of white emitting organic electroluminescent elements as alternative devices for white lighting such as a fluorescent lamp. As an example, Patent Literature 4 discloses a method for obtaining a white emitting organic electroluminescent element. The organic electroluminescent element disclosed in this publication achieves a white emission with two light emitting layers, specifically a laminate of a yellow to red light emitting layer and a blue emitting layer.

### Citation List

### Patent Literature

Patent Literature 1: JP-A-2001-284056
Patent Literature 2: JP-A-2012-033918
Patent Literature 3: JP-A-2006-156848
Patent Literature 4: JP-A-2008-159367

### Summary of Invention

### Technical Problem

A white emission can be achieved with two light emitting layers of different emission colors by laminating a fluorescent material and a phosphorescent material as above. However, there has been no thorough investigation of such a configuration as to how the fluorescent material and the phosphorescent material should be laminated, and which hole blocking layer material should be used.

The present invention has been made under these circumstances, and it is an object of the present invention to achieve a mixed-color emission, preferably a white emission in an organic electroluminescent element provided with a laminate of a phosphorescent material-containing light emitting layer and a fluorescent material-containing light emitting layer, specifically an organic electroluminescent element that has a light emitting layer configuration capable of achieving more desirable emission characteristics, and that includes a hole blocking layer capable of lowering the driving voltage.

### Solution to Problem

In order to achieve the foregoing object, the features of the organic electroluminescent element, the organic EL lighting, and the organic EL display of the present invention lie in the following <1> to <10>.
<1> An organic electroluminescent element comprising an anode, a cathode, and a plurality of light emitting layers formed between the anode and the cathode,
   wherein the plurality of light emitting layers includes a first light emitting layer formed by using a wet film forming method, and a second light emitting layer formed by using a vacuum evaporation method, in this order from the anode side,
   the first light emitting layer contains a phosphorescent material and a first charge transporting material, both of which are a low-molecular-weight compound,
   the second light emitting layer contains a fluorescent material and a second charge transporting material, both of which are a low-molecular-weight compound,
   the organic electroluminescent element includes a hole blocking layer adjacent to the cathode side of the second light emitting layer, and
   the hole blocking layer contains a compound represented by the following formula (1): 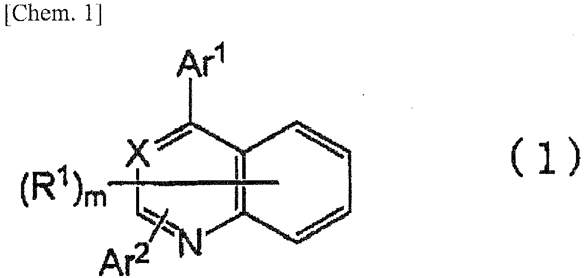 wherein X represents C or N, Ar¹ and Ar² each independently represents an optionally substituted aromatic ring group, R¹ represents an optionally substituted organic group of 50 or less carbon atoms, and may be the same or different when a plurality of R¹ exists, and m represents an integer of 0 to 5.
<2> The organic electroluminescent element according to the <1> above, wherein the compound represented by the formula (1) is a compound represented by the following formula (2): 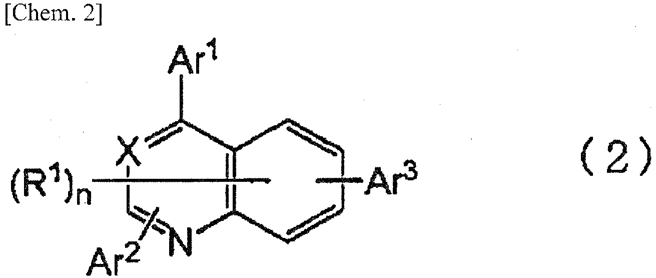 wherein X represents C or N, Ar¹ to Ar³ each independently represents an optionally substituted aromatic ring group, R¹ represents an optionally substituted organic group of 50 or less carbon atoms, and may be the same or different when a plurality of R¹ exists, and n represents an integer of 0 to 4.
<3> The organic electroluminescent element according to the <2> above, wherein the compound represented by the formula (2) is a compound represented by the following formula (3): 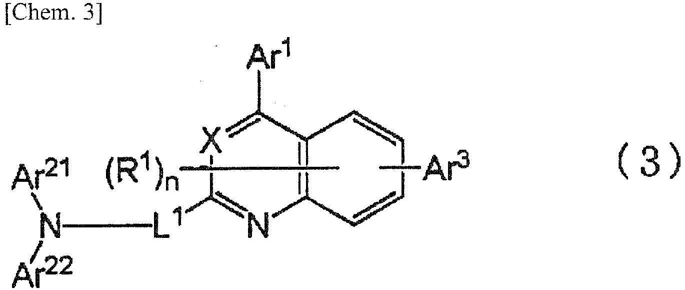 wherein X represents C or N, Ar¹, Ar³, Ar²¹, and Ar²² each independently represents an optionally substituted aromatic ring group, and Ar²¹ and Ar²² may be bonded to each other to form a ring, R¹ represents an optionally substituted organic group of 50 or less carbon atoms, and may be the same or different when a plurality of R¹ exists, L¹ represents a single bond, or an optionally substituted aromatic ring group of 25 or less carbon atoms, and n represents an integer of 0 to 4.
<4> The organic electroluminescent element according to the <3> above, wherein the compound represented by the formula (3) is a compound represented by the following formula (4): 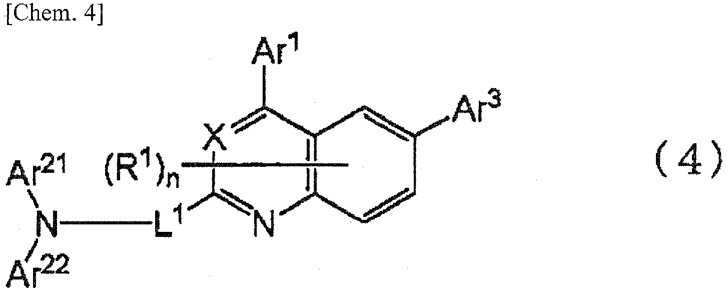 wherein X represents C or N, Ar¹, Ar³, Ar²¹, and Ar²² each independently represents an optionally substituted aromatic ring group, and Ar²¹ and Ar²² may be bonded to each other to form a ring, R¹ represents an optionally substituted organic group of 50 or less carbon atoms, and may be the same or different when a plurality of R¹ exists, L¹ represents a single bond, or an optionally substituted aromatic ring group of 25 or less carbon atoms, and n represents an integer of 0 to 4.
<5> The organic electroluminescent element according to any one of the <1> to <4> above, wherein Ar¹ in at least one of the formulae (1) to (4) is an aromatic hydrocarbon group.
<6> The organic electroluminescent element according to any one of the <1> to <5> above, wherein the organic electroluminescent element has an emission spectrum having a maximum emission wavelength in at least two of the 440 to 500 nm region, the 500 to 580 nm region, and the 580 to 630 nm region.
<7> The organic electroluminescent element according to any one of the <1> to <6> above, which comprises a hole transport layer between the anode and the light emitting layers.
<8> The organic electroluminescent element according to the <7> above, wherein the hole transport layer is a layer formed by using a wet film forming method.
<9> An organic EL lighting comprising the organic electroluminescent element of any one of the <1> to <8> above.
<10> An organic EL display comprising the organic electroluminescent element of any one of the <1> to <8> above.

### Advantageous Effects of Invention

The present invention can provide a low-driving-voltage organic electroluminescent element capable of achieving a mixed-color emission, preferably a white emission.

The organic electroluminescent element of the present invention has potential application in areas where the surface emitting characteristic can be exploited, including, for example, white light sources (for example, the light source of copiers, the backlight light source of liquid crystal displays and instruments, and color filter display devices), display boards, and marker lights. The organic electroluminescent element thus has high technical values.

### Brief Description of Drawings

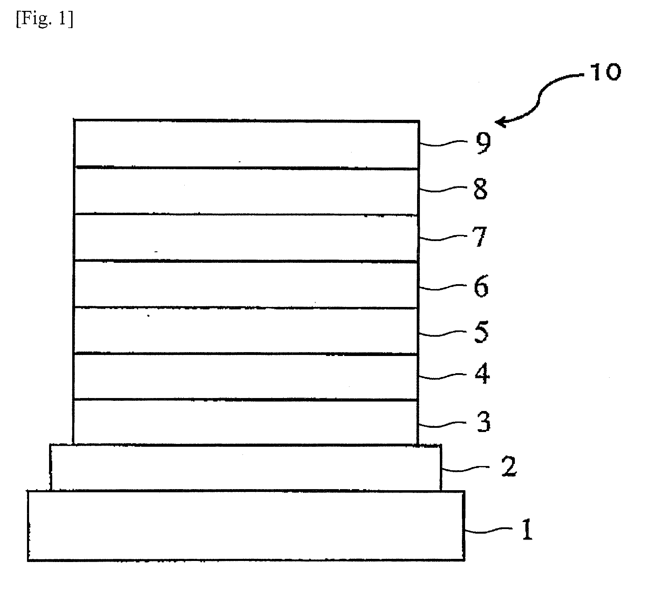

FIG. 1 is a cross sectional view schematically representing an exemplary structure of an organic electroluminescent element of the present invention.

### Description of Embodiments

Embodiments of the present invention are described below in detail. It should be noted that the present invention is not limited by the following embodiments, and may be applied in many variations within the gist of the present invention.

### [Explanations of Terms]

As used herein, the term "heterocyclic ring" or "hydrocarbon ring" refers to rings with and without aromaticity. The term "aromatic ring" as used herein encompasses both aromatic hydrocarbon rings and aromatic heterocyclic rings.

As used herein, "aromatic ring group" means not only groups derived from monocyclic aromatic rings, and groups derived from fused rings that have had two or more rings fused to each other, but groups in which two or more such monocyclic and/or fused rings are joined to each other via a single bond. As used herein, "group derived from a ring" means a ring with a free valency corresponding to the number of bonds. The term "free valency" as used herein refers to the connectivity of elements with other elements, as described in Nomenclatures in Organic Chemistry and Biochemistry (Vol. 1, 2nd Edition, Nankodo, 1992). Specifically, for example, a benzene ring with a free valency of 1 means a phenyl group, and a benzene ring with a free valency of 2 means a phenylene group.

As used herein, "optionally substituted" means that one or more substituents may be contained.

The term "(hetero)aryl" as used herein means both "aryl" and "heteroaryl". The term "aryl group" means both "aromatic hydrocarbon group" and "aromatic heterocyclic group".

As used herein, the notation "440 nm to 500 nm" means 440 nm or more to less than 500 nm.

### Organic Electroluminescent Element

The organic electroluminescent element of the present invention includes an anode, a cathode, and a plurality of light emitting layers formed between the anode and the cathode. The light emitting layers include a first light emitting layer formed by using a wet film forming method (hereinafter, also referred to as "coated light emitting layer"), and a second light emitting layer formed by using a vacuum evaporation method (hereinafter, also referred to as "vapor deposited light emitting layer"), in this order from the anode side. The coated light emitting layer contains a phosphorescent material and a first charge transporting material both of which are a low-molecular-weight compound. The vapor deposited light emitting layer contains a fluorescent material and a second charge transporting material both of which are a low-molecular-weight compound. The organic electroluminescent element has a hole blocking layer adjacent the cathode side of the vapor deposited light emitting layer, and the hole blocking layer contains a compound represented by the following formula (1). 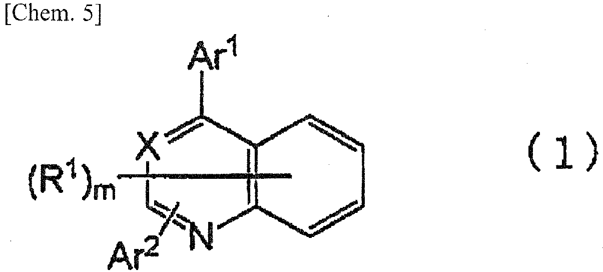 (In the formula (1), X represents C or N, Ar¹ and Ar² each independently represent an optionally substituted aromatic ring group. R¹ represents an optionally substituted organic group of 50 or less carbon atoms, and may be the same or different when a plurality of R¹ exists. m represents an integer of 0 to 5.)

The coated light emitting layer and the vapor deposited light emitting layer of the present invention use the low-molecular-weight compound, specifically the light-emitting material, and the first or second charge transporting material (hereinafter, the first and second charge transporting materials will also be collectively referred to as "charge transporting materials") for the following reasons.

In the light emitting layer that contains a polymeric charge transport material and a low-molecular-weight light emitting material, it is very difficult to control and confine the interval of the charge transport units linked by polymer chains in the polymeric charge transport material within a distance that makes it easier to transport charges or move excitons.

The wet film formation and the vacuum evaporation using the low-molecular-weight charge transport material produce high film density than the wet film formation using the high molecular weight charge transport material, and improve the intermolecular adhesion at the coating/evaporation interface. This is preferable as it makes it easier to give and receive charges, and lower the voltage.

For this reason, a low-molecular-weight compound is used for all the light emitting layer materials used in the organic electroluminescent element of the present invention.

The organic electroluminescent element of the present invention preferably further includes a hole transport layer between the anode and the light emitting layer, because it allows the holes to be sufficiently injected into the light emitting layer closest to the cathode.

### Low- Molecular-Weight compound

The coated light emitting layer and the vapor deposited light emitting layer as the light emitting layers of the organic electroluminescent element of the present invention contain a light-emitting material and a first or second charge transporting material both of which are low molecular compounds.

The molecular weight of the "low molecular compound" as used herein is typically 10,000 or less, preferably 5,000 or less, more preferably 4,000 or less, further preferably 3,000 or less, and typically 100 or more, preferably 200 or more, more preferably 300 or more, further preferably 400 or more.

An excessively small molecular weight of the material used to form the light emitting layer may cause various problems, including considerably low heat resistance, gas generation, formation of a low-quality film, and morphology changes in the organic electroluminescent element due to migration. On the other hand, an excessively large molecular weight of the light emitting material may make it difficult to purify the organic compounds, or increase the time required to dissolve in solvent.

Confining the molecular weight of the material of the light emitting layer in the foregoing ranges is advantageous, because it provides a high glass transition temperature, a high melting point, and a high degradation temperature, and desirable heat resistance for the light emitting layer material and the resulting light emitting layer. Other advantages are that lowering of film quality due to recrystallization or molecule migration, and increased impurity concentration associated with the material pyrolysis are unlikely to occur. The unlikelihood of element performance drop, and ease of purification are also advantages.

When the light emitting layer of the organic electroluminescent element of the present invention includes a compound other than the light emitting material and the charge transport material, the compound is preferably a low-molecular-weight compound with a molecular weight of preferably 10,000 or less, more preferably 5,000 or less, further preferably 4,000 or less, particularly preferably 3,000 or less, and preferably 100 or more, more preferably 200 or more, further preferably 300 or more, particularly preferably 400 or more.

### Maximum Emission Wavelength of Emission Spectrum

The organic electroluminescent element of the present invention preferably has an emission spectrum with a maximum emission wavelength occurring in at least two of the 440 to 500 mm region, the 500 to 580 nm region, and the 580 to 630 nm region.

The organic electroluminescent element of the present invention with such an emission spectrum may be obtained, for example, by appropriately selecting and using a light emitting material for the light emitting layer so that the emission spectrum of the organic electroluminescent element has a maximum emission wavelength in at least two of the 440 to 500 nm region, the 500 to 580 nm region, and the 580 to 630 nm region.

The organic electroluminescent element of the present invention may be designed with a color filter, a polarizing plate, a retardation plate, a diffusion plate, a fluorescence conversion film, or the like to have a maximum emission wavelength in each region. However, it is preferable in the organic electroluminescent element of the present invention to appropriately select and use a light emitting material for the light emitting layer so that the emission spectrum of the organic electroluminescent element has a maximum emission wavelength in the 440 to 500 nm region, the 500 to 580 nm region, and the 580 to 630 nm region.

### Emission Spectrum Measurement Method

The emission spectrum of the organic electroluminescent element of the present invention may be measured by using, for example, a spectroscope USB4000 (Ocean Optics).

The emission spectrum measurement device is not limited to the device exemplified above, and other measurement devices may be used, provided that the devices are equivalent in terms of measurement capability.

### Light Emitting Layer

The light emitting layer of the present invention is a layer that serves as the main light source upon being excited by the recombination of the holes and the electrons injected from the anode and the cathode, respectively, under an applied electric field across the electrodes. As described above, the light emitting layer includes a coated light emitting layer containing a phosphorescent material and a first charge transport material both of which are a low-molecular-weight compound, and a vapor deposited light emitting layer containing a fluorescent material and a second charge transport material both of which are a low-molecular-weight compound, in this order from the anode side.

Because the light emitting layer includes the coated light emitting layer and the vapor deposited light emitting layer provided in this order from the anode side, the light emitting layer can be obtained as a film of uniform quality. Further, high efficiency can be obtained with the phosphorescent material contained in the coated light emitting layer, and sufficient emission intensity can be obtained with the fluorescent material contained in the vapor deposited light emitting layer. Further, the luminescence efficiency of the organic electroluminescent element can improve by the following mechanism of action with the fluorescent material-containing vapor deposited light emitting layer laminated on the phosphorescent material-containing coated light emitting layer.

First, a composition containing a phosphorescent material and a first charge transport material is deposited by wet film formation as the first light emitting layer. The phosphorescent material is typically a complex that contains metal atoms of large atomic weights such as Ir and Pt. Because the compound containing metal atoms of large atomic weights has lower surface energy and is chemically more stable outside of the outermost surface of the film, it is believed that the phosphorescent material hardly exists on the outermost surface in the presence of a solvent, and that the first charge transport material exists in abundance in the extremely thin region on the outermost surface of the dried film.

The region with the abundant first charge transport material is believed to block the transfer of energy from the fluorescent material of the overlying second light emitting layer (vapor deposited light emitting layer) to the phosphorescent material of the first light emitting layer. This is believed to cause sufficient emission in both the first and second light emitting layers, and provide the organic electroluminescent element of high luminescence efficiency.

In the organic electroluminescent element of the present invention, fluorescent material is used as the light emitting material of the second light emitting layer (vapor deposited light emitting layer), because use of phosphorescent material as the light emitting material of the vapor deposited light emitting layer has the possibility of causing the following problems.

Specifically, as described above, the phosphorescent material is a large-molecular-weight molecule containing metal atoms of large atomic weights, and accordingly the air-borne molecules occurring in the vacuum evaporation has large heat energy. If the phosphorescent material is used as the light emitting material of the second light emitting layer formed on the first light emitting layer by the vacuum evaporation, the phosphorescent material molecules of large heat energy would collide with the first light emitting layer and damage the larger surface. The damaged flat surface (interface) promotes aggregation of the materials contained in the layer, and the aggregates cause charge trapping.

Further, because the characteristic barrier function of the element of the present invention by the first charge transport material on the first light emitting layer surface is lost by the air-borne phosphorescent material molecules occurring in the evaporation, there is a risk of the triplet energy in the first light emitting layer being transferred to the second light emitting layer, causing insufficient emission in the first light emitting layer, and possibly disrupting the color balance in the emitted light.

### Light Emitting Material

### Fluorescent Material

The fluorescent material used as light emitting material in the vapor deposited light emitting layer is described below.

### (1) 440 to 500 nm region (blue)

The fluorescent material (blue fluorescent dye) for providing blue emission with the maximum emission wavelength in 440 to 500 nm region may be, for example, naphthalene, chrysene, perylene, pyrene, anthracene, coumalin, p-bis(2-phenylethenyl)benzene, arylamine, or a derivative thereof, of which anthracene, chrysene, pyrene, arylamine, and derivatives thereof are preferred.

Styrylamine compounds, and arylamine compounds are particularly preferred because of high blue color purity, high efficiency, and longevity.

For efficient trapping of the holes in the light emitting layer, styrylamine compounds represented by the following formula (A) are preferable. 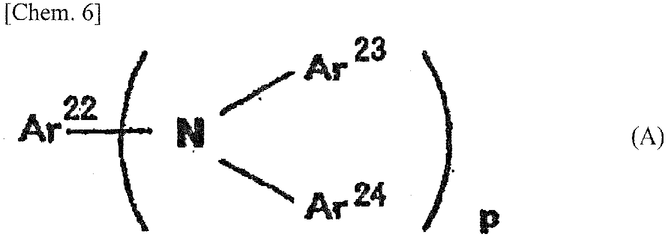 (In the formula (A), Ar²² is biphenyl, terphenyl, stilbene, or distyrylaryl, Ar²³ and Ar²⁴ are each independently a hydrogen atom, or an aromatic group of 6 to 20 carbon atoms, and each independently may be the same or different when a plurality of Ar²³ and a plurality of Ar²⁴ exist. Ar²² to Ar²⁴ may have a substituent. p is an integer of 1 to 4.)

Preferably, at least one of Ar²³ and Ar²⁴ in formula (A) is a styryl-substituted aromatic group of 6 to 20 carbon atoms.

Examples of the aromatic group of 6 to 20 carbon atoms include aromatic hydrocarbon groups such as phenyl, naphthyl, anthryl, phenanthryl, and terphenyl.

For efficient trapping of the holes in the light emitting layer, arylamine compounds represented by the following formula (B) are preferable. 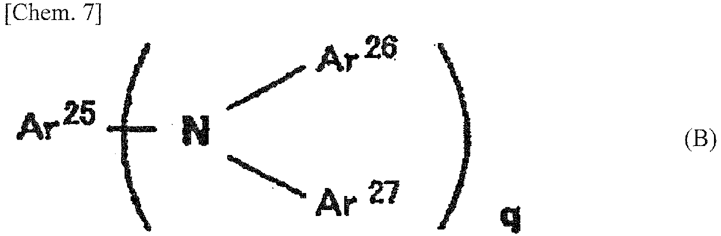 (In the formula (B), Ar²⁵ is substituted or unsubstituted aryl of 10 to 40 nuclear carbon atoms, Ar²⁶ and Ar²⁷ are each independently substituted or unsubstituted aryl of 5 to 40 nuclear carbon atoms. q is an integer of 1 to 4.)

Examples of the aryl of 10 to 40 nuclear carbon atoms represented by Ar²⁵ include naphthyl, anthryl, phenanthryl, pyrenyl, chrysenyl, coronyl, biphenyl, terphenyl, diphenylanthryl, carbazolyl, benzoquinolyl, fluoranthenyl, acenaphthofluoranthenyl, and stilbene.

Examples of the aryl of 5 to 40 nuclear carbon atoms represented by Ar²⁶ and Ar²⁷ include phenyl, naphthyl, anthryl, phenanthryl, pyrenyl, chrysenyl, coronyl, biphenyl, terphenyl, pyrrolyl, furanyl, thienyl, benzothienyl, oxadiazolyl, diphenylanthryl, indolyl, carbazolyl, pyridyl, benzoquinolyl, fluoranthenyl, acenaphthofluoranthenyl, and stilbene.

When the aryl has a substituent, preferred examples of the substituent include alkyl of 1 to 6 carbon atoms (such as ethyl, methyl, i-propyl, n-propyl, s-butyl, t-butyl, pentyl, hexyl, cyclopentyl, and cyclohexyl), alkoxy of 1 to 6 carbon atoms (such as ethoxy, methoxy, i-propoxy, n-propoxy, s-butoxy, t-butoxy, pentoxy, hexyloxy, cyclopentoxy, and cyclohexyloxy), aryl of 5 to 40 nuclear atoms, amino groups substituted with aryl of 5 to 40 nuclear atoms, ester groups having aryl of 5 to 40 nuclear atoms, ester groups having alkyl of 1 to 6 carbon atoms, cyano, nitro, and halogen atoms.

The following presents specific preferred examples of the blue emission-producing fluorescent materials used in the present invention. The present invention, however, is not limited to these.

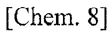

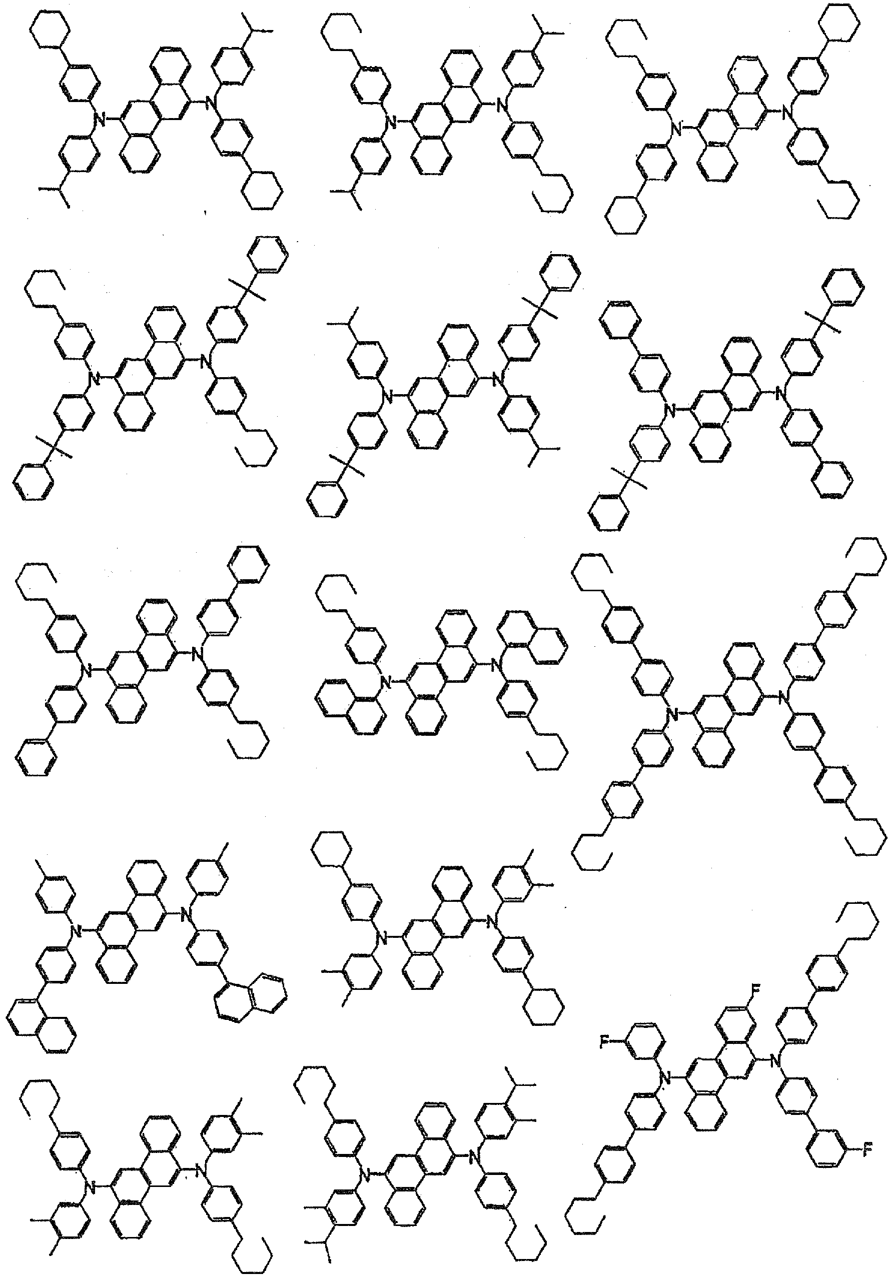

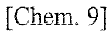

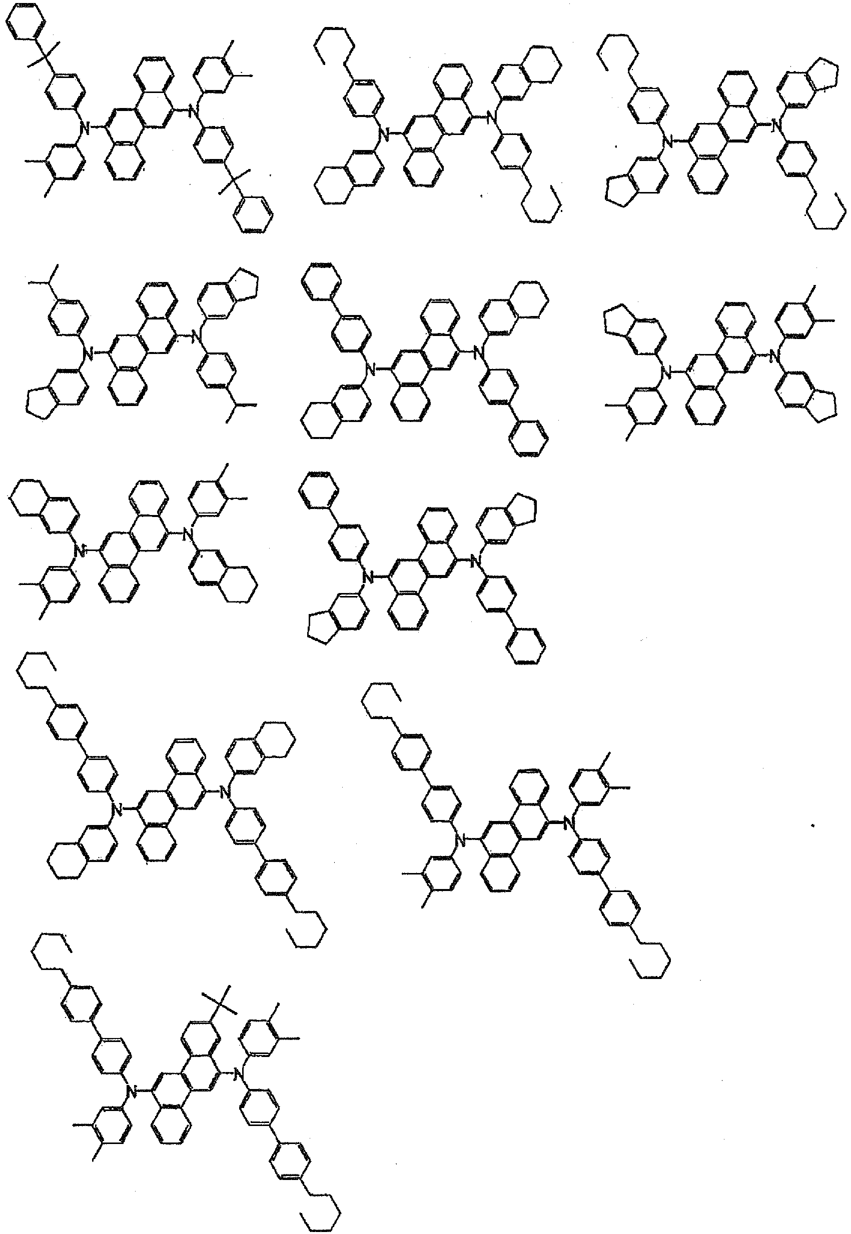

The blue emission-producing fluorescent materials may be use either alone, or in any combination and proportion of two or more.

### (2) 500 to 580 nm region (green)

The fluorescent material (green fluorescent dye) for providing green emission with the maximum emission wavelength in 500 to 580 nm region may be, for example, quinacridone, coumalin, an aluminum complex such as Al(C₉H₆NO)₃, or a derivative thereof. These may be used either alone, or in any combination and proportion of two or more.

### (3) 580 to 630 nm region (red)

The fluorescent material (red fluorescent dye) for providing red emission with the maximum emission wavelength in 580 to 630 nm region may be, for example, a DCM(4-(dicyanomethylene)-2-methyl-6-(p-dimethylaminostyryl)-4H-pyran) compound, benzopyran, rhodamine, xanthene such as benzothioxanthene and azabenzothioxanthene, or a derivative thereof. These may be used either alone, or in any combination and proportion of two or more.

### Phosphorescent Material

The phosphorescent material used as light emitting material in the coated light emitting layer is described below.

Examples of the phosphorescent material include Werner-type complexes or organic metal complexes that contain a center metal selected from Group 7 to 11 of the long form periodic table (in the following, "periodic table" refers to the long form periodic table, unless otherwise stated).

Preferred examples of the metals selected from Group 7 to 11 of the periodic table include ruthenium, rhodium, palladium, silver, rhenium, osmium, iridium, platinum, and gold, more preferably iridium and platinum.

The complex ligand is preferably a ligand in which (hetero)aryl such as a (hetero)arylpyridine ligand, and a (hetero)arylpyrazole ligand is joined to compounds such as pyridine, pyrazole, and phenanthroline, particularly preferably a phenylpyridine ligand, and a phenylpyrazole ligand. Here, (hetero)aryl means aryl or heteroaryl.

Specific examples of the phosphorescent material include tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethyl platinum porphyrin, octaphenyl platinum porphyrin, octaethyl palladium porphyrin, and octaphenyl palladium porphyrin.

Particularly preferred as the phosphorescent organic metal complex of the phosphorescent material are compounds represented by the following formula (III) or (IV).
[Chem. 10]

ML₍ᵢ₋ⱼ₎L'ⱼ (III)

(In the formula (III), M represents a metal, and i represents the valency of the metal M. L and L' each independently represent bidentate ligands, and may be the same or different when a plurality of L and a plurality of L' exist. j represents a number 0, 1, or 2.) 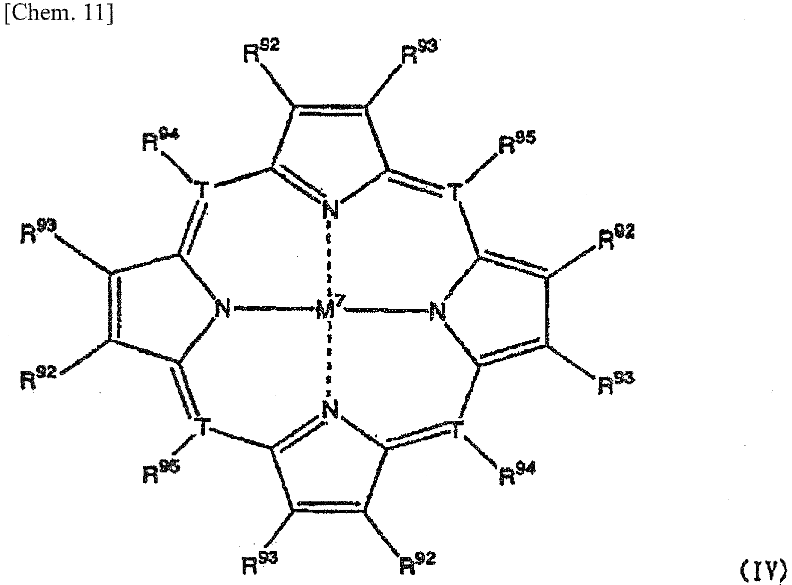 (In the formula (IV), M⁷ represents a metal, and T represents a carbon atom or a nitrogen atom. R⁹² to R⁹⁵ each independently represent a substituent. When T is a nitrogen atom, R⁹⁴ or R⁹⁵ that directly binds to the nitrogen atom T does not exist. The plurality of T, and the plurality of R⁹² to R⁹⁵ may be the same or different.)

Compounds represented by formula (III) are described below.

In the formula (III), M represents any metal, preferably the metals specifically exemplified above as metals selected from Group 7 to 11 of the periodic table.

In the formula (III), the bidentate ligand L represents a ligand having the following partial structure.

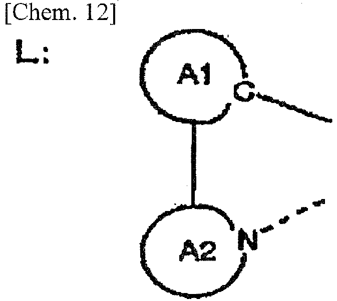

In the partial structure of L, ring A1 represents an aromatic hydrocarbon group or aromatic heterocyclic group that may have a substituent.

Examples of the aromatic hydrocarbon group include groups derived from a five-or six-membered monocyclic ring or fused rings of 2 to 5 five- or six-membered rings.

Specific examples include monovalent groups derived from a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a fluoranthene ring, and a fluorene ring.

Examples of the aromatic heterocyclic group include groups derived from a five-or six-membered monocyclic ring or fused rings of 2 to 4 five- or six-membered rings.

Specific examples include monovalent groups derived from a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a perimidine ring, a quinazoline ring, a quinazolinone ring, and an azulene ring.

In the partial structure of L, ring A2 represents a nitrogen-containing aromatic heterocyclic group that may have a substituent.

Examples of the nitrogen-containing aromatic heterocyclic group include groups derived from a five- or six-membered monocyclic ring or fused rings of 2 to 4 five- or six-membered rings.

Specific examples include monovalent groups derived from a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a furopyrrole ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a quinoxaline ring, a phenanthridine ring, a perimidine ring, a quinazoline ring, and a quinazolinone ring.

Examples of the substituent of the ring A1 or ring A2 include halogen atoms, alkyl, alkenyl, aralkyl, alkoxycarbonyl, alkoxy, aryloxy, dialkylamino, diarylamino, carbazolyl, acyl, haloalkyl, cyano, and aromatic hydrocarbon groups.

In the formula (III), the bidentate ligand L' represents a ligand having the following partial structures. In the formula, "Ph" represents phenyl.

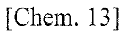

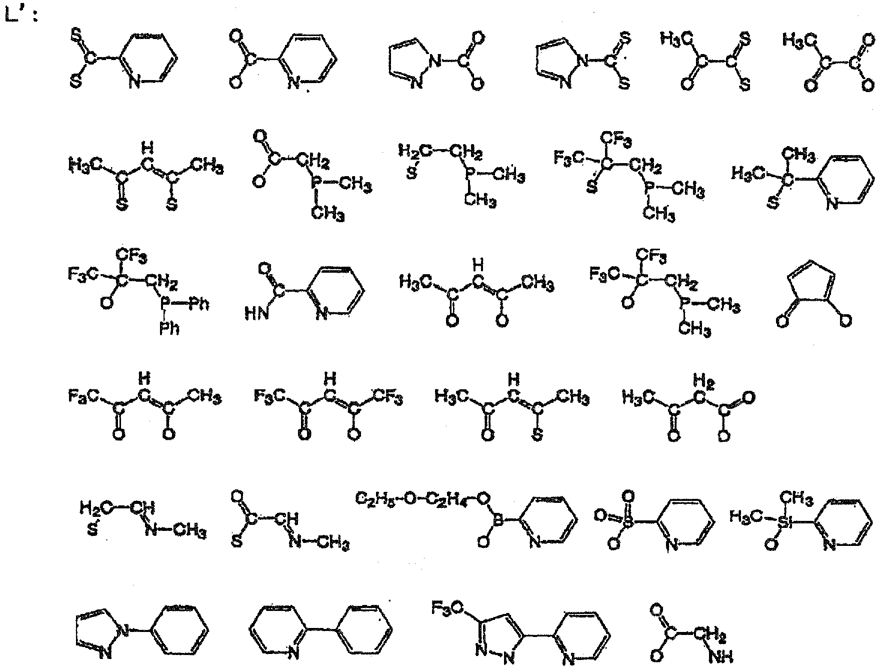

From the viewpoint of complex stability, preferred as L' are the following ligands.

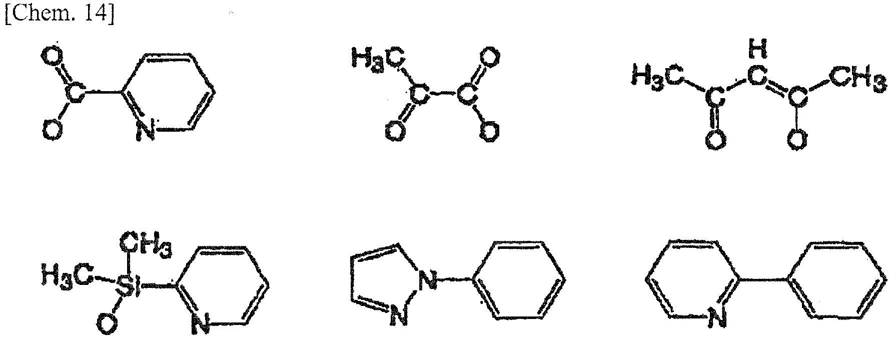

The compounds represented by formula (III) are further preferably compounds represented by the following formula (IIIa), (IIIb), or (IIIc). 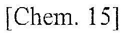 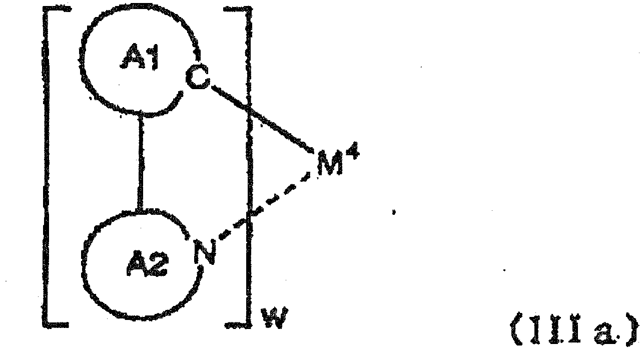 (In the formula (IIIa), M⁴ represents the same metal represented by M, w represents the valency of the metal M⁴, ring A1 represents an aromatic hydrocarbon group or aromatic heterocyclic group that may have a substituent, and ring A2 represents a nitrogen-containing aromatic heterocyclic group that may have a substituent. Rings A1 and A2 each may be the same or different when a plurality of ring A1 and a plurality of ring A2 exist.) 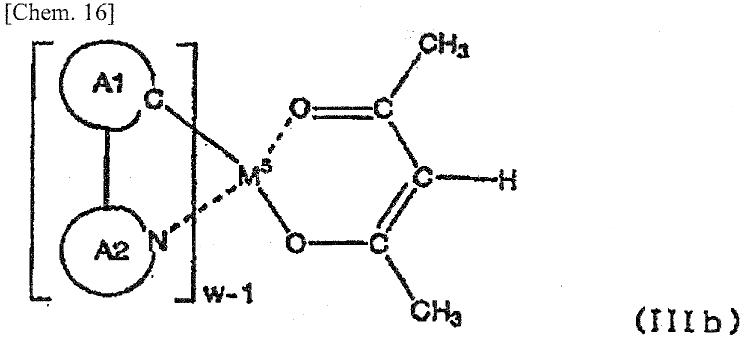 (In the formula (IIIb), M⁵ represents the same metal represented by M in formula (III), w represents the valency of the metal M⁵, ring A1 represents an aromatic hydrocarbon group or aromatic heterocyclic group that may have a substituent, and ring A2 represents a nitrogen-containing aromatic heterocyclic group that may have a substituent. Rings A1 and A2 each may be the same or different when a plurality of ring A1 and a plurality of ring A2 exist.) 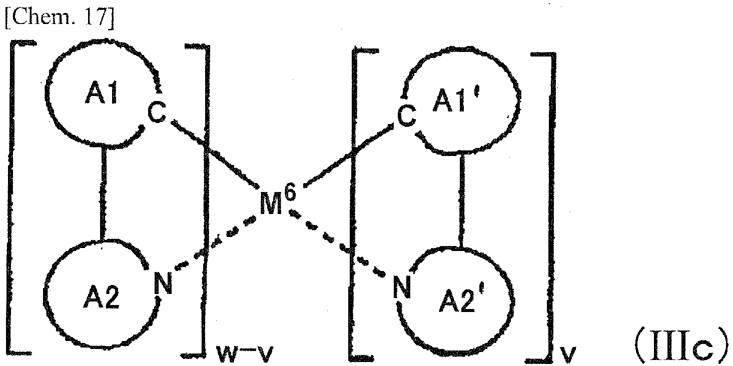 (In the formula (IIIc), M⁶ represents the same metal represented by M in formula (III), w represents the valency of the metal M⁶, v represents 0, 1, or 2, ring A1 and ring A1' each independently represent an aromatic hydrocarbon group or aromatic heterocyclic group that may have a substituent, and ring A2 and ring A2' each independently represent a nitrogen-containing aromatic heterocyclic group that may have a substituent. Rings A1, A2, A1', and A2' each may be the same or different when a plurality of ring A1, a plurality of ring A2, a plurality of ring A1', and a plurality of ring A2' exist.)

In the formulae (IIIa) to (IIIc), preferred examples of the ring A1 and ring A1' include phenyl, biphenyl, naphthyl, anthryl, thienyl, furyl, benzothienyl, benzofuryl, pyridyl, quinolyl, isoquinolyl, and carbazolyl.

In the formulae (IIIa) to (IIIc), preferred examples of the ring A2 and ring A2' include pyridyl, pyrimidyl, pyrazinyl, triazinyl, benzothiazole, benzooxazole, benzoimidazole, quinolyl, isoquinolyl, quinoxalyl, and phenanthridinyl.

Examples of the possible substituents of the aromatic ring group of ring A1 and ring A1', and examples of the possible substituents of the nitrogen-containing aromatic heterocyclic group of ring A2 and ring A2' in the formulae (IIIa) to (IIIc) include halogen atoms; alkyl of 1 to 12 carbon atoms; alkenyl of 1 to 12 carbon atoms; alkoxycarbonyl of 1 to 12 carbon atoms; alkoxy of 1 to 12 carbon atoms; aralkyl of 1 to 24 carbon atoms; aryloxy of 1 to 12 carbon atoms; dialkylamino of 1 to 24 carbon atoms; diarylamino of 8 to 24 carbon atoms; five- or six-membered monocyclic aromatic hydrocarbon groups, or fused aromatic hydrocarbon groups of 2 to 4 five- or six-membered rings; carbazolyl; acyl; haloalkyl; and cyano.

The diarylamino of 8 to 24 carbon atoms, the five- or six-membered monocyclic aromatic hydrocarbon groups or fused aromatic hydrocarbon groups of 2 to 4 five- or six-membered rings, and the carbazolyl may have a further substituent at the aryl moiety forming the group. Examples of such substituents include alkyl of 1 to 12 carbon atoms, alkoxy of 1 to 12 carbon atoms, aralkyl of 1 to 24 carbon atoms, and five- or six-membered monocyclic aromatic hydrocarbon groups or fused aromatic hydrocarbon groups of 2 to 4 five- or six-membered rings that may be substituted with alkyl of 1 to 12 carbon atoms.

These substituents may be joined to each other to form a ring. As a specific example, the substituent of ring A1 may be bound to the substituent of ring A2, or the substituent of ring A1' and the substituent of ring A2' may be bound to each other to form a single fused ring. An example of such a fused ring is 7,8-benzoquinoline.

The substituents of the rings A1, A1', A2, and A2' are more preferably alkyl of 1 to 12 carbon atoms, alkoxy of 1 to 12 carbon atoms, aralkyl of 1 to 24 carbon atoms, five- or six-membered monocyclic aromatic hydrocarbon groups or fused aromatic hydrocarbon groups of 2 to 4 five- or six-membered rings, cyano, a halogen atom, haloalkyl, diarylamino of 8 to 24 carbon atoms, and carbazolyl, further preferably alkyl of 1 to 12 carbon atoms, alkoxy of 1 to 12 carbon atoms, aralkyl of 1 to 24 carbon atoms, five- or six-membered monocyclic aromatic hydrocarbon groups or fused aromatic hydrocarbon groups of 2 to 4 five- or six-membered rings, diarylamino of 8 to 24 carbon atoms, and carbazolyl. The five- or six-membered monocyclic aromatic hydrocarbon groups or fused aromatic hydrocarbon groups of 2 to 4 five- or six-membered rings, the diarylamino of 8 to 24 carbon atoms, and carbazolyl may have a further substituent at the aryl moiety forming the group. Examples of such substituents are as listed above.

Preferred examples of M⁴ to M⁶ in the formulae (IIIa) to (IIIc) include ruthenium, rhodium, palladium, silver, rhenium, osmium, iridium, platinum, and gold.

Particularly preferred as the organic metal complex represented by the formula (III) is a compound in which the ligands L and/or L' is a 2-arylpyridine ligand, specifically 2-arylpyridine with or without a substituent attached thereto, or a group fused thereto.

The compounds described in WO2005/019373 also may be used as the light emitting material.

The compounds represented by formula (IV) are described below.

In the formula (IV), M⁷ represents a metal. Specific examples include the metals exemplified above as metals selected from Groups 7 to 11 of the periodic table. Preferred examples include ruthenium, rhodium, palladium, silver, rhenium, osmium, iridium, platinum, and gold, particularly preferably bivalent metals such as platinum and palladium.

In the formula (IV), R⁹² and R⁹³ each independently represent a hydrogen atom, a halogen atom, alkyl, aralkyl, alkenyl, cyano, amino, acyl, alkoxycarbonyl, carboxyl, alkoxy, alkylamino, aralkylamino, haloalkyl, hydroxyl, aryloxy, an aromatic hydrocarbon group, or an aromatic heterocyclic group.

When T is a carbon atom, R⁹⁴ and R⁹⁵ each independently represent the same substituent exemplified for R⁹² and R⁹³. When T is a nitrogen atom, R⁹⁴ or R⁹⁵ that directly binds to T does not exist.

R⁹² to R⁹⁵ may be further substituted. When substituted, the substituent is not particularly limited, and may be any group.

Any two of R⁹² to R⁹⁵ may be joined to each other to form a ring.

The following presents specific examples of the phosphorescent materials having maximum emission wavelengths in different wavelength regions. The phosphorescent materials below may be used either alone, or in any combination and proportion of two or more.
(1) Specific examples of phosphorescent material (blue) having a maximum emission wavelength in a 440 nm to 500 nm region 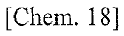 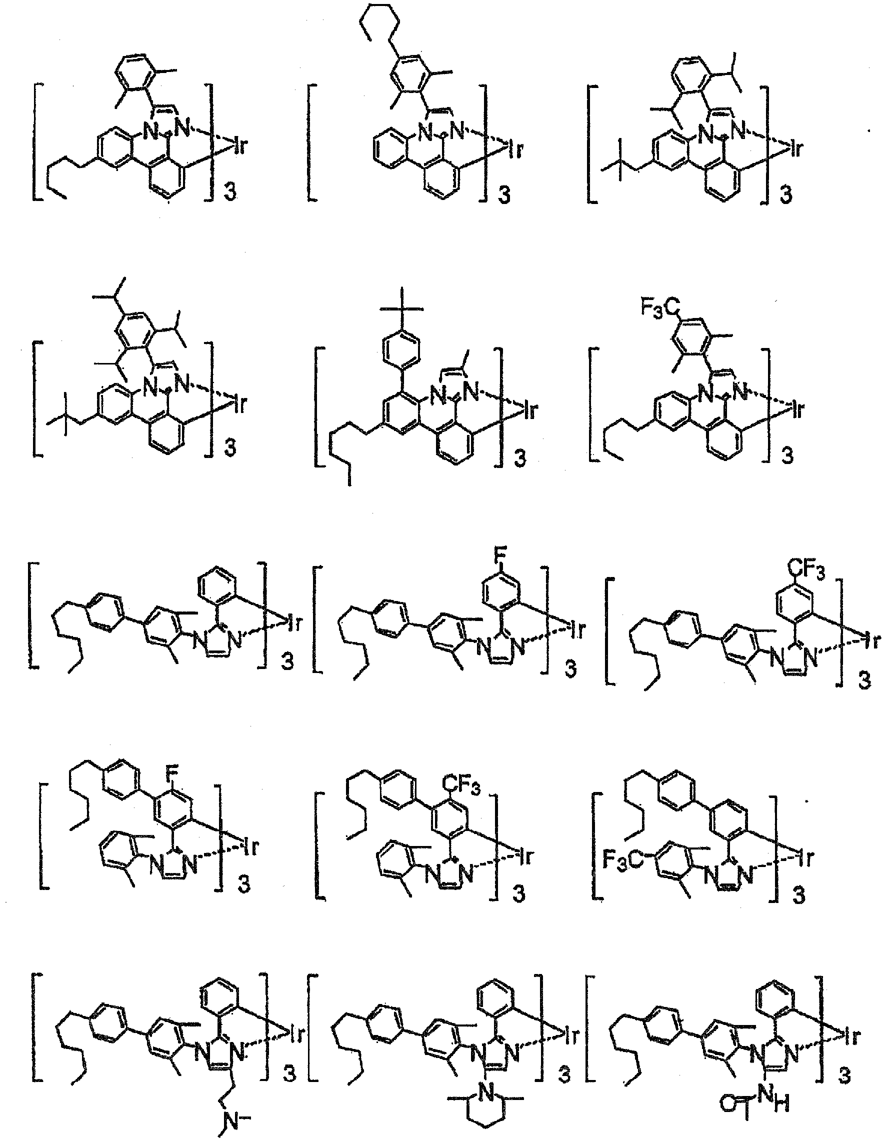 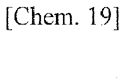 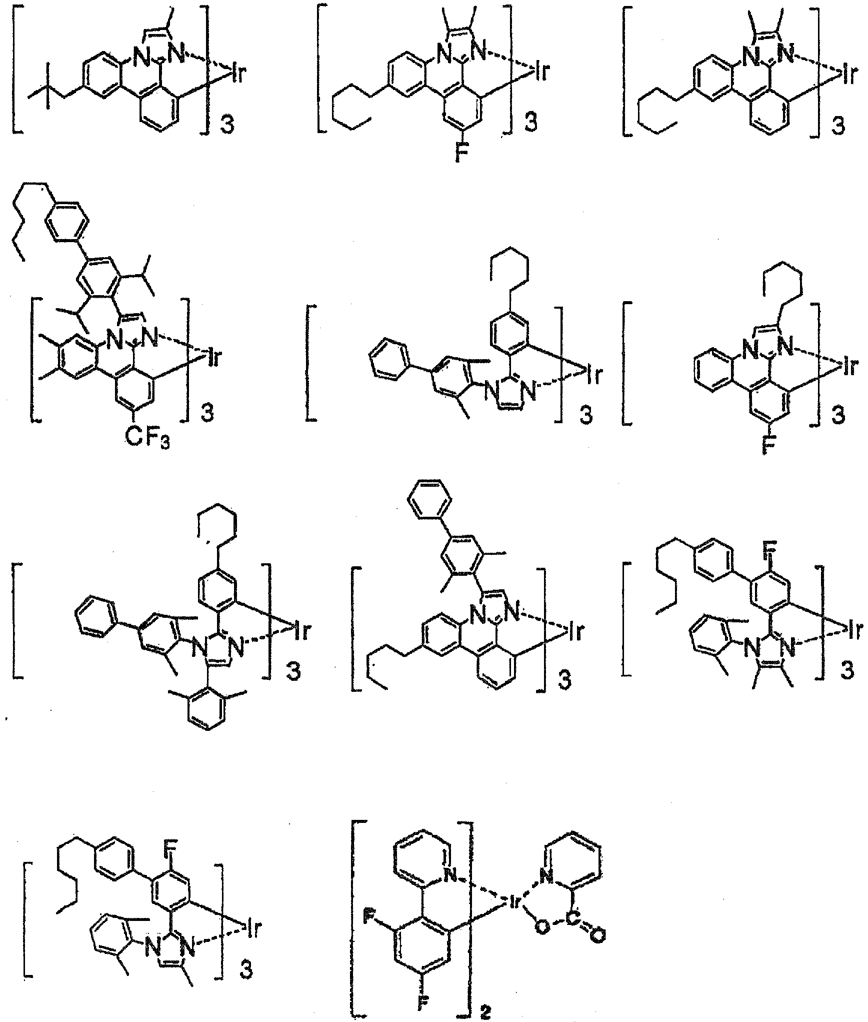
(2) Specific examples of phosphorescent material (green) having a maximum emission wavelength in a 500 to 580 nm region 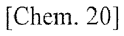 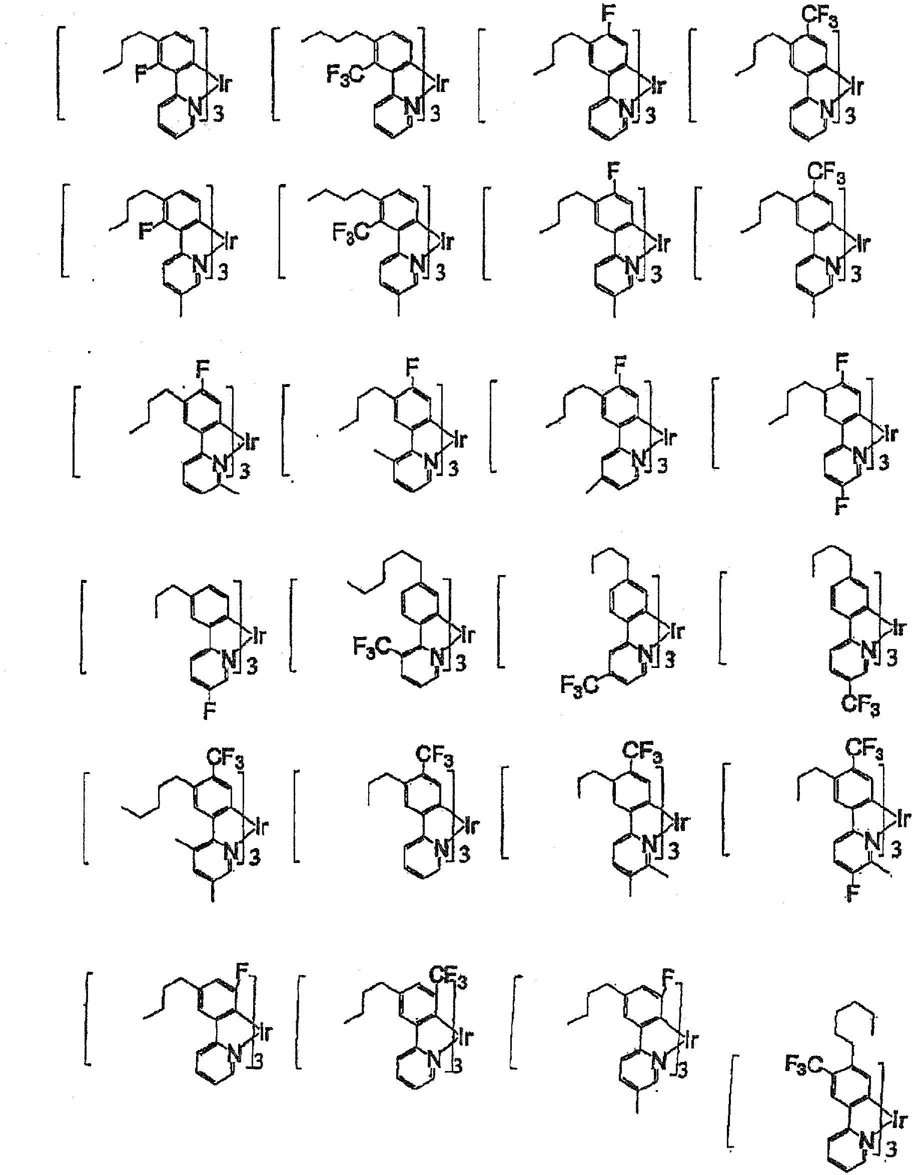 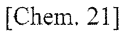 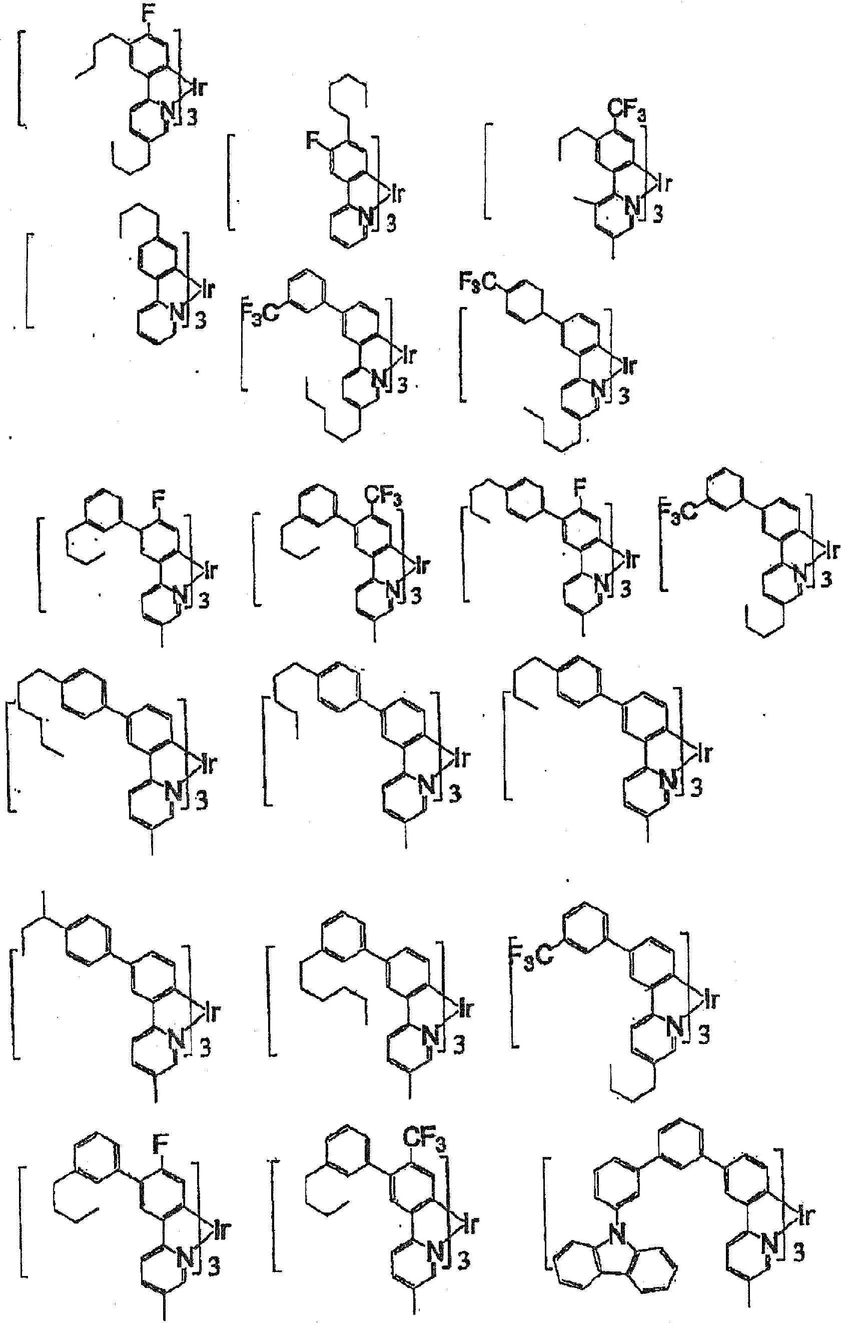 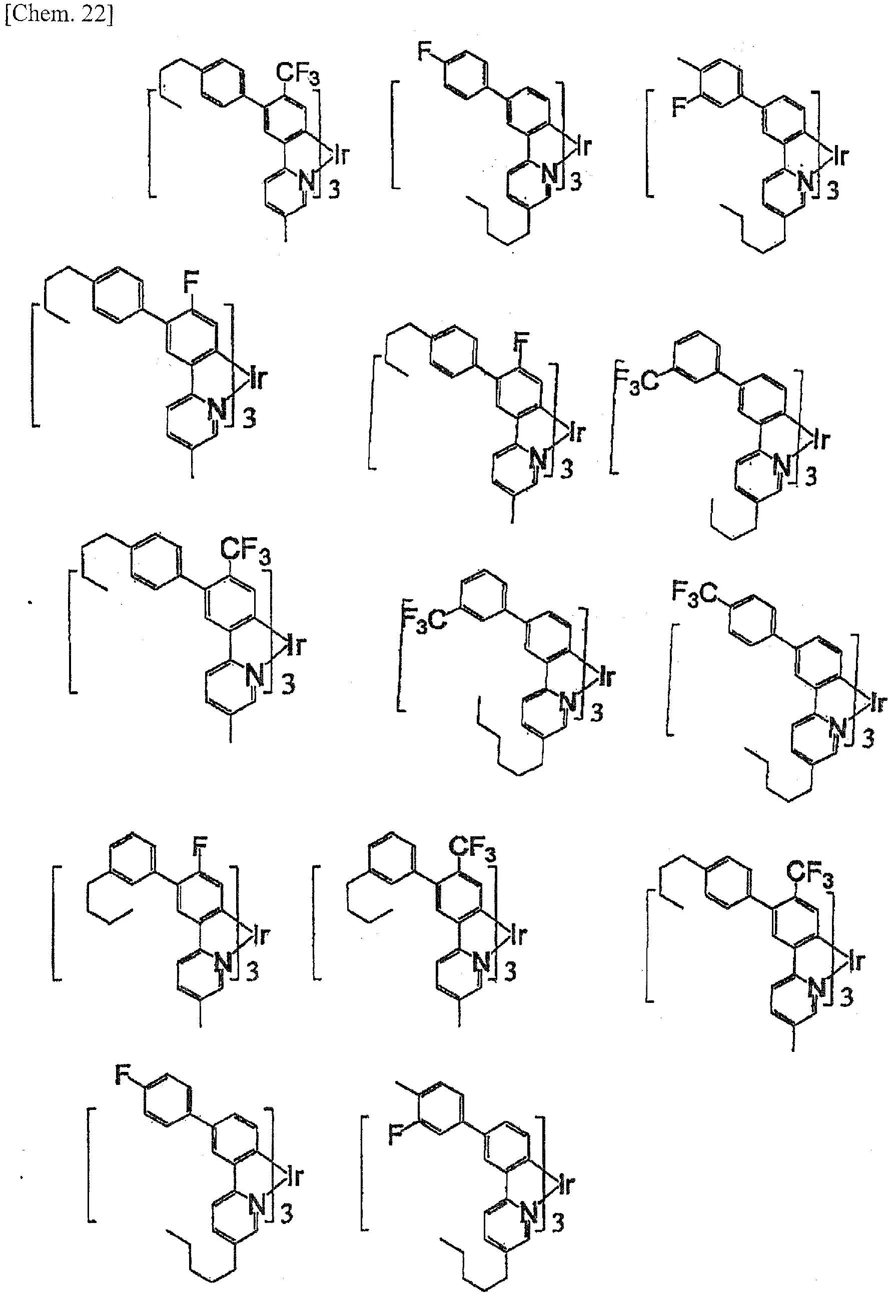 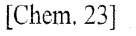 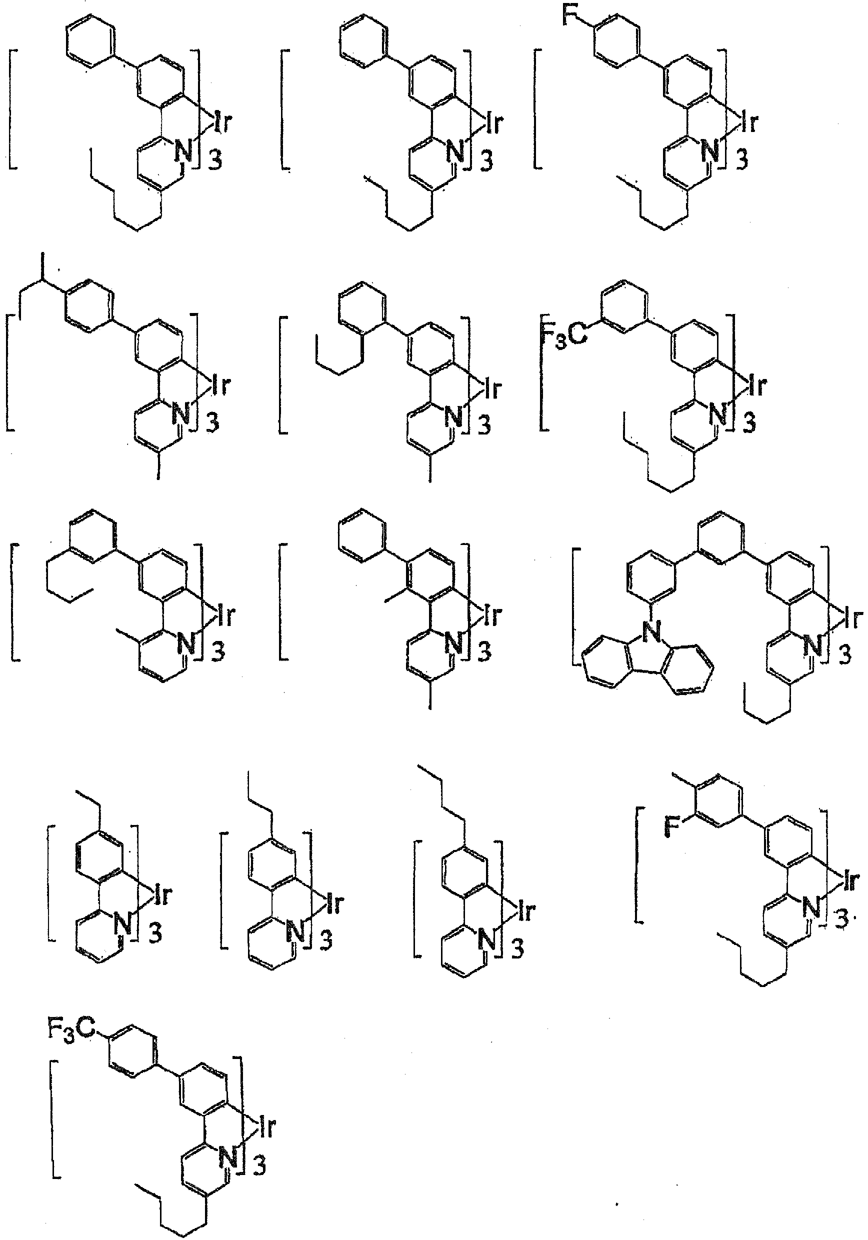 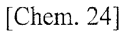 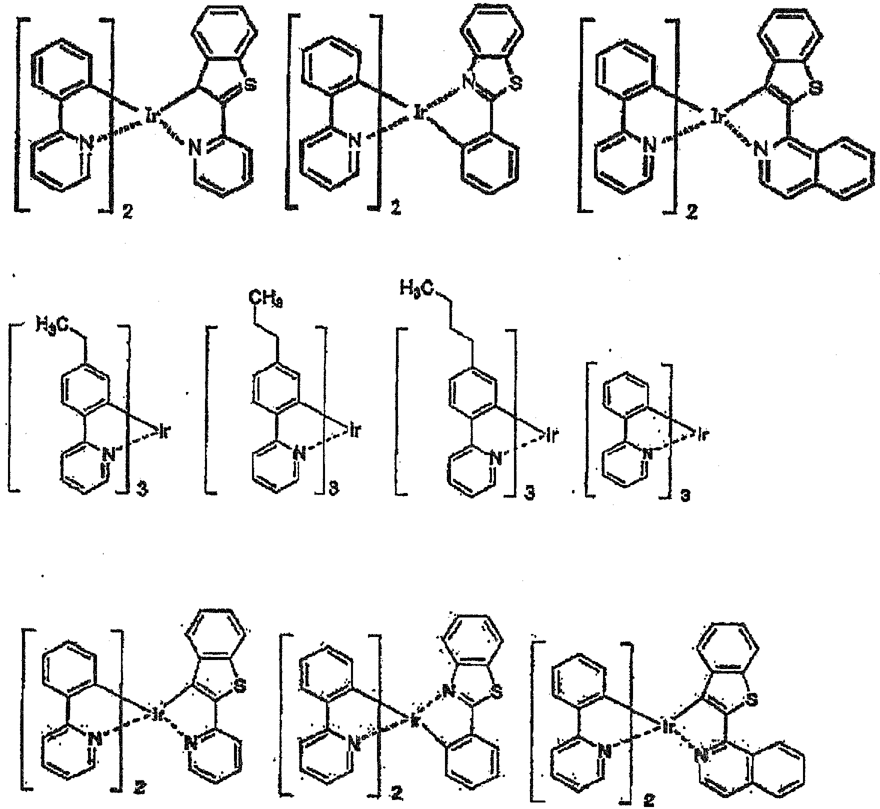 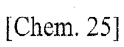 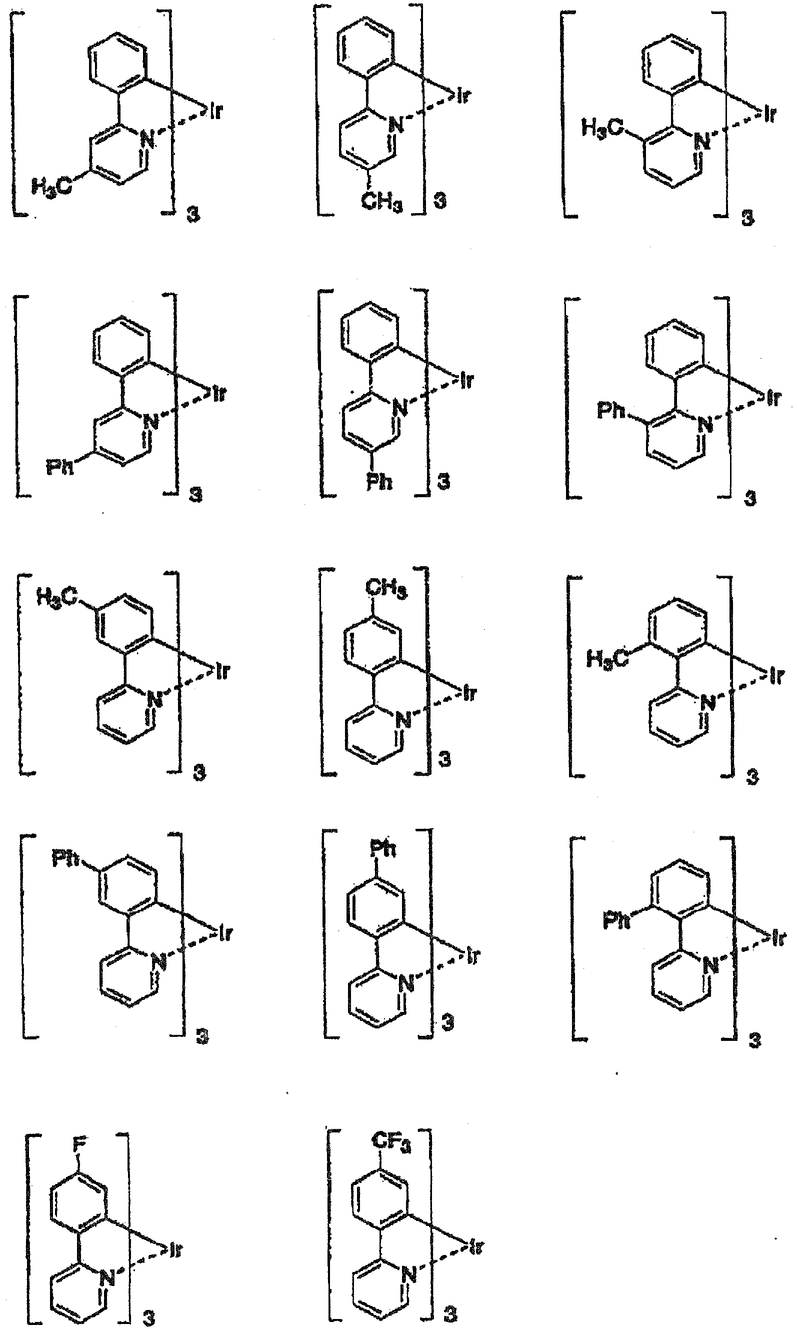
(3) Specific examples of phosphorescent material (red) having a maximum emission wavelength in a 580 to 630 nm region

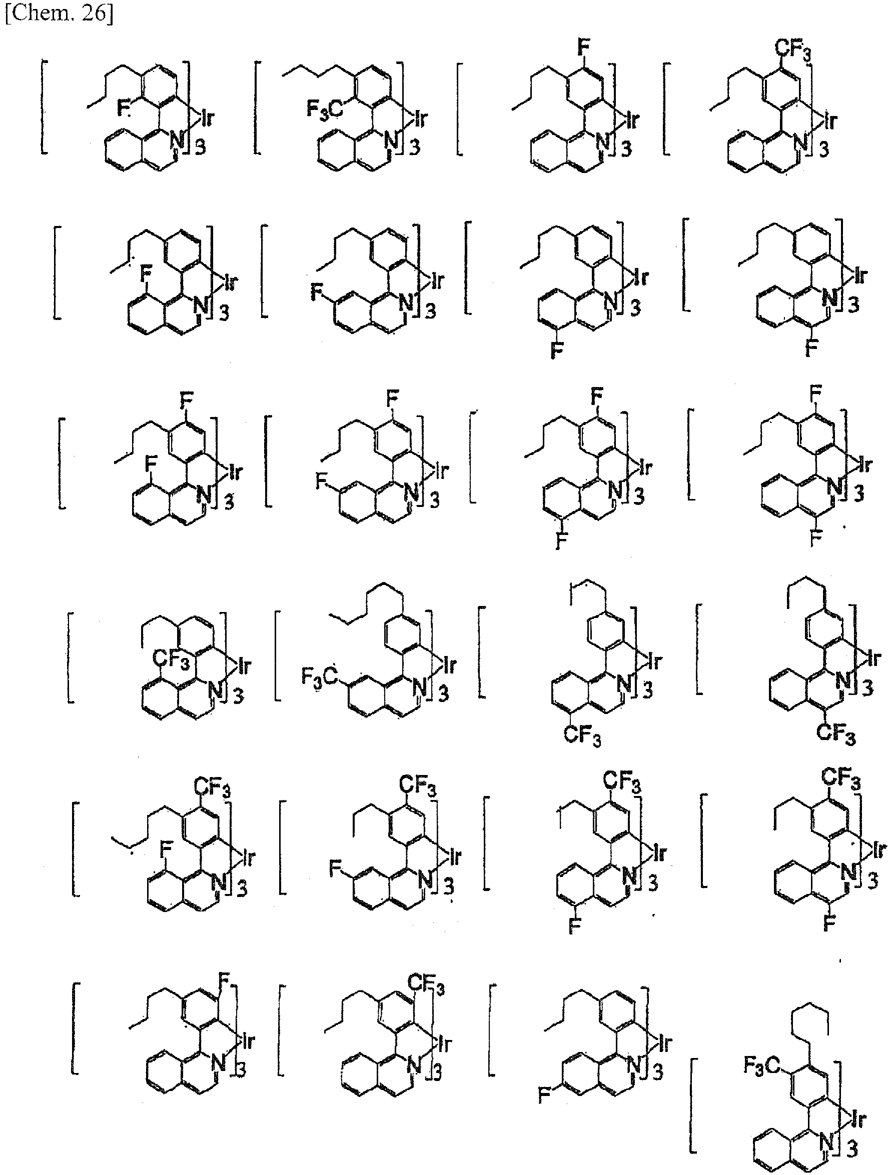

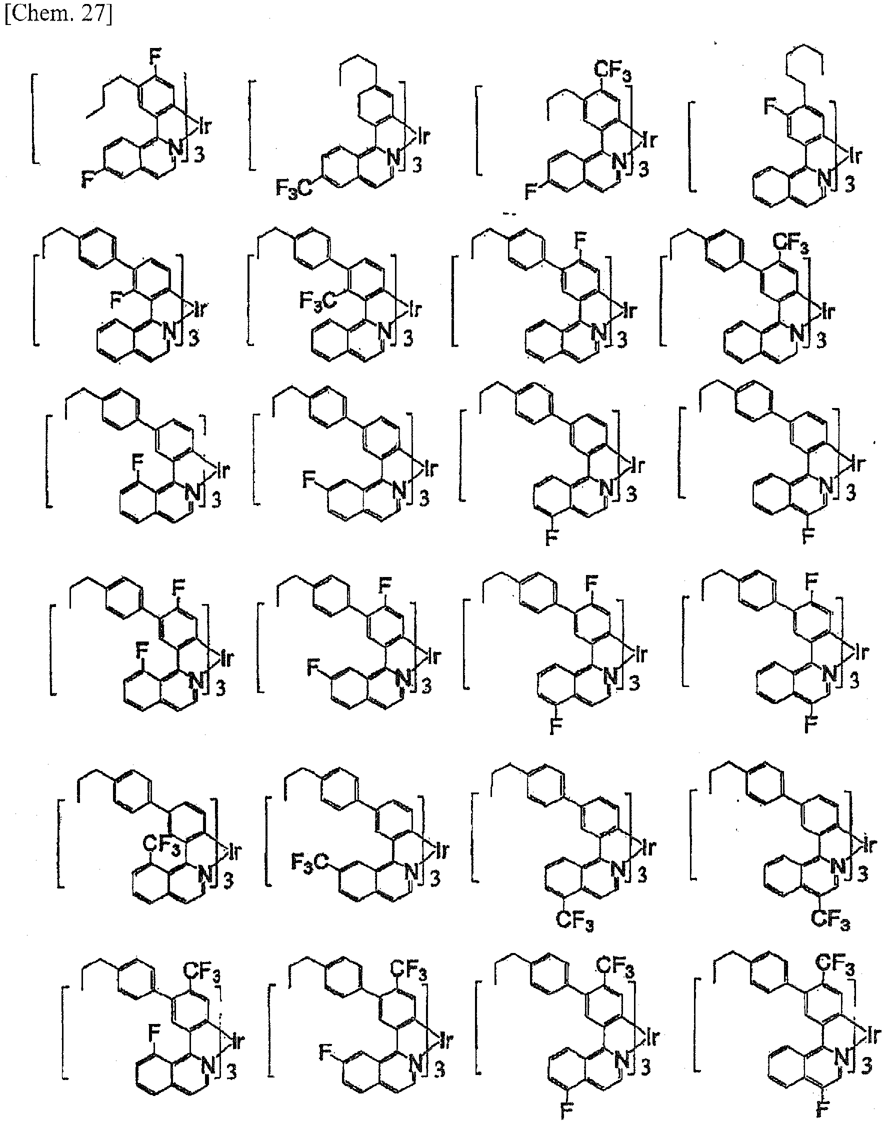

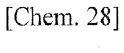

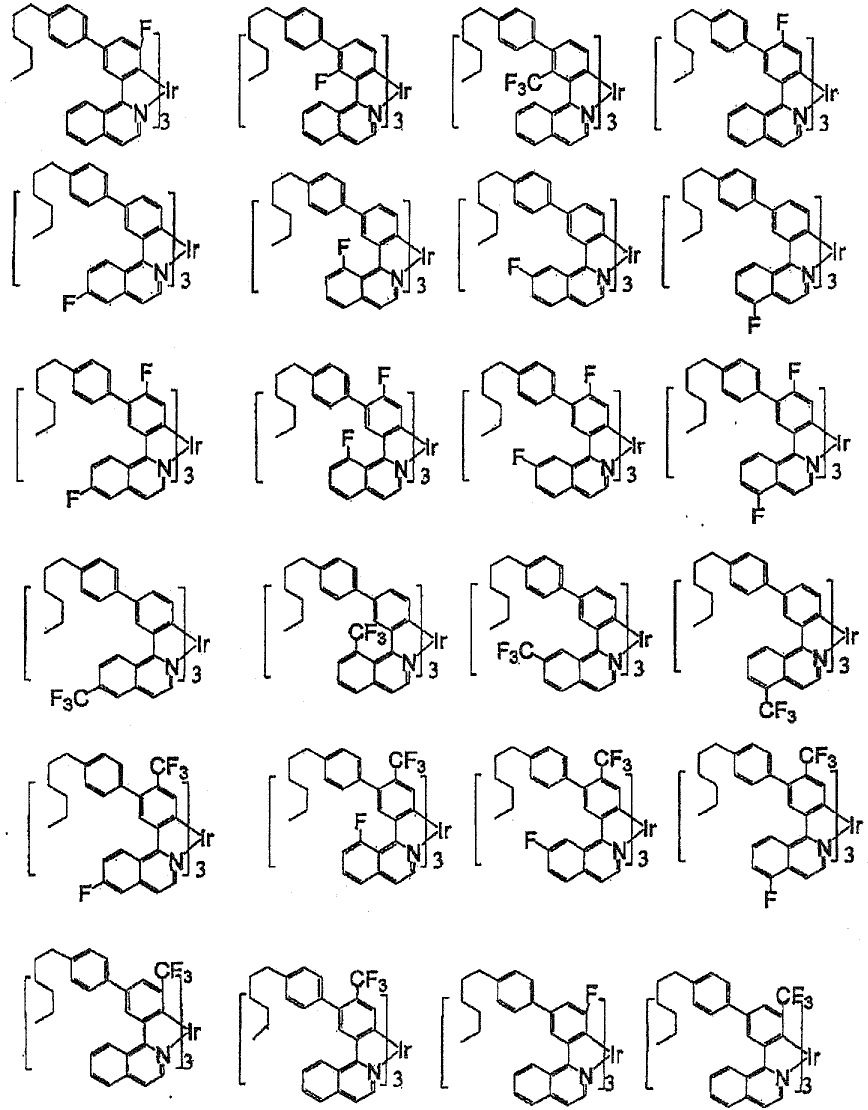

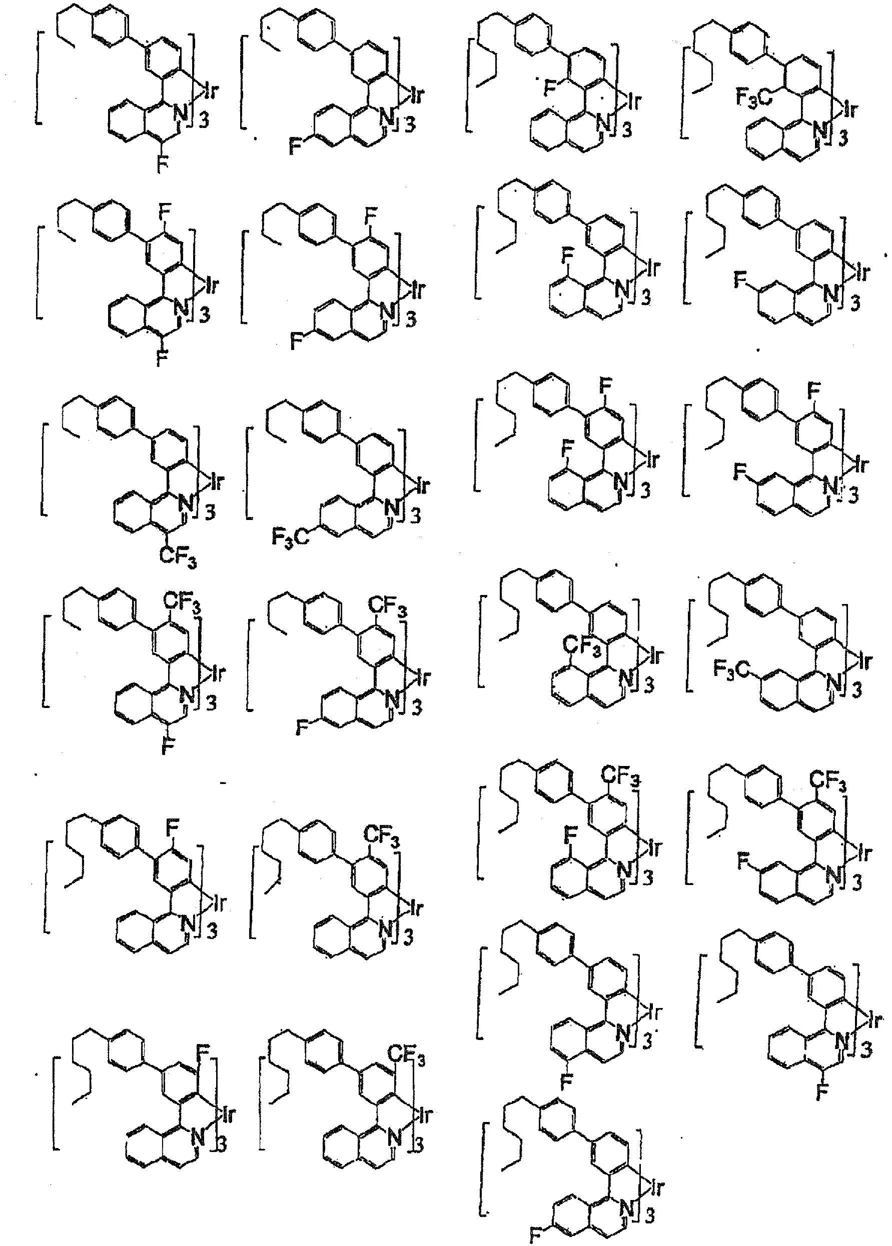

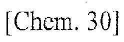

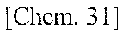

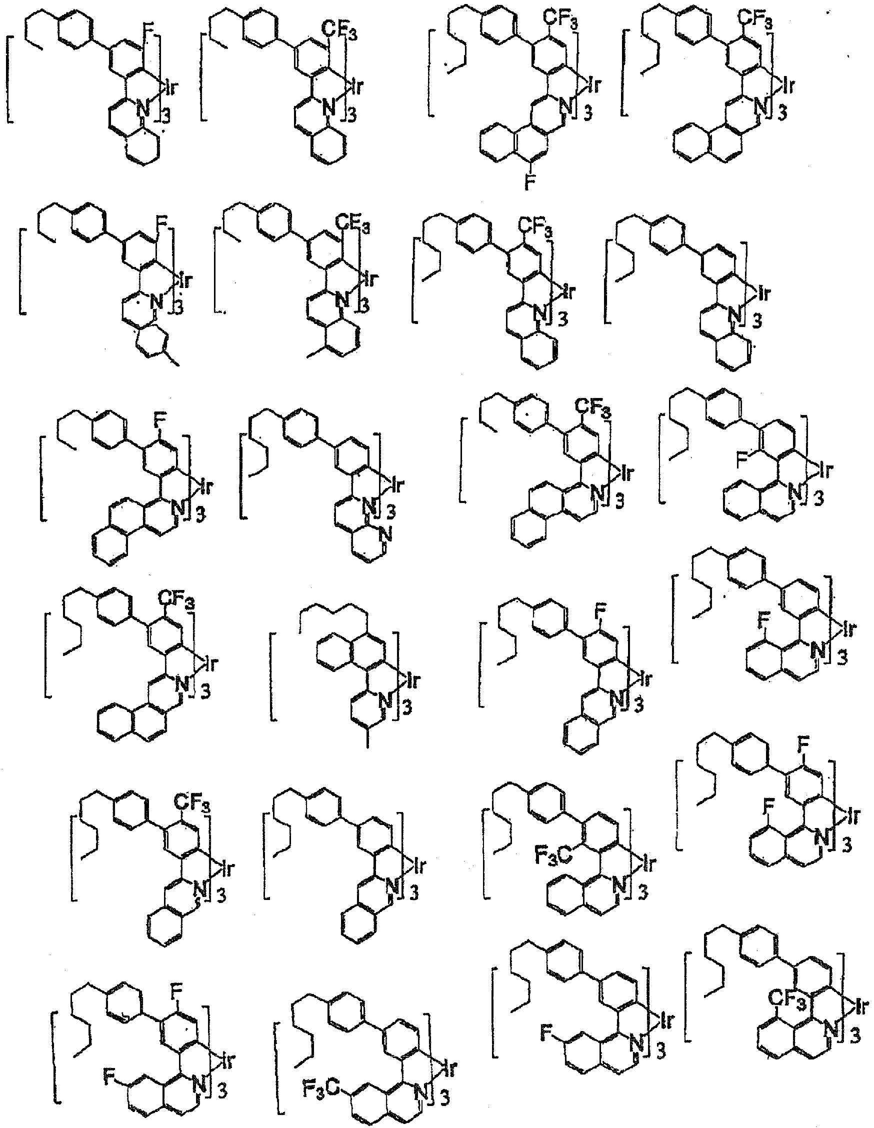

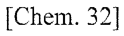

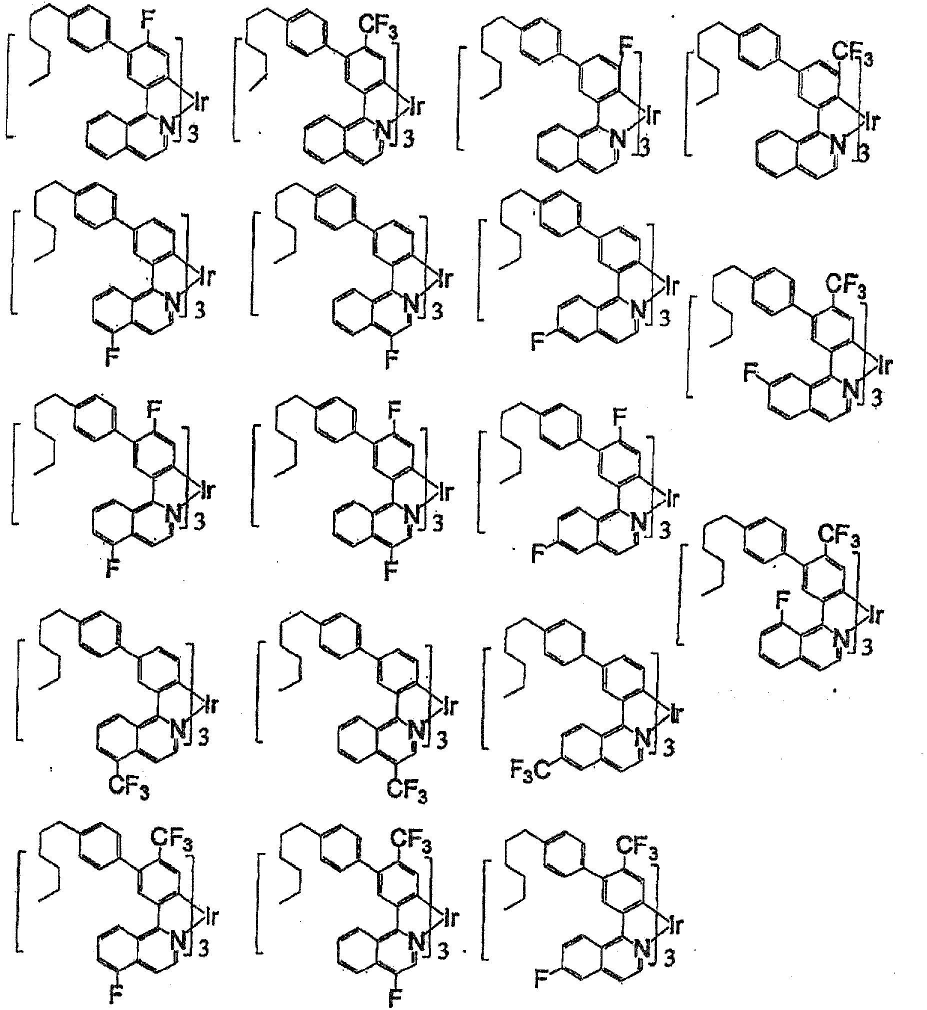

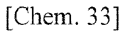

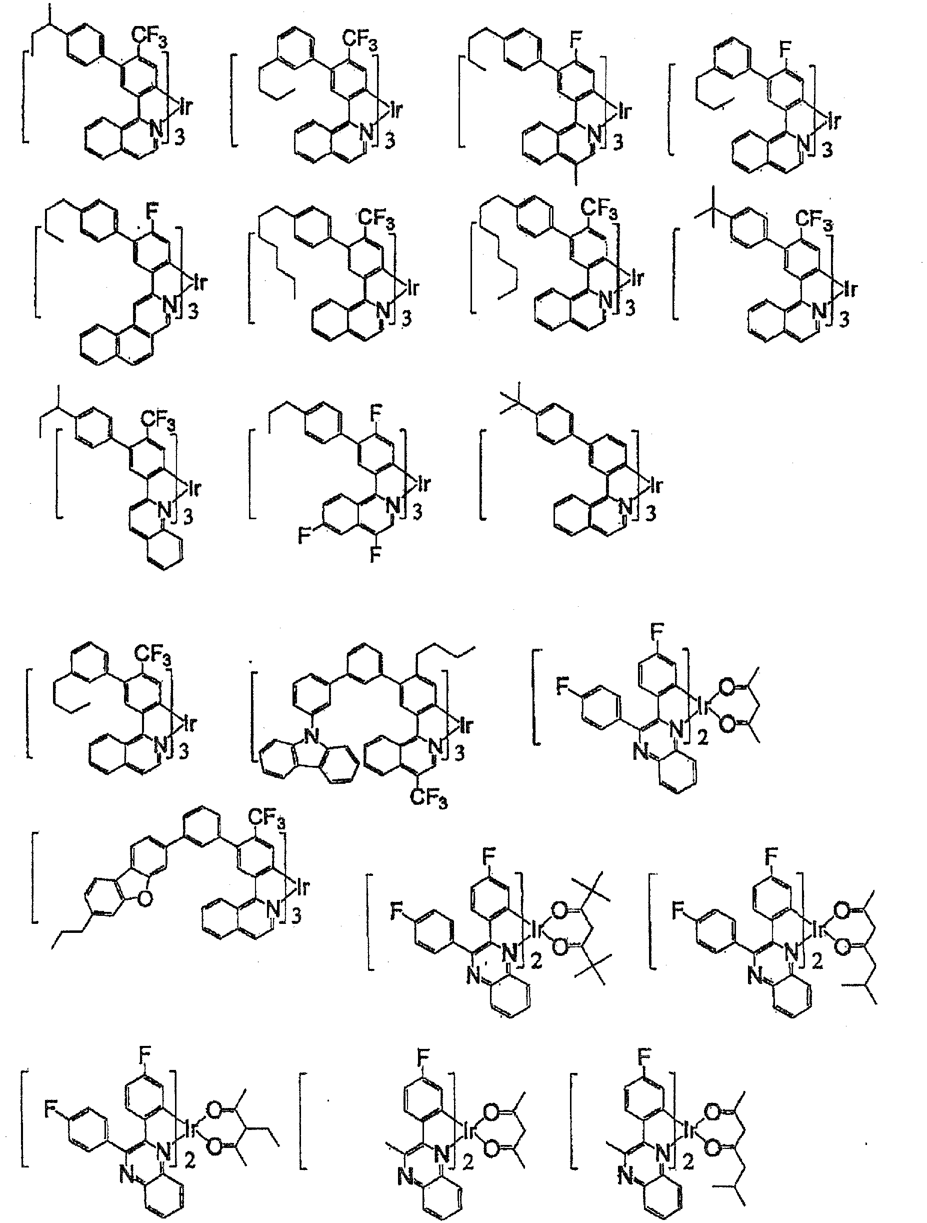

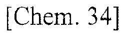

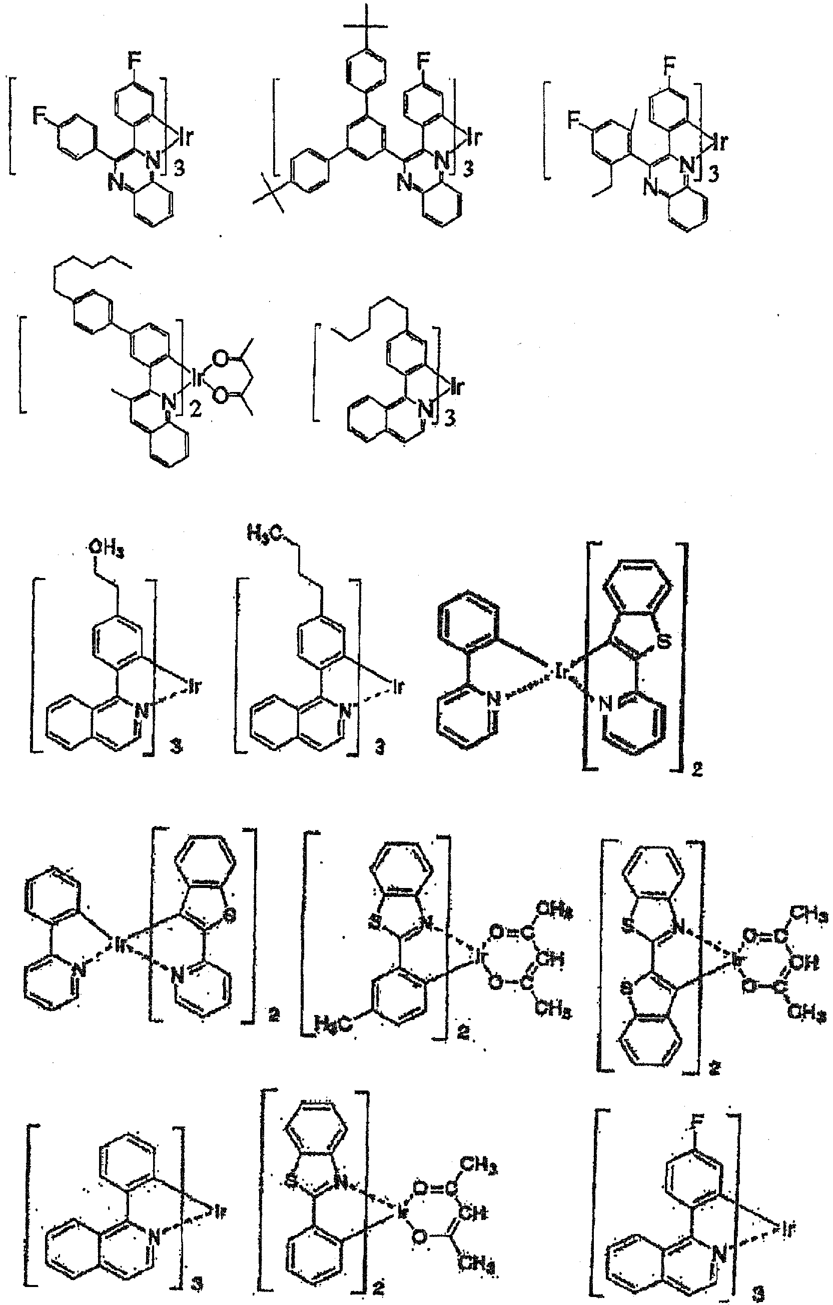

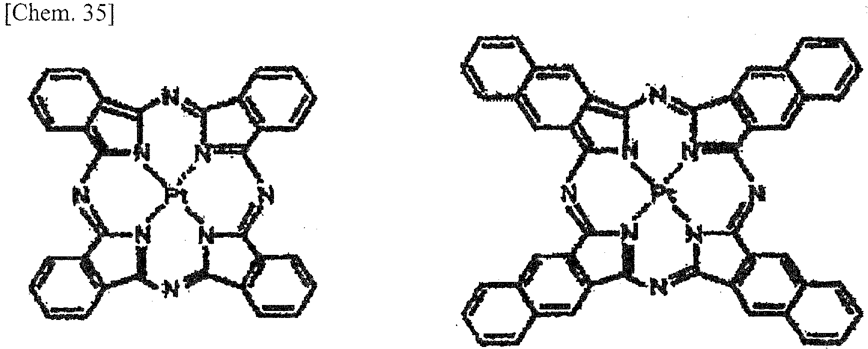

### Coated Light Emitting Layer

In the organic electroluminescent element of the present invention, the first light emitting layer (the layer on the anode side of the light emitting layer) formed by using a wet film forming method is the coated light emitting layer.

Specifically, the phosphorescent material generally has a large molecular weight, as described above. Suppose that the first light emitting layer is formed by using a vacuum evaporation process. In this case, because the air-borne phosphorescent material molecules occurring in the evaporation have large heat energy, the molecules adhered to the outermost surface of the layer in the final stage of the evaporation step move on the layer surface, and aggregate to stabilize. It is thus believed that the aggregates of the phosphorescent material molecules are present in larger numbers on the outermost layer than inside of the light emitting layer. The aggregates is believed to trap the excitons and charges present in the first light emitting layer and the second light emitting layer, and cause increase of driving voltage and lowering of luminescence efficiency in the element. It is therefore preferable to provide the first light emitting layer as the coated light emitting layer.

The molecular weight of the fluorescent material is not as large as that of the phosphorescent material. The air-borne fluorescent material molecules adhered to the substrate in the evaporation step are thus believed to have relatively smaller heat energy, and move only slightly on the outermost surface of the layer (low probability of forming aggregates).

As used herein, "wet film forming method" refers to methods that use solvent-containng ink for film formation. Examples include spin coating, dip coating, die coating, bar coating, blade coating, roll coating, spray coating, capillary coating, nozzle printing, inkjet method, screen printing, gravure printing, flexography, and offset printing. Preferred for ease of patterning are nozzle printing, die coating, roll coating, spray coating, inkjet method, gravure printing, and flexography. Particularly preferred for obtaining a uniform film quality are nozzle printing, inkjet method, gravure printing, and flexography.

The coated light emitting layer is formed by using the wet film forming method, using a light emitting layer forming composition that contains the phosphorescent material, the low-molecular-weight first charge transport material, and a solvent.

### Solvent

The solvent used to form the coated light emitting layer is not particularly limited, as long as it can desirably dissolve the phosphorescent material and the first charge transport material (described later).

The solubility of the solvent is typically 0.01 weight% or more, preferably 0.05 weight% or more, further preferably 0.1 weight% or more for each of the phosphorescent material and the first charge transport material at ordinary temperature and ordinary pressure.

Specific examples of the solvent are listed below. The solvent is not limited to the following examples, provided that it does not interfere with the advantages of the present invention.
Alkanes such as n-decane, cyclohexane, ethylcyclohexane, decalin, and bicyclohexane
Aromatic hydrocarbons such as toluene, xylene, mesitylene, cyclohexylbenzene, and tetralin
Halogenated aromatic hydrocarbons such as chlorobenzene, dichlorobenzene, and trichlorobenzene
Aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether
Aromatic esters such as phenyl acetate, phenyl propionate, methyl benzoate, ethyl benzoate, propyl benzoate, and n-butyl benzoate
Alicyclic ketones such as cyclohexanone, cyclooctanone, and fenchone
Alicyclic alcohols such as cyclohexanol, and cyclooctanol
Aliphatic ketones such as methyl ethyl ketone, and dibutyl ketone
Aliphatic alcohols such as butanol, and hexanol
Aliphatic ethers such as ethylene glycol dimethyl ether, ethylene glycol diethyl ether, and propylene glycol-1-monomethyl ether acetate (PGMEA)

Preferred are alkanes and aromatic hydrocarbons.

These solvents may be used either alone, or in any combination and proportion of two or more.

In order to obtain a film of improved uniformity, it is preferable to evaporate the solvent from the liquid film at an appropriate rate immediately after the film formation. To this end, the boiling point of the solvent is typically 80°C or more, preferably 100°C or more, more preferably 120°C or more, and typically 300°C or less, preferably 270°C or less, more preferably 250°C or less.

The solvent may be used in any amount, provided that it is not detrimental to the advantages of the present invention. The solvent is used in preferably 10 weight parts or more, more preferably 50 weight parts or more, particularly preferably 80 weight parts or more, and preferably 99.99 weight parts or less, more preferably 99.95 weight parts or less, particularly preferably 99.90 weight parts or less with respect to 100 weight parts of the light emitting layer forming composition. When the solvent content in the light emitting layer forming composition is below these lower limits, the viscosity may become excessively high, and ease of film formation procedure may suffer. On the other hand, above the foregoing upper limits, a sufficient thickness cannot be provided for the film after the removal of the solvent following the film formation, and the film formation tends to become difficult. When two or more solvents are mixed and used as the light emitting layer forming composition, the solvent content satisfying the foregoing ranges is the total content of the solvents.

### Light Emitting Material

In the present invention, the coated light emitting layer is preferably a layer that has a maximum emission wavelength in at least one of the 440 to 500 nm region, 500 to 580 nm region, and 580 to 630 nm region. Accordingly, the coated light emitting layer preferably contains at least one of a blue emitting material having a maximum emission wavelength in the 440 to 500 nm region, a green emitting material having a maximum emission wavelength in the 500 to 580 nm region, and a red emitting material having a maximum emission wavelength in the 580 to 630 nm region, more preferably one of a green emitting material having a maximum emission wavelength in the 500 to 580 nm region, and a red emitting material having a maximum emission wavelength in the 580 to 630 nm region, particularly preferably both of a green emitting material having a maximum emission wavelength in the 500 to 580 nm region, and a red emitting material having a maximum emission wavelength in the 580 to 630 nm region.

As described above, the coated light emitting layer contains the phosphorescent material to obtain high luminescence efficiency. Preferably, the coated light emitting layer contains a red phosphorescent material and/or a green phosphorescent material.

This is because, when a layer of a narrow energy gap containing a red to green emitting material is disposed on the anode side, energy transfer from the blue emitting material of a wide energy gap to the adjacent layer (for example, the hole transport layer) on the anode side of the light emitting layer can be suppressed.

The light emitting layer forming composition of the present invention contains the light emitting material in typically 0.01 weight% or more, preferably 0.05 weight% or more, further preferably 0.1 weight% or more, and typically 20 weight% or less, preferably 10 weight% or less, further preferably 5 weight% or less.

### First Charge Transport Material

The coated light emitting layer of the present invention contains the first charge transport material.

The first charge transport material is a compound for transporting charges such as holes and electrons, and is specified by a single molecular weight. Preferably, the light emitting layer according to the present invention contains the light emitting material as dopant material, and the first charge transport material as host material.

The first charge transport material may be a low-molecular-weight compound used for the light emitting layer of conventional organic electroluminescent elements, and is preferably a compound used as the host material of the light emitting layer.

Specific examples of the first charge transport material include aromatic amine compounds, phthalocyanine compounds, porphyrin compounds, oligothiophene compounds, polythiophene compounds, benzylphenyl compounds, compounds joined to tertiary amine with a fluorene group, hydrazone compounds, silazane compounds, silanamine compounds, phosphamine compounds, quinacridone compounds, anthracene compounds, pyrene compounds, carbazole compounds, pyridine compounds, styryl compounds, phenanthroline compounds, oxadiazole compounds, and silole compounds.

The first charge transport material can be broadly classified into hole transporting compounds and electron transporting compounds.

### Hole Transporting Compound

The coated light emitting layer may contain a hole transporting compound as a constituent material. Among a variety of hole transporting compounds, examples of low-molecular-weight hole transporting compounds include aromatic diamines, as represented by 4,4'-bis[N-(1-naphthyl)-N-phenylamino]biphenyl, that contain two or more tertiary amines, and in which the nitrogen atoms are attached to two or more condensed aromatic rings (JP-A-5-234681); aromatic amine compounds having a starburst structure, such as 4,4',4"-tris(1-naphthylphenylamino)triphenylamine (Journal of Luminescence, 1997, Vol. 72-74, pp. 985); aromatic amine compounds formed by a tetramer of triphenylamine (Chemical Communications, 1996, pp. 2175); and spiro compounds such as 2,2',7,7'-tetrakis-(diphenylamino)-9,9'-spirobifluorene (Synthetic Metals, 1997, Vol. 91, pp. 209).

In the coated light emitting layer, the hole transporting compound may be used either alone, or in any combination and proportion of two or more.

### Electron Transporting Compound

The coated light emitting layer may contain the electron transporting compound as a constituent material. Among a variety of electron transporting compounds, examples of low-molecular-weight electron transporting compounds include 2,5-bis(1-naphthyl)-1,3,4-oxadiazole (BND), 2,5-bis(6'-(2',2"-bipyridyl))-1,1-dimethyl-3,4-diphenylsilole (PyPySPyPy), bathophenanthroline (BPhen), 2,9-dimethyl-4,7-diphenyl-1,10-phenanthroline (BCP, bathocuproin), 2-(4-biphenylyl)-5-(p-tert-butylphenyl)-1,3,4-oxadiazole (tBu-PBD), and 4,4'-bis(9-carbazole)-biphenyl (CBP).

In the coated light emitting layer, the electron transporting compound may be used either alone, or in any combination and proportion of two or more.

The first charge transport material may be used either alone, or in any combination and proportion of two or more. When used in a combination of two or more, it is preferable to use the hole transporting compound and the electron transporting compound in combination.

When the coated light emitting layer contains a red phosphorescent material and a green phosphorescent material, the first charge transport material may be, for example, an aromatic amine compound, a compound joined to tertiary amine with a fluorene group, a carbazole compound, a pyridine compound, or a silole compound.

Specific examples of first charge transport materials preferred for use in the present invention are given below. It should be noted, however, that the present invention is in no way limited to the following.

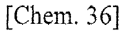

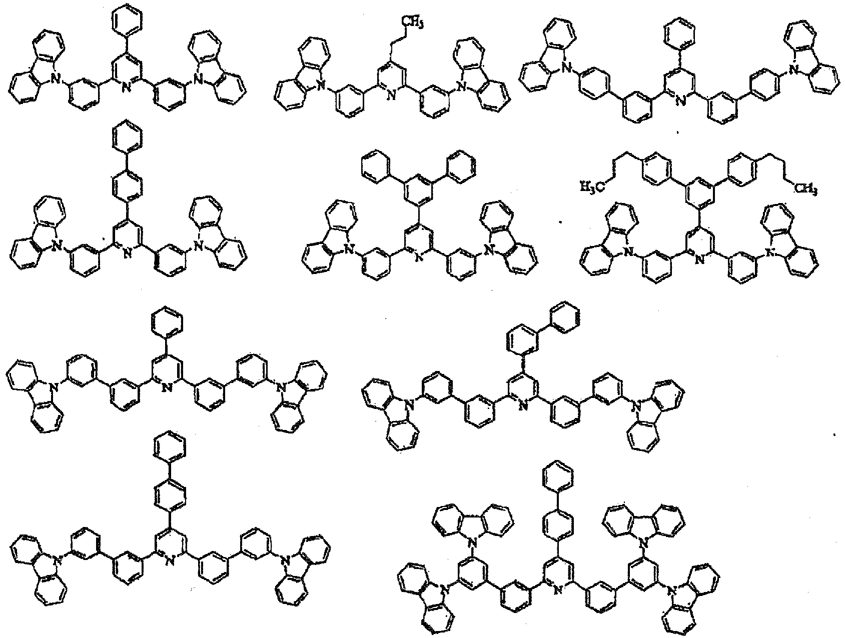

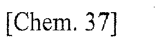

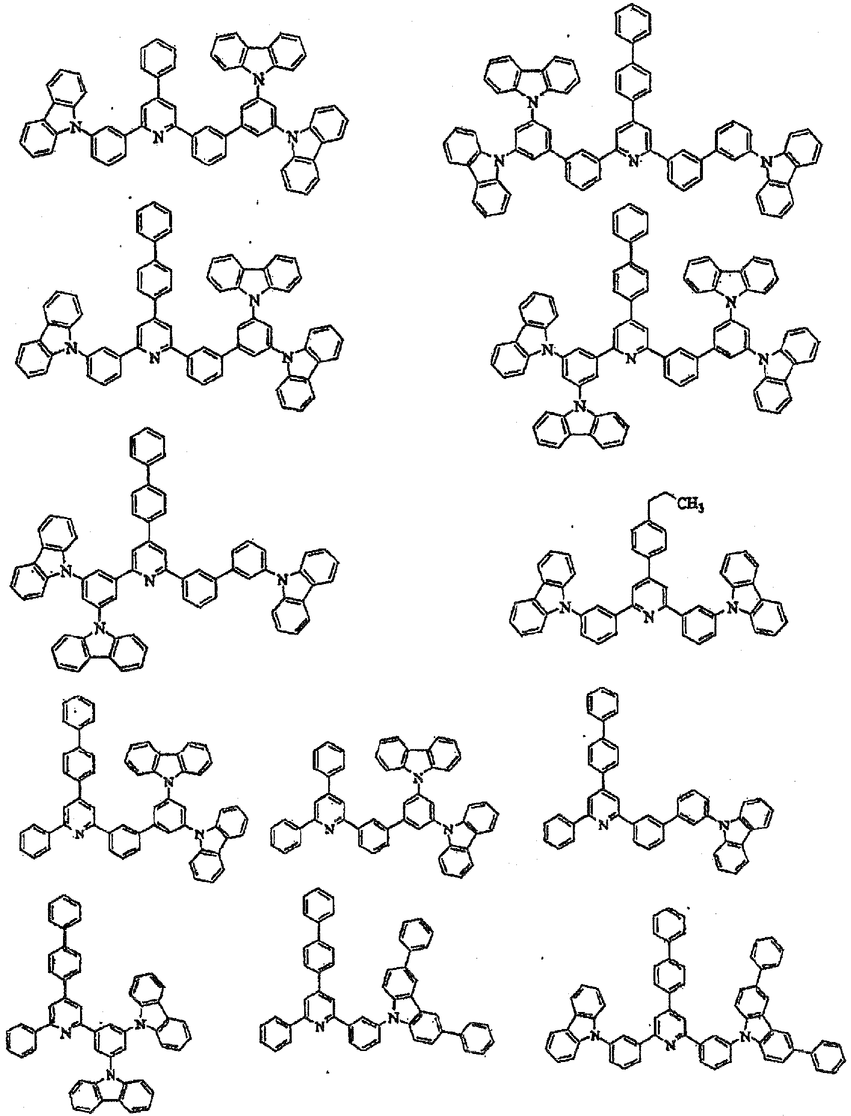

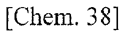

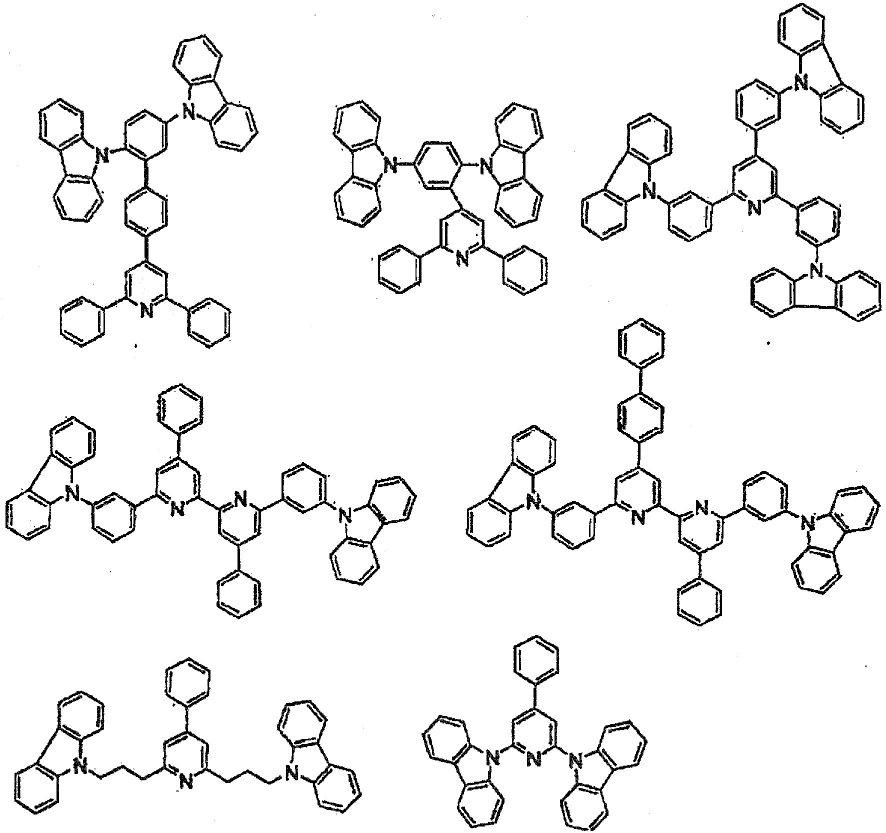

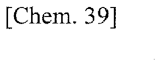

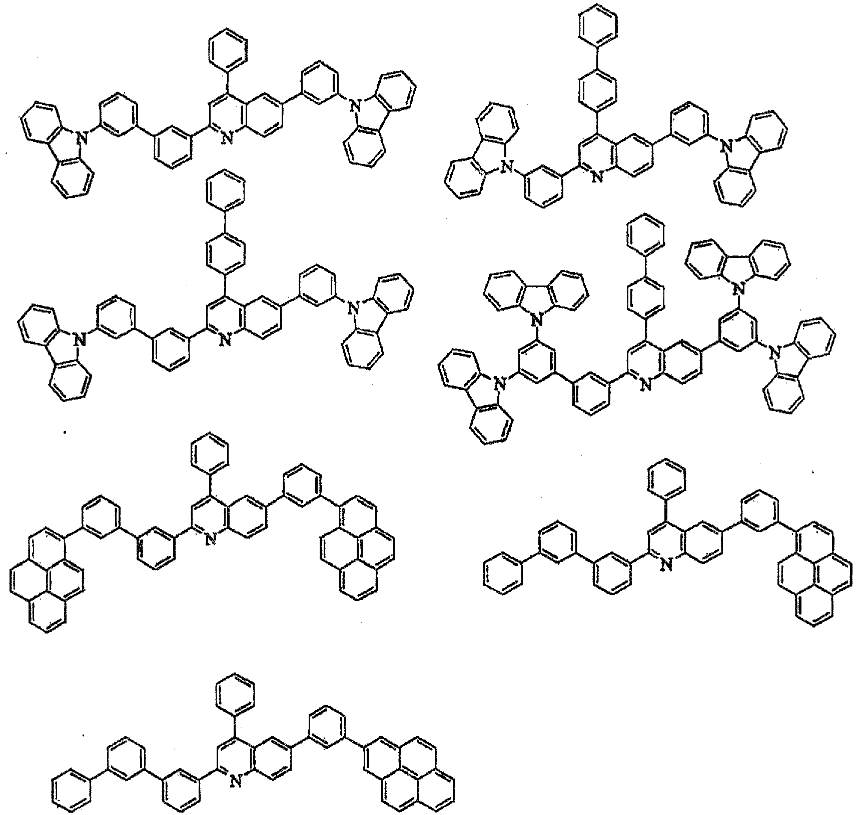

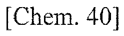

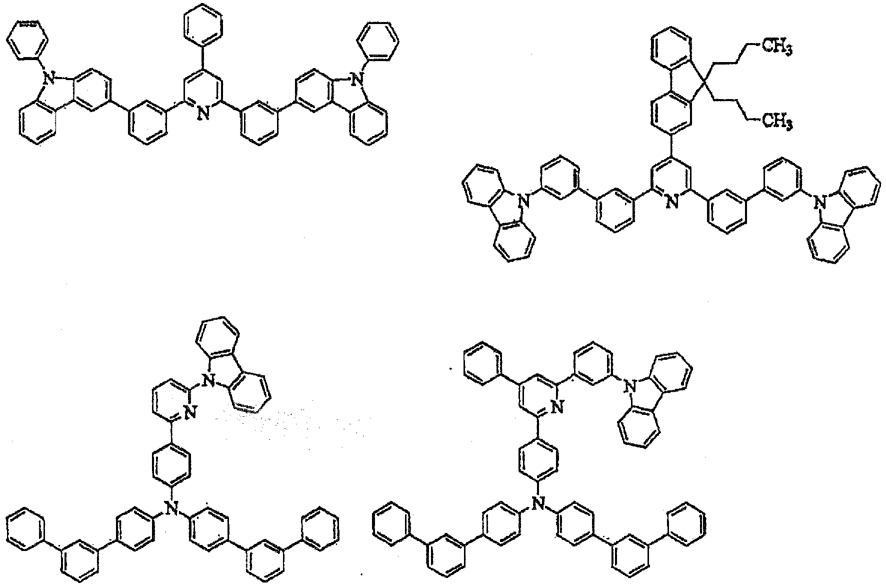

The light emitting layer forming composition of the present invention contains the first charge transport material in typically 0.1 weight% or more, preferably 0.5 weight% or more, further preferably 1 weight% or more, and typically 20 weight% or less, preferably 10 weight% or less, further preferably 5 weight% or less.

The content ratio of the light emitting material and the first charge transport material (light emitting material/first charge transport material) in the light emitting layer forming composition is typically 0.01 or more, preferably 0.03 or more, and typically 0.5 or less, preferably 0.3 or less.

### Other Components

The light emitting layer forming composition of the present invention may contain other components, provided that these are not detrimental to the advantages of the present invention. Examples of such other components include components derived from the hole transport layer and the hole injection layer, coat improvers such as leveling agents, defoaming agents, and thickeners, charge transport auxiliary agents such as electron-accepting compounds and electron donating compounds, and binder resins, as will be described later. These additional components may be used either alone, or in any combination and proportion of two or more.

For considerations such as preventing overly interfering with the charge movement in the formed thin film (coated light emitting layer), and preventing interfering with the emission from the light emitting material, and preventing lowering of thin film quality, the content of the additional component in the coated light emitting layer is typically 5 weight% or less, preferably 1 weight% or less, more preferably 0.5 weight% or less, particularly preferably 0 weight% (not contained).

From the standpoint of the advantages of the present invention, it is preferable that all the materials contained in the coated light emitting layer are a low-molecular-weight compound, including the light emitting material and the first charge transport material contained in the light emitting layer forming composition.

### Vapor Deposited Light Emitting Layer

In the organic electroluminescent element of the present invention, the second light emitting layer (the layer formed on the anode side of the light emitting layer via the first light emitting layer) formed by using a vacuum evaporation method is the vapor deposited light emitting layer.

As used herein, "vacuum evaporation method" refers to methods that form a layer by evaporating a compound in a vacuum.

For preventing collision with the residual gas molecules inside the vacuum evaporation device, and lowering the evaporation temperature of the evaporation material for easy evaporation, it is preferable that the degree of vacuum is typically 10⁻² Pa or less and 10⁻⁶ or more, and 10⁻³ Pa or less and 10⁻⁵ or more.

For ease of evaporation, the vapor deposited light emitting layer of the present invention is provided as a layer that contains a fluorescent material. Preferably, the vapor deposited light emitting layer contains at least a blue emitting material having a maximum emission wavelength in the 440 to 500 nm region.

### Second Charge Transport Material

The vapor deposited light emitting layer according to the present invention typically contains a second charge transport material, in addition to the light emitting material.

The second charge transport material contained in the vapor deposited light emitting layer is not particularly limited, as long as it does not interfere with the advantages of the present invention, and known low-molecular-weight materials may be used.

When the vapor deposited light emitting layer contains a blue fluorescent material, it is particularly preferable to use the compound represented by the following formula (VI) as the second charge transport material because of durability. 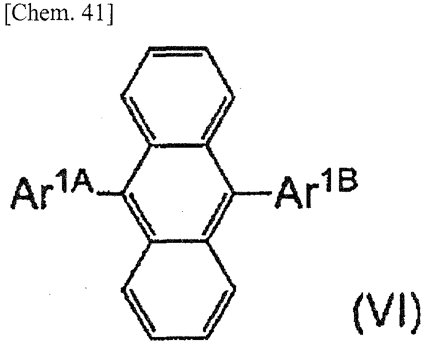 (In the formula (VI), Ar^{1A} and Ar^{1B} each independently represent an aromatic hydrocarbon group that may have a substituent, or an aromatic heterocyclic group that may have a substituent. The anthracene ring in the formula (VI) may have substituents other than Ar^{1A} and Ar¹B.)

Specific examples of the aromatic hydrocarbon group represented by Ar^{1A} and Ar^{1B} include groups derived from a benzene ring or fused rings of 2 to 5 benzene rings, such as a benzene ring, a naphthalene ring, a phenanthrene ring, an anthracene ring, a pyrene ring, a chrysene ring, a naphthacene ring, and a benzophenanthrene ring. Other examples include groups of 25 or less carbon atoms that have had two or more of these groups joined to each other.

Specific examples of the aromatic heterocyclic group represented by Ar^{1A} and Ar^{1B} include groups derived from a furan ring, a benzofuran ring, a dibenzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a cinnoline ring, a quinoxaline ring, a perimidine ring, a quinazoline ring, a quinazolinone ring, an azulene ring, and the like.

The substituent of the aromatic hydrocarbon group represented by the Ar^{1A} and Ar^{1B} may be an organic group such as alkyl, an aromatic hydrocarbon group, an aromatic heterocyclic group, alkoxy, (hetero)aryloxy, alkylthio, (hetero)arylthio, cyano, dialkylamino, alkylarylamino, and diarylamino. For compound stability, alkyl and aromatic hydrocarbon group are preferred, and aromatic hydrocarbon group is particularly preferred.

The alkyl as the substituent of the aromatic hydrocarbon group represented by Ar^{1A} and Ar^{1B} is preferably alkyl of 1 to 20 carbon atoms. Examples include methyl, ethyl, propyl, iso-propyl, butyl, iso-butyl, sec-butyl, tert-butyl, hexyl, octyl, cyclohexyl, decyl, and octadecyl. Methyl, ethyl, iso-propyl, sec-butyl, and tert-butyl are preferred. Methyl and ethyl are preferred for their wide availability as raw material, and cost.

The aromatic hydrocarbon group is preferably of 6 to 25 carbon atoms, and is preferably an aromatic hydrocarbon group derived from a six-membered monocyclic ring or fused rings of 2 to 5 six-membered rings. Examples include groups derived from a benzene ring, a naphthalene ring, an anthracene ring, a phenanthrene ring, a perylene ring, a tetracene ring, a pyrene ring, a benzopyrene ring, a chrysene ring, a triphenylene ring, a fluoranthene ring, and the like.

The aromatic heterocyclic group is preferably of 3 to 20 carbon atoms. Examples include groups derived from a furan ring, a benzofuran ring, a dibenzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a cinnoline ring, a quinoxaline ring, a perimidine ring, a quinazoline ring, a quinazolinone ring, an azulene ring, and the like.

The alkoxy is preferably of 1 to 20 carbon atoms. Examples include methoxy, ethoxy, isopropyloxy, cyclohexyloxy, and octadecyloxy.

The (hetero)aryloxy is preferably of 3 to 20 carbon atoms. Examples include phenoxy, 1-naphthyloxy, 9-anthryloxy, and 2-thienyloxy.

The alkylthio is preferably of 1 to 20 carbon atoms. Examples include methylthio, ethylthio, isopropylthio, and cyclohexylthio.

The (hetero)arylthio is preferably of 3 to 20 carbon atoms. Examples include phenylthio, 1-naphthylthio, 9-anthrylthio, and 2-thienylthio.

The dialkylamino is preferably of 2 to 29 carbon atoms. Examples include diethylamino, diisopropylamino, and methylethylamino.

The alkylarylamino is preferably of 7 to 30 carbon atoms. Examples include methylphenylamino.

The diarylamino is preferably of 12 to 30 carbon atoms. Examples include diphenylamino, and phenylnaphthylamino.

These substituents may be further substituted. Examples of such further substituents include the alkyl, aromatic hydrocarbon group, aromatic heterocyclic group, alkoxy, and diarylamino exemplified above. This shall not apply when the substituents are bound to each other to form a ring.

Specific examples of the second charge transport material preferably contained in the vapor deposited light emitting layer are given below. It should be noted, however, that the present invention is not limited to these.

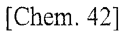

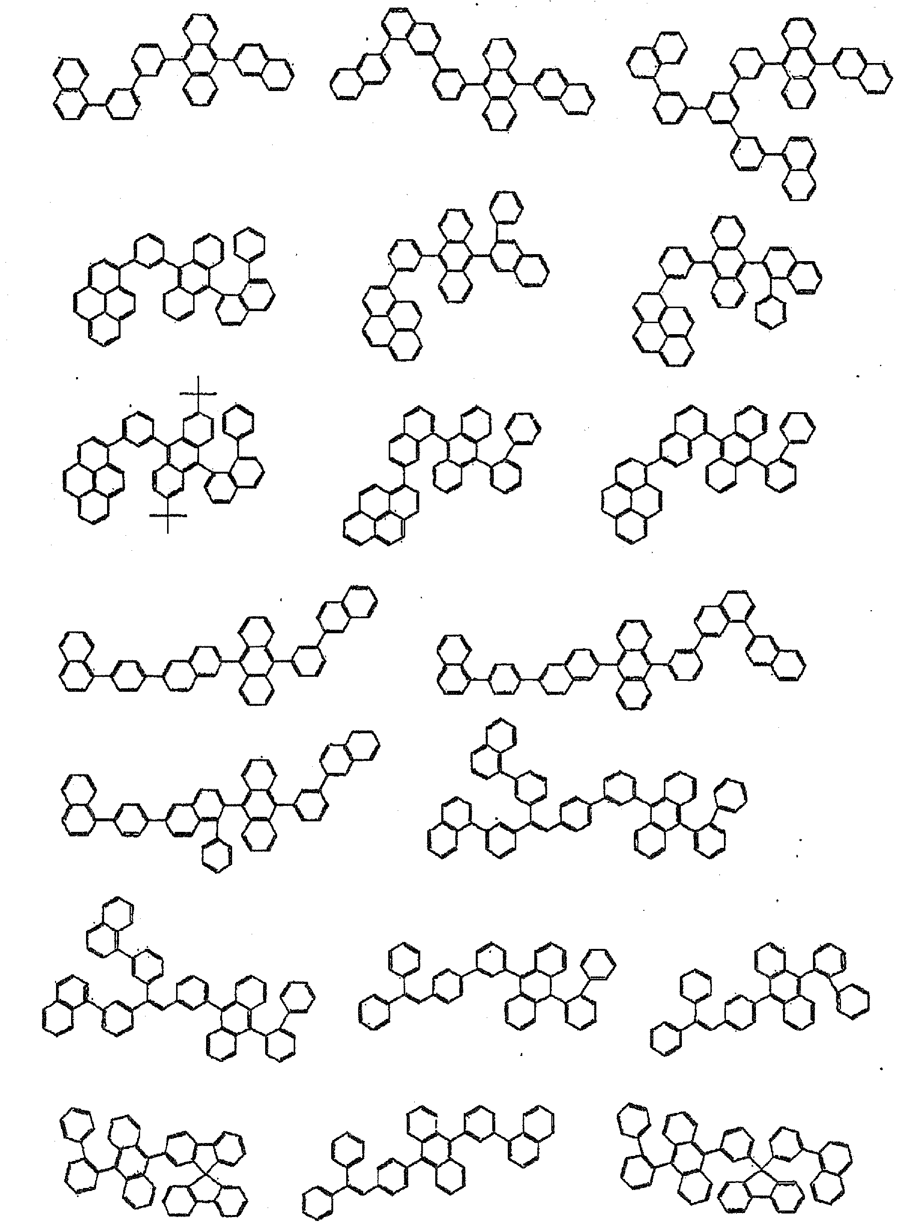

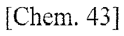

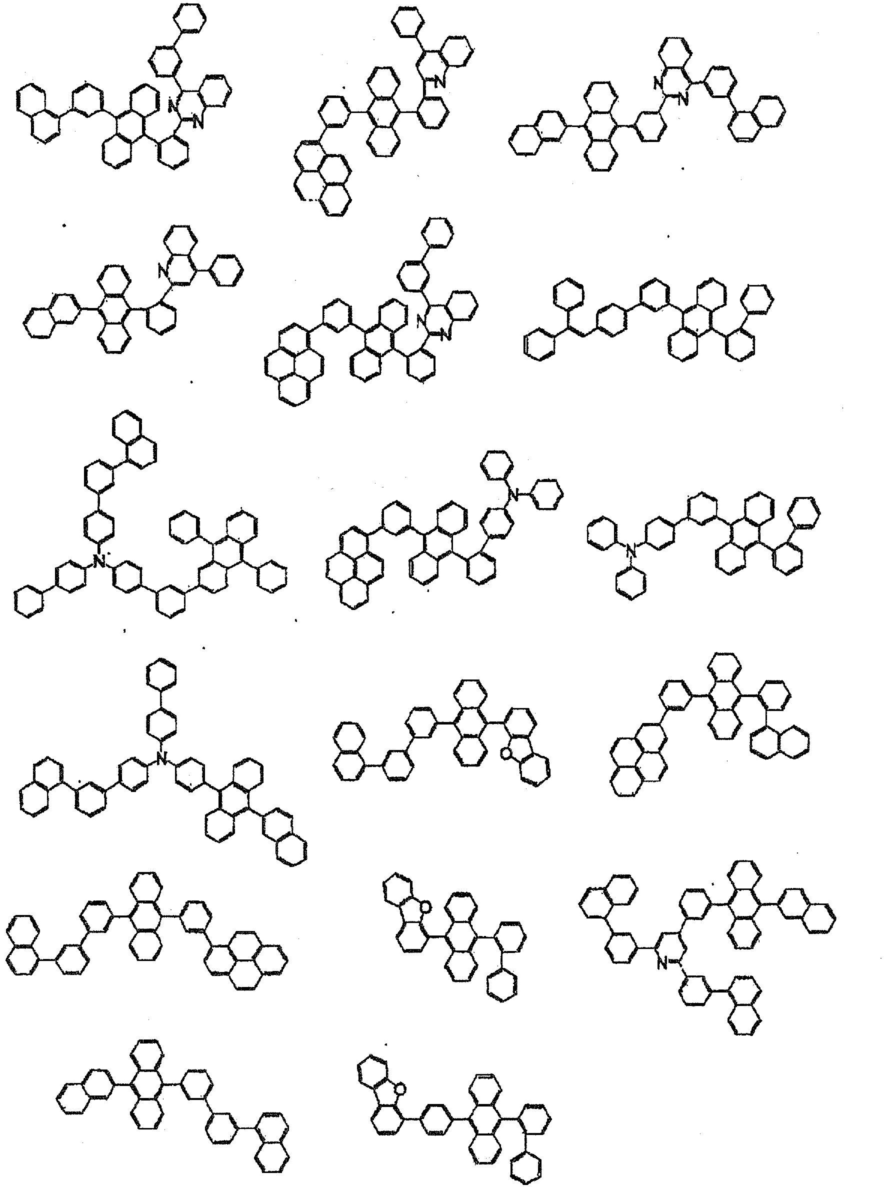

The second charge transport material may be used either alone, or in any combination and proportion of two or more.

### Other Components

The vapor deposited light emitting layer of the present invention may contain other components, provided that these do not interference with the advantages of the present invention. The other components may be the same components described in the Coated Light Emitting Layer section and the Other Components section.

### Component Content

The vapor deposited light emitting layer of the present invention contains the light emitting material in typically 0.001 weight% or more, preferably 0.005 weight% or more, further preferably 0.01 weight% or more, and typically 30 weight% or less, preferably 20 weight% or less, further preferably 15 weight% or less.

The vapor deposited light emitting layer of the present invention contains the second charge transport material in typically 0.001 weight% or more, and typically 99.999 weight% or less, preferably 99.995 weight% or less, further preferably 99.99 weight% or less.

The content ratio of the light emitting material and the second charge transport material (light emitting material/second charge transport material) in the vapor deposited light emitting layer is typically 0.01 or more, preferably 0.03 or more, and typically 0.5 or less, preferably 0.2 or less.

When the vapor deposited light emitting layer of the present invention contains an additional component, the additional component is contained in typically 5 weight% or less, preferably 1 weight% or less, more preferably 0.5 weight% or less, particularly preferably 0 weight% (not contained) for considerations such as preventing overly interfering with the charge movement in the formed thin film (vapor deposited light emitting layer), and preventing interfering with the emission from the light emitting material, and preventing lowering of thin film quality.

From the standpoint of the advantages of the present invention, it is preferable that all the materials contained in the light emitting layer are a low-molecular-weight compound, including the light emitting material and the second charge transport material contained in the vapor deposited light emitting layer.

### Interlayer

For the purpose of suppressing energy transfer between the coated light emitting layer and the vapor deposited light emitting layer, a non-emitting interlayer laminated by a vacuum evaporation method using a charge transport material may be used between the coated light emitting layer and the vapor deposited light emitting layer of the organic electroluminescent element of the present invention.

### Thickness

In the light emitting layer according to the present invention, the coated light emitting layer has a thickness of preferably 2 to 100 nm, particularly 3 to 60 nm from the standpoint of lowering the driving voltage of the product element.

The vapor deposited light emitting layer preferably has a thickness of 2 to 100 nm, particularly preferably 3 to 60 nm from the standpoint of lowering the driving voltage of the product element.

From the standpoint of lowering the driving voltage of the product element, and improving the stability of the emitted colors, the total thickness of the light emitting layer according to the present invention (the total thickness of the coated light emitting layer and the vapor deposited light emitting layer, plus the thickness of the interlayer when it is used) is preferably 5 to 100 nm, particularly preferably 10 to 80 nm.

### Hole Blocking Layer

The hole blocking layer of the present invention is a layer provided adjacent the cathode side of the second light emitting layer to improve element efficiency by confining the holes injected from the anode in the light emitting layer, and to prevent deterioration due to the passage of holes towards the cathode. The following describes the compounds contained in the hole blocking layer of the present invention.

### [Compounds Represented by Formula (1)]

The compound of the present invention contained in the hole blocking layer is represented by the following formula (1). 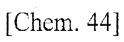 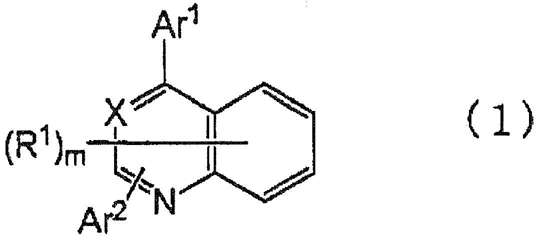 (In the formula (1), X represents C or N. Ar¹ and Ar² each independently represent an optionally substituted aromatic ring group. R¹ represents an optionally substituted organic group of 50 or less carbon atoms, and may be the same or different when a plurality of R¹ exists. m represents an integer of 0 to 5.)

### [1] Structural Characteristics

The compounds of the present invention represented by the formula (1) have a structure in which the substituents Ar¹ and Ar² representing aromatic ring groups are attached to a quinoline ring or a quinazoline ring, and in which the substituent R¹ is attached to the ring in number of m. Because of this structure, a relatively wider lowest unoccupied molecular orbital (LUMO) occurs around the quinoline ring or quinazoline ring in the compounds of the present invention than in compounds having a pyridine ring or a pyrimidine ring, and a delocalized charge distribution occurs around the quinoline ring or quinazoline ring.

Such a charge distribution is believed to enable a smooth transfer of electrons to the adjacent light emitting layer, and contribute to lowering the driving voltage. Presumably, this reduces the quenching of the adjacent fluorescent material, and contributes to improving the emission efficiency, making the organic electroluminescent element more durable.

The structure with the substituent aromatic ring group Ar¹ attached to position 4 of the quinoline ring or quinazoline ring appears to prevent the breaking of the ring, and improve the durability of the organic electroluminescent element. The quinoline ring is more preferred than the quinazoline ring in the compounds of the present invention.

### [2] Constituting Elements in Formula (1)

The following specifically describes the constituting elements in the formula (1).

Ar¹ and Ar²

Ar¹ and Ar² in formula (1) represent optionally substituted aromatic ring groups.

The aromatic ring groups represented by Ar¹ and Ar² are preferably aromatic ring groups of 3 to 25 carbon atoms. Specific examples of the aromatic ring groups include aromatic hydrocarbon groups such as phenyl, biphenyl (e.g., 3-biphenyl, and 4-biphenyl), terphenyl, naphthyl (e.g., 1-naphthyl, and 2-naphthyl), anthryl (e.g., 1-anthryl, 2-anthryl, and 9-anthryl), phenanthryl (e.g., 9-phenanthryl), naphthacenyl (e.g., 1-naphthacenyl, and 2-naphthacenyl), chrysenyl (e.g., 1-chrysenyl, 2-chrysenyl, 3-chrysenyl, 4-chrysenyl, 5-chrysenyl, and 6-chrysenyl), pyrenyl (e.g., 1-pyrenyl), triphenylenyl (e.g., 1-triphenylenyl), and coronenyl (e.g., 1-coronenyl); and aromatic heterocyclic groups such as pyridyl (e.g., 2-pyridyl), thienyl (e.g., 2-thienyl), benzothienyl (e.g., 3-benzothienyl), and quinolinyl (e.g., 2-quinolinyl). Particularly preferred are aromatic hydrocarbon groups.

Preferred as Ar¹ and Ar² in terms of compound stability are phenyl, 3-biphenyl, 4-biphenyl, 2-naphthyl, 9-phenanthryl, and 9-anthryl. Phenyl, 3-biphenyl, 4-biphenyl, and 2-naphthyl are particularly preferred for ease of compound purification, and phenyl, 3-biphenyl, and 4-biphenyl are most preferable.

Ar¹ and Ar² may have substituents. Specific examples of the substituents include alkyl of 1 to 20 carbon atoms, aromatic hydrocarbons of 6 to 25 carbon atoms, aromatic heterocyclic groups of 3 to 20 carbon atoms, alkyloxy of 1 to 20 carbon atoms, (hetero)aryloxy of 3 to 20 carbon atoms, alkylthio of 1 to 20 carbon atoms, (hetero)arylthio of 3 to 20 carbon atoms, cyano, and diarylamino such as diphenylamino. These groups may have further substituents. Specific examples of such further substituents are as exemplified for the substituents of Ar¹ and Ar². The substituents of Ar¹ are preferably alkyl and aromatic hydrocarbons in terms of compound stability, and aromatic hydrocarbons are particularly preferable.

Examples of the alkyl of 1 to 20 carbon atoms as a possible substituent of Ar¹ and Ar² include methyl, ethyl, propyl, isopropyl, butyl, iso-butyl, sec-butyl, tert-butyl, hexyl, octyl, cyclohexyl, decyl, and octadecyl. Preferred are methyl, ethyl, and isopropyl. Methyl and ethyl are preferred for their wide availability as raw material, and cost.

Examples of the aromatic hydrocarbon of 6 to 25 carbon atoms as a possible substituent of Ar¹ and Ar² include phenyl; naphthyl such as 1-naphthyl, and 2-naphthyl; anthryl such as 1-anthryl, 2-anthryl, and 9-anthryl; phenanthryl such as 9-phenanthryl; naphthacenyl such as 1-naphthacenyl, and 2-naphthacenyl; chrysenyl such as 1-chrysenyl, 2-chrysenyl, 3-chrysenyl, 4-chrysenyl, 5-chrysenyl, and 6-chrysenyl; pyrenyl such as 1-pyrenyl; triphenylenyl such as 1-triphenylenyl; coronenyl such as 1-coronenyl; biphenyl such as 4-biphenyl, and 3-biphenyl; and terphenyl such as o-terphenyl, m-terphenyl, and p-terphenyl. Preferred for compound stability are phenyl, 2-naphthyl, 9-phenanthryl, 9-anthryl, 4-biphenyl, and 3-biphenyl. Phenyl, 2-naphthyl, and 3-biphenyl are particularly preferred in terms of ease of compound purification.

Examples of the aromatic heterocyclic groups of 3 to 20 carbon atoms as a possible substituent of Ar¹ and Ar² include thienyl such as 2-thienyl, furyl such as 2-furyl, imidazolyl such as 2-imidazolyl, carbazolyl such as 9-carbazolyl, pyridyl such as 2-pyridyl, and triazin-yl such as 1,3,5-triazin-2-yl. Preferred for compound stability is 9-carbazolyl.

Examples of the alkyloxy of 1 to 20 carbon atoms as a possible substituent of Ar¹ and Ar² include methoxy, ethoxy, isopropyloxy, cyclohexyloxy, and octadecyloxy.

Examples of the (hetero)aryloxy of 3 to 20 carbon atoms as a possible substituent of Ar¹ and Ar² include phenoxy, 1-naphthyloxy, 9-anthryloxy, and 2-thienyloxy.

Examples of the alkylthio of 1 to 20 carbon atoms as a possible substituent of Ar¹ and Ar² include methylthio, ethylthio, isopropylthio, and cyclohexylthio.

Examples of the (hetero)arylthio of 3 to 20 carbon atoms as a possible substituent of Ar¹ and Ar² include phenylthio, 1-naphthylthio, 9-anthrylthio, and 2-thienylthio.

When Ar¹ and Ar² have substituents such as above, the positions of the substituents are not particularly limited. For example, when Ar¹ is phenyl, the substituent is preferably para or meta with respect to the substitution position on the quinoline ring or quinazoline ring.

R¹ and m

R¹ in formula (1) is a substituent attached to the quinoline ring or quinazoline ring, and m represents the number of the substituents R¹ on the ring. m is an integer of 0 to 5, preferably 0 to 2, particularly preferably 0 to 1, and m = 0 means that the substituent R¹ is not attached to the ring. When m is 2 or more, the plurality of the substituents R¹ attached to the ring may be the same or different.

R¹ in formula (1) represents an organic group of 50 or less carbon atoms, and may have a substituent. The number of carbon atoms in the organic group R¹ is typically 50 or less, preferably 30 or less, including the carbon atoms present in the substituent when R¹ has a substituent.

Specific examples of the organic group represented by R¹ include alkyl of 1 to 20 carbon atoms, aromatic hydrocarbons of 6 to 25 carbon atoms, aromatic heterocyclic groups of 3 to 20 carbon atoms, alkyloxy of 1 to 20 carbon atoms, (hetero)aryloxy of 3 to 20 carbon atoms, alkylthio of 1 to 20 carbon atoms, (hetero)arylthio of 3 to 20 carbon atoms, and cyano. Preferred as R¹ in terms of compound stability are alkyl, aromatic hydrocarbons, and aromatic heterocyclic groups. Aromatic hydrocarbons are particularly preferable.

Examples of the alkyl of 1 to 20 carbon atoms as the organic group represented by R¹ include methyl, ethyl, propyl, isopropyl, butyl, iso-butyl, sec-butyl, tert-butyl, hexyl, octyl, cyclohexyl, decyl, and octadecyl. Preferred are methyl, ethyl, and isopropyl. Methyl and ethyl are preferred for their wide availability as raw material, and cost.

Examples of the aromatic hydrocarbons of 6 to 25 carbon atoms as the organic group represented by R¹ include phenyl; naphthyl such as 1-naphthyl, and 2-naphthyl; anthryl such as 1-anthryl, 2-anthryl, and 9-anthryl; phenanthryl such as 9-phenanthryl: naphthacenyl such as 1-naphthacenyl, and 2-naphthacenyl; chrysenyl such as 1-chrysenyl, 2-chrysenyl, 3-chrysenyl, 4-chrysenyl, 5-chrysenyl, and 6-chrysenyl; pyrenyl such as 1-pyrenyl; triphenylenyl such as 1-triphenylenyl; and coronenyl such as 1-coronenyl. Preferred for compound stability are phenyl, 2-naphthyl, 1-anthryl, 9-anthryl, and 9-phenanthryl. Phenyl and 2-naphthyl are particularly preferable in terms of ease of compound purification.

Examples of the aromatic heterocyclic groups of 3 to 20 carbon atoms as the organic group represented by R¹ include thienyl such as 2-thienyl, furyl such as 2-furyl, imidazolyl such as 2-imidazolyl, carbazolyl such as 9-carbazolyl, pyridyl such as 2-pyridyl, and triazin-yl such as 1,3,5-triazin-2-yl. Preferred for compound stability is 9-carbazolyl.

Examples of the alkyloxy of 1 to 20 carbon atoms as the organic group represented by R¹ include methoxy, ethoxy, isopropyloxy, cyclohexyloxy, and octadecyloxy. Methoxy and ethoxy are preferred in terms of providing a high glass transition temperature.

Examples of the (hetero)aryloxy of 3 to 20 carbon atoms as the organic group represented by R¹ include phenoxy, 3-phenoxyphenoxy, 2-naphthyloxy, 9-anthryloxy, and 2-thienyloxy. Preferred for ease of compound purification are phenoxy, 3-phenoxyphenoxy, and 2-naphthyloxy. 3-Phenoxyphenoxy is particularly preferred.

Examples of the alkylthio of 1 to 20 carbon atoms as the organic group represented by R¹ include methylthio, ethylthio, isopropylthio, and cyclohexylthio. Methylthio and ethylthio are preferred in terms of providing a high glass transition temperature.

Examples of the (hetero)arylthio of 3 to 20 carbon atoms as the organic group represented by R¹ include phenylthio, 1-naphthylthio, 9-anthrylthio, and 2-thienylthio.

These organic groups may have further substituents. Examples of such further substituents are as exemplified above for the substituents of Ar¹.

### [3] Compounds Represented by Formula (2)

The compounds represented by the formula (1) are preferably compounds represented by the following formula (2). The increased number of the substituent aromatic ring groups attached to the quinoline ring or quinazoline ring appears to widen the lowest unoccupied molecular orbital (LUMO), and facilitate a smooth transfer of electrons to the adjacent light emitting layer, increasing the glass transition point of the compound, and improving the heat resistance. 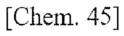 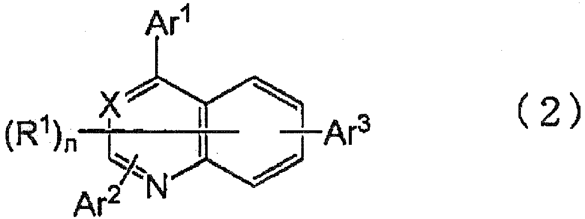 (In the formula (2), X represents C or N. Ar¹ to Ar³ each independently represent an optionally substituted aromatic ring group. R¹ represents an optionally substituted organic group of 50 or less carbon atoms, and may be the same or different when a plurality of R¹ exists. n represents an integer of 0 to 4.)

Ar¹, Ar², and Ar³

Ar¹, Ar², and Ar³ in formula (2) have the same definition as Ar¹ of the formula (1). Specific examples and preferred examples of Ar¹, Ar², and Ar³, and examples of the possible substituents of Ar¹, Ar², and Ar³ are as described for Ar¹ of formula (1).

R¹ and n

R¹ in formula (2) has the same definition as R¹ of the formula (1). Specific examples and preferred examples of R¹, and examples of the possible substituents of R¹ are as described for R¹ of formula (1).

In formula (2), n represents the number of the substituent R¹ attached to the quinoline ring or quinazoline ring. n is an integer of 0 to 4, preferably 0 to 2, particularly preferably 0 to 1. n = 0 means that the substituent R¹ is not attached to the ring. When n is 2 or more, the plurality of the substituents R¹ attached to the ring may be the same or different.

### [4] Compounds Represented by Formula (3)

The compounds represented by the formula (2) are preferably compounds represented by the following formula (3). This is because the structure in which the substituent aromatic ring groups Ar²¹ and Ar²² are attached to the nitrogen atom with unshared electron pairs appears to provide high hole affinity, and improve the durability against holes with the highest occupied orbital (HOMO) of the compound emanating around the nitrogen atom. 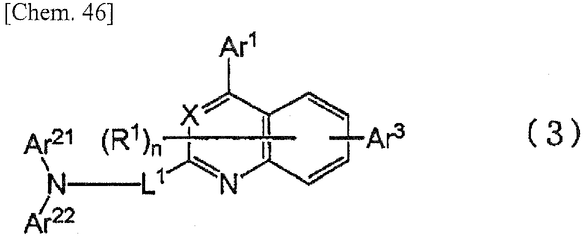 (In the formula (3), X represents C or N. Ar¹, Ar³, Ar²¹, and Ar²² each independently represent an optionally substituted aromatic ring group. Ar²¹ and Ar²² may be bonded to each other to form a ring. R¹ represents an optionally substituted organic group of 50 or less carbon atoms, and may be the same or different when a plurality of R¹ exists. L¹ represents a single bond, or an optionally substituted aromatic ring group of 25 or less carbon atoms. n represents an integer of 0 to 4.)

Ar¹, Ar³, Ar²¹, and Ar²²

Ar¹, Ar³, Ar²¹, and Ar²² in formula (3) have the same definition as Ar¹ of formula (1). Specific examples and preferred examples of Ar¹, Ar³, Ar²¹, and Ar²², and examples of the possible substituents of Ar¹, Ar², Ar²¹ and Ar²² are as described for Ar¹ of formula (1).

R¹ and n

R¹ and n in formula (3) have the same definitions as R¹ and n of the formula (2). Specific examples and preferred examples of R¹, and examples of the possible substituents of R¹ are as described for R¹ of formula (2).

L¹

L¹ in formula (3) represents a single bond, or an optionally substituted aromatic ring group of 25 or less carbon atoms. Specific examples of the aromatic ring group of 25 or less carbon atoms include aromatic hydrocarbons of 6 to 25 carbon atoms, and aromatic heterocyclic groups of 3 to 25 carbon atoms. Preferred for compound stability are aromatic hydrocarbons.

Examples of the aromatic hydrocarbons of 6 to 25 carbon atoms represented by L¹ include phenylene such as 1,4-phenylene, and 1,3-phenylene; naphthylene such as 1,6-naphthylene; phenanthrylene such as 3,9-phenanthrylene; anthrylene such as 2,6-anthrylene, and 9,10-anthrylene; pyrenylene such as 1,6-pyrenylene; triphenylenylene such as 2,7-triphenylenylene; and biphenylene such as 4,4'-biphenylene, 3,3'-biphenylene, and 4,3'-biphenylene. Preferred for compound stability are 1,4-phenylene, 1,3-phenylene, 3,3'-biphenylene, 4,3'-biphenylene, and 1,6-naphthylene. In terms of ease of compound purification, 1,3-phenylene, 3,3'-biphenylene, and 1,6-naphthylene are particularly preferable.

Examples of the aromatic heterocyclic groups of 3 to 25 carbon atoms represented by L¹ include thienylene such as 2,5-thienylene, furylene such as 2,5-furylene, pyridylene such as 2,6-pyridylene, and quinolylene such as 2,6-quinolylene. Preferred for compound stability are 2,6-pyridylene, and 2,6-quinolylene.

The possible substituents of L¹ are as described for the possible substituents of Ar¹ of the formula (1).

### [5] Compounds Represented by Formula (4)

The compounds represented by the formula (3) are preferably compounds represented by the following formula (4) in which the substituent Ar³ is attached to position 6 of the quinoline ring or quinazoline ring.

The presence of the aromatic ring group Ar³ at position 6 of the quinoline ring or quinazoline ring appears to further widen the lowest unoccupied molecular orbital (LUMO), and facilitate a smooth transfer of electrons to the adjacent light emitting layer, improving the durability against electrons. 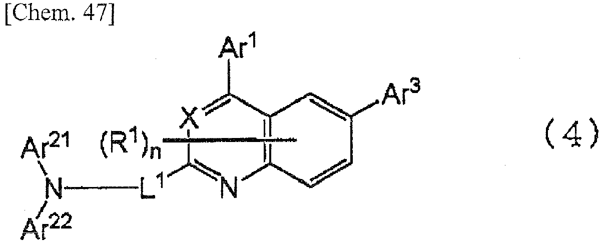 (In formula (4), X represents C or N. Ar¹, Ar³, Ar²¹, and Ar²² each independently represent an optionally substituted aromatic ring group. Ar²¹ and Ar²² may be bonded to each other to form a ring. R¹ represents an optionally substituted organic group of 50 or less carbon atoms, and may be the same or different when a plurality of R¹ exists. L¹ represents a single bond, or an optionally substituted aromatic ring group of 25 or less carbon atoms. n represents an integer of 0 to 4.)

Ar¹, Ar³, Ar²¹, Ar²², R¹, L¹, and n

Ar¹, Ar³, Ar²¹, Ar²², R¹, L¹, and n in formula (4) have the same definition as Ar¹, Ar³, Ar²¹, Ar²², R¹, L¹, and n of formula (3). Specific examples and preferred examples of Ar¹, Ar³, Ar²¹, Ar²², R¹, and L¹, and examples of the possible substituents of Ar¹, Ar³, Ar²¹, Ar²², R¹, and L¹ are as described for Ar¹, Ar³, Ar²¹, Ar²², R¹, L¹, and n of formula (3).

### [6] Molecular Weight

The upper limit of the molecular weight of the compounds represented by formula (1) of the present invention is typically 7,000 or less, and is preferably 5,000 or less, particularly preferably 3,000 or less for ease of compound purification, and is most preferably 1,500 or less in terms of increasing purity by sublimation purification.

The lower limit of the molecular weight of the compounds represented by formula (1) of the present invention is typically 100 or more, and is preferably 500 or more in terms of the heat stability of the compound.

### [7] Glass Transition Point

The compounds represented by formula (1) of the present invention has a glass transition point of typically 100°C or more, preferably 120°C or more from the standpoint of heat resistance.

### [8] Exemplary Compounds

Specific examples of the compounds represented by formula (1) of the present invention are given below. However, the compounds of the present invention are not limited to the following exemplary compounds. In the following exemplary compounds, X represents C or N.

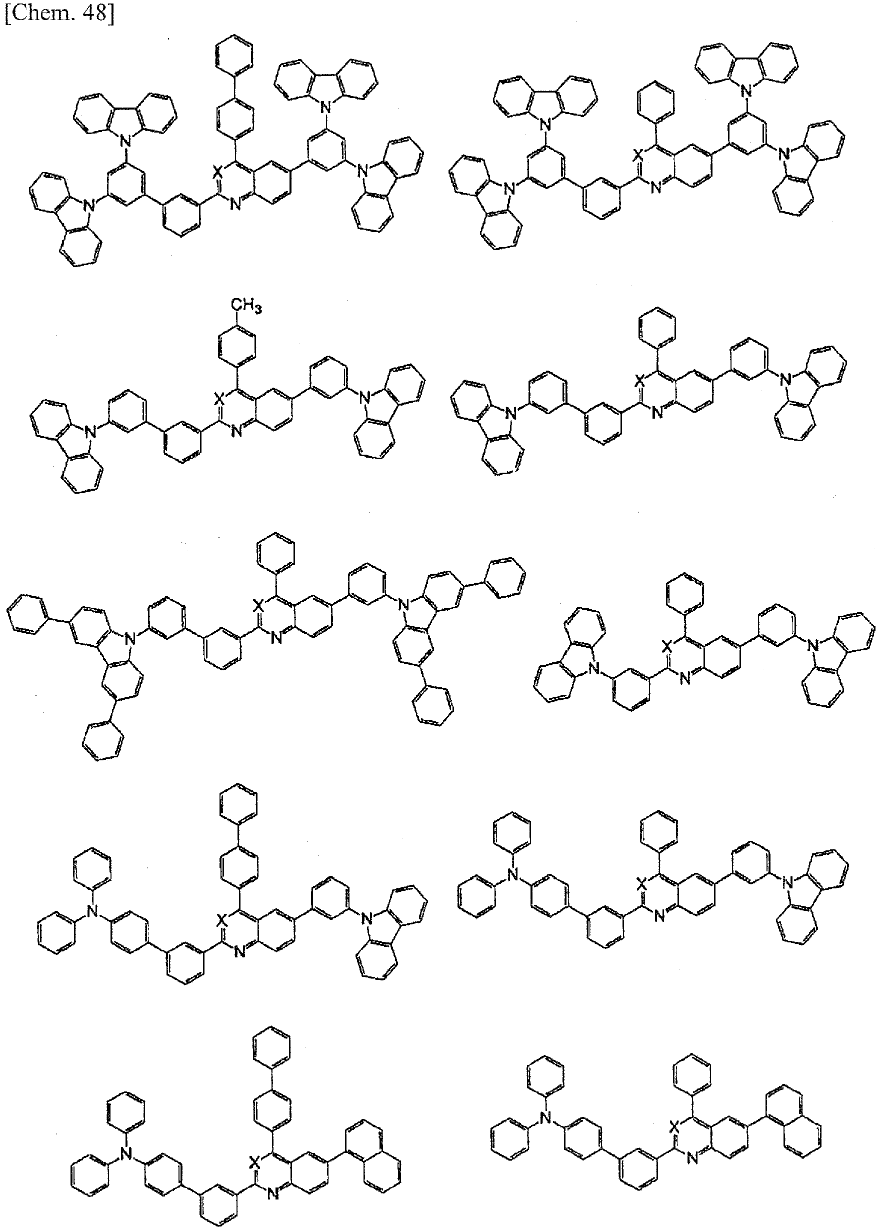

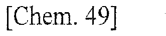

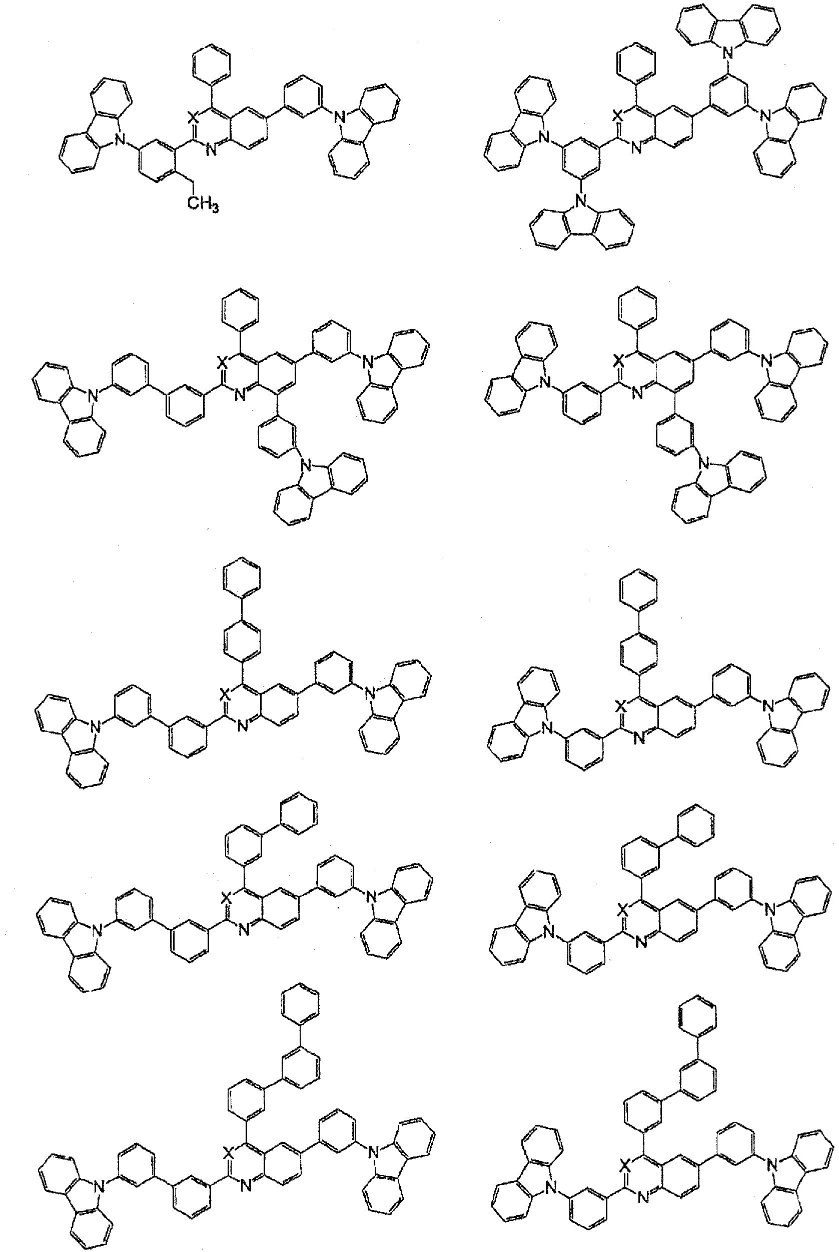

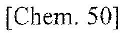

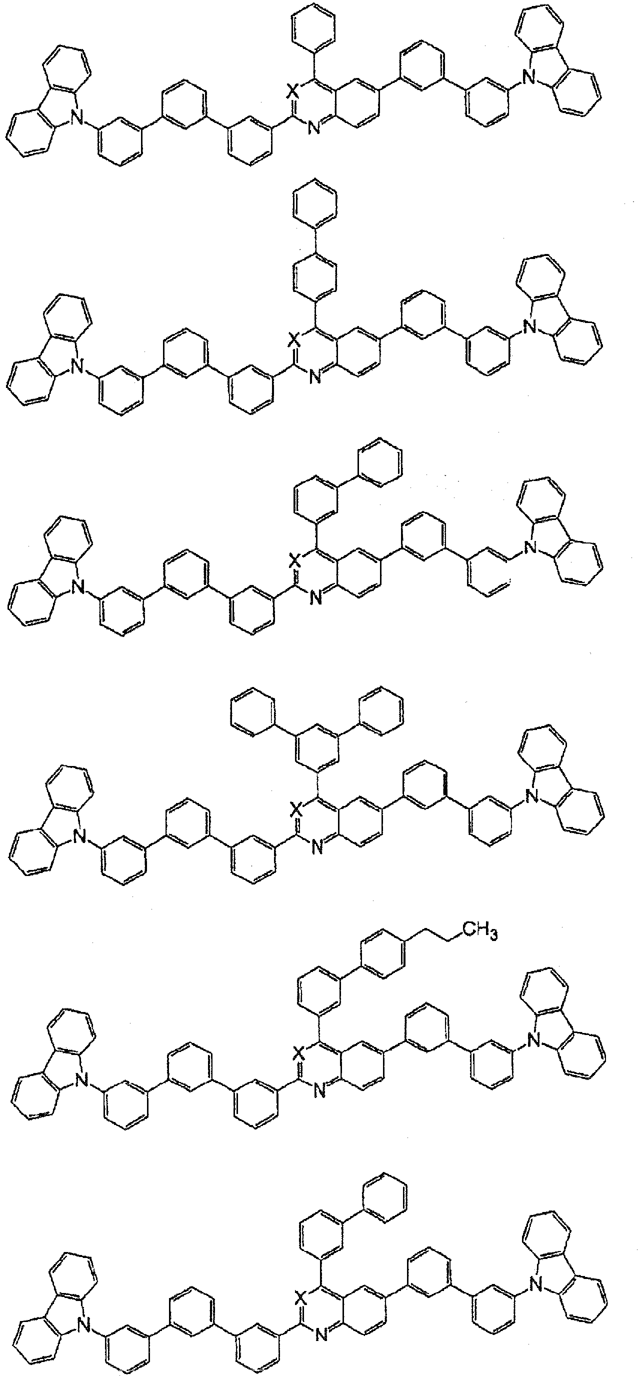

### Layer Configuration of Organic Electroluminescent Element

The layer configuration of the organic electroluminescent element of the present invention, and the general method of forming the organic electroluminescent element are described below with reference to FIG. 1.

FIG. 1 is a schematic cross sectional diagram representing an exemplary structure of an organic electroluminescent element 10 of the present invention. Referring to FIG. 1, the organic electroluminescent element 10 includes a substrate 1, an anode 2, a hole injection layer 3, a hole transport layer 4, a light emitting layer 5, a hole blocking layer 6, an electron transport layer 7, an electron injection layer 8, and a cathode 9.

### Substrate

The substrate 1 serves as the base of the organic electroluminescent element, and materials such as a quartz or glass plate, a metal board or a metal foil, and a plastic film or sheet are used. It is particularly preferable to use a glass plate, and a transparent plate of synthetic resins such as polyester, polymethacrylate, polycarbonate, and polysulfone. When synthetic resin is used for the substrate, care must be taken for the gas barrier property. When the gas barrier property of the substrate is too low, ambient air passes through the substrate, and deteriorates the organic electroluminescent element. In a preferred method, a dense silicon oxide film or the like is provided on at least one side of the synthetic resin substrate to ensure a sufficient gas barrier property.

### Anode

The anode 2 has a role of injecting holes to the layer on the side of the light emitting layer 5.

The anode 2 is typically formed by using materials such as metal (e.g., aluminum, gold, silver, nickel, palladium, platinum, etc.), metal oxides (e.g., indium and/or tin oxide), halogenated metal (e.g., copper iodide), and conductive polymer (e.g., carbon black, poly(3-methylthiophene), polypyrrole, and polyaniline).

The anode 2 is formed typically by using a method such as sputtering, and vacuum evaporation. When forming the anode 2 by using materials such as silver or other metallic fine particles, fine particles of copper iodide or the like, carbon black, conductive metal oxide fine particles, and a conductive polymer fine powder, these may be dispersed in a suitable binder resin solution, and applied to the substrate 1 to form the anode 2. In the case of conductive polymer, the anode 2 may be formed by directly forming a thin film on the substrate 1 by electrolytic polymerization, or by applying a conductive polymer onto the substrate 1 (Appl. Phys. Lett., Vol. 60, p. 2711, 1992).

The anode 2 typically has a monolayer structure. However, the anode 2 may have a laminate structure of more than one material, as desired.

The thickness of the anode 2 depends on the required transparency. When transparency is required, it is desirable to have a visible light transmittance of typically 60% or more, preferably 80% or more. In this case, the thickness of the anode 2 is typically about 5 nm or more, preferably about 10 nm or more, and typically about 1,000 nm or less, preferably about 500 nm or less. When transparency is not required, the anode 2 may have any thickness, and may have the same thickness as the substrate 1. Different conductive materials may be laminated on the anode 2.

For the purpose of removing the impurities adhered to the anode 2, and adjusting the ionization potential and improving the hole injectability, it is preferable to subject the surface of the anode 2 to a ultraviolet (UV)/ozone treatment, an oxygen plasma treatment or, an argon plasma treatment.

### Hole Injection Layer

The hole injection layer 3 is provided to inject holes from the anode 2 to the layers on the side of the light emitting layer 5, and is typically formed on the anode 2.

The method used to form the hole injection layer 3 in the present invention is not particularly limited, and may be a vacuum evaporation method or a wet film forming method. However, from the standpoint of reducing dark spots, it is preferable to form the hole injection layer 3 by using a wet film forming method.

The thickness of the hole injection layer 3 is typically 5 nm or more, preferably 10 nm or more, and typically 1,000 nm or less, preferably 500 nm or less.

### Formation of Hole Injection Layer by Wet film forming method

When a wet film forming method is used, the hole injection layer 3 is typically formed as follows. The material of the hole injection layer 3 is mixed with a suitable solvent (hole injection layer solvent) to prepare a film formation composition (hole injection layer forming composition). The composition for forming the hole injection layer 3 is then applied and deposited onto the underlayer (typically, the anode 2) of the hole injection layer by using a suitable technique. The composition is then dried to form the hole injection layer 3.

### Hole Transporting Compound

The hole injection layer forming composition typically contains a hole transporting compound and a solvent as constituent materials of the hole injection layer 3.

Typically, the hole transporting compound may be a high molecular compound such as polymer, or a low-molecular-weight compound such as monomer, as long as it is capable of transporting holes and usable for the hole injection layer 3 of the organic electroluminescent element. Preferably, the hole transporting compound is a high molecular compound.

From the standpoint of the charge injection barrier between the anode 2 and the hole injection layer 3, the hole transporting compound is preferably a compound having an ionization potential of 4.5 eV to 6.0 eV. Examples of the hole transporting compound include aromatic amine derivatives, phthalocyanine derivatives, porphyrin derivatives, oligothiophene derivatives, polythiophene derivatives, benzylphenyl derivatives, compounds joined to tertiary amine with a fluorene group, hydrazone derivatives, silazane derivatives, silanamine derivatives, phosphamine derivatives, quinacridone derivatives, polyaniline derivatives, polypyrrole derivatives, polyphenylenevinylene derivatives, polythienylenevinylene derivatives, polyquinoline derivatives, polyquinoxaline derivatives, and carbon.

Taking an aromatic amine derivative as an example, the term "derivative" as used herein refers to compounds that contain the aromatic amine itself, or that contain a compound having an aromatic amine backbone, and may be a polymer or a monomer.

The hole transporting compound used as the material of the hole injection layer 3 may contain such compounds either alone or in a combination of two or more. When two or more hole transporting compounds are contained, the hole transporting compounds may be used in any combination. Preferably, one or more aromatic tertiary amine polymer compounds are used in combination with one or more other hole transporting compounds.

Of the foregoing examples, aromatic amine compounds are preferred, and aromatic tertiary amine compounds are particularly preferred from the standpoint of amorphous property, and visible light transmittance. Here, aromatic tertiary amine compounds are compounds having an aromatic tertiary amine structure, and encompass compounds having a group derived from aromatic tertiary amines.

The type of aromatic tertiary amine compound is not particularly limited, and is preferably a polymer compound having a weight average molecular weight of 1,000 or more and 1,000,000 or less (a polymerizable compound with a repeating unit) from the standpoint of obtaining uniform emission by the surface smoothing effect. Preferred examples of the aromatic tertiary amine polymer compound include polymer compounds having the repeating unit of the following formula (I). 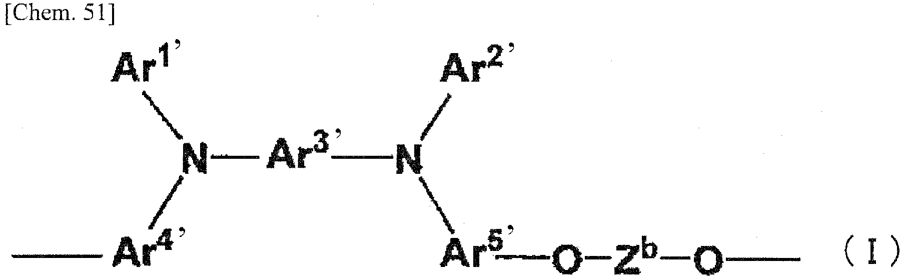 (In the formula (I), Ar¹' and Ar²' each independently represent an aromatic hydrocarbon group that may have a substituent, or an aromatic heterocyclic group that may have a substituent. Ar³' to Ar⁵' each independently represent an aromatic hydrocarbon group that may have a substituent, or an aromatic heterocyclic group that may have a substituent. Z^{b} represents a linking group selected from the group of linking groups below. Two of the Ar¹' to Ar⁵' bound to the same nitrogen atom may be bound to each other to form a ring. 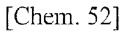 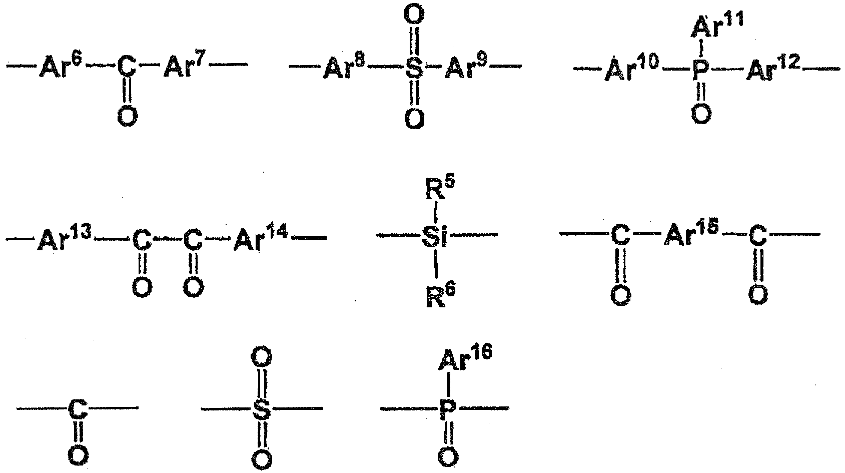 (In each formula, Ar⁶ to Ar¹⁶ each independently represent an aromatic hydrocarbon group that may have a substituent, or an aromatic heterocyclic group that may have a substituent. R⁵ and R⁶ each independently represent a hydrogen atom or any substituent.))

From the standpoint of the solubility, the heat resistance, and the hole injectability and transportability of the polymer compound, the aromatic hydrocarbon group and the aromatic heterocyclic group represented by Ar¹' to Ar⁵' and Ar⁶ to Ar¹⁶ are preferably groups derived from a benzene ring, a naphthalene ring, a phenanthrene ring, a thiophene ring, and a pyridine ring, further preferably groups derived from a benzene ring, and a naphthalene ring.

The aromatic hydrocarbon group and the aromatic heterocyclic group represented by Ar¹' to Ar⁵' and Ar⁶ to Ar¹⁶ may be further substituted. The molecular weight of the substituent is typically about 400 or less, preferably about 250 or less. Preferred examples of the substituent include alkyl, alkenyl, alkoxy, aromatic hydrocarbon group, and aromatic heterocyclic group.

When R⁵ and R⁶ are any substituent, examples of the substituent include alkyl, alkenyl, alkoxy, silyl, siloxy, aromatic hydrocarbon group, and aromatic heterocyclic group.

Specific examples of the aromatic tertiary amine polymer compound having the repeating unit of formula (I) include the compounds described in WO2005/089024.

Also preferred as the hole transporting compound is a conductive polymer (PEDOT/PSS) obtained by polymerizing 3,4-ethylenedioxythiophene(3,4-ethylenedioxythiophene) (a derivative of polythiophene) in high molecular polystyrene sulfonate. The polymer may be one in which the terminals are capped with methacrylate or the like.

The hole transporting compound may be a crosslinking compound as described in the Hole Transport Layer section below. The same film formation methods described above also may be used for the crosslinking compound.

The hole transporting compound in the hole injection layer forming composition may have any concentration, as long as it is not detrimental to the advantages of the present invention. However, from the standpoint of thickness uniformity, the concentration of the hole transporting compound is typically 0.01 weight% or more, preferably 0.1 weight% or more, further preferably 0.5 weight% or more, and typically 70 weight% or less, preferably 60 weight% or less, further preferably 50 weight% or less. Non-uniform thickness may occur when the concentration is too high. When too low, defects may occur in the deposited hole injection layer.

### Electron-Accepting Compound

The hole injection layer forming composition preferably contains an electron-accepting compound as a constituent material of the hole injection layer 3.

The electron-accepting compound is preferably an oxidative compound capable of accepting electrons from the hole transporting compound. Specifically, a compound with an electron affinity of 4 eV or more is preferred, and a compound with an electron affinity of 5 eV or more is further preferred.

Examples of such electron-accepting compounds include one or more compounds selected from the group consisting of triaryl boron compounds, halogenated metals, Lewis acids, organic acids, onium salts, salts of arylamine and halogenated metal, and salts of arylamine and Lewis acid. Specific examples include onium salts with substituted organic groups, such as 4-isopropyl-4'-methyldiphenyl iodonium tetrakis(pentafluorophenyl)borate, and triphenylsulfoniumtetrafluoroborate (WO2005/089024); high-valent inorganic compounds such as iron(III) chloride (JP-A-11-251067), and ammonium peroxodisulfate; cyano compounds such as tetracyanoethylene; aromatic boron compounds such as tris(pentafluorophenyl)borane (JP-A-2003-31365); fullerene derivatives; iodine; and sulfonic acid ions such as polystyrene sulfonate ions, alkylbenzene sulfonic acid ions, and camphor sulfonic acid ions.

The electron-accepting compound can improve the conductivity of the hole injection layer 3 by oxidizing the hole transporting compound.

The content of the electron-accepting compound in the hole injection layer 3 or in the hole injection layer forming composition is typically 0.1 mol% or more, preferably 1 mol% or more with respect to the hole transporting compound. The content is typically 100 mol% or less, preferably 40 mol% or less.

### Other Constituent Materials

Components other than the hole transporting compound and the electron-accepting compound may be contained as material of the hole injection layer 3, provided that these are not detrimental to the advantages of the present invention. Examples of such other components include various light emitting materials, electron transporting compounds, binder resins, and coat improvers. These additional components may be used either alone, or in any combination and proportion of two or more.

### Solvent

Preferably, at least one of the solvents of the hole injection layer forming composition used in the wet film forming method is a compound that can dissolve the constituent material of the hole injection layer 3. The solvent has a boiling point of typically 110°C or more, preferably 140°C or more, more preferably 200°C or more, and typically 400°C or less, preferably 300°C or less. When the boiling point of the solvent is too low, the drying rate may become too fast, and the film quality may deteriorate. An excessively high solvent boiling point requires increasing the temperature of the drying step. This may have adverse effects on the other layers and the substrate.

Examples of the solvent include ether solvents, ester solvents, aromatic hydrocarbon solvents, and amide solvents.

Examples of the ether solvents include aliphatic ethers such as ethylene glycol dimethyl ether, ethylene glycol diethyl ether, and propylene glycol-1-monomethyl ether acetate (PGMEA); and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole.

Examples of the ester solvents include aromatic esters such as phenyl acetate, phenyl propionate, methyl benzoate, ethyl benzoate, propyl benzoate, and n-butyl benzoate.

Examples of the aromatic hydrocarbon solvents include toluene, xylene, cyclohexylbenzene, 3-isopropylbiphenyl, 1,2,3,4-tetramethylbenzene, 1,4-diisopropylbenzene, and methylnaphthalene.

Examples of the amide solvents include N,N-dimethylformamide, and N,N-dimethylacetamide.

Compounds such as dimethylsulfoxide also may be used.

These solvents may be used either alone, or in any combination and proportion of two or more.

### Film Formation Method

After preparing the hole injection layer forming composition, the composition is applied and deposited on the underlayer (typically, the anode 2) of the hole injection layer 3 by using a wet film forming method, and dried to form the hole injection layer 3.

The temperature of the coating step is preferably 10°C or more, and 50°C or less to prevent damage to the film due to formation of crystals in the composition.

The relative humidity in the coating step is not particularly limited, as long as it is not detrimental to the advantages of the present invention, and is typically 0.01 ppm or more, typically 80% or less.

After being applied, the hole injection layer forming composition film is dried, typically by heating. The heating means used in the heating step may be, for example, a clean oven, a hot plate, infrared, a halogen heater, or microwave irradiation. A clean oven and a hot plate are preferably used to evenly apply heat to the whole film.

The heating temperature in the heating step is preferably equal to or greater than the boiling point of the solvent used for the hole injection layer forming composition, as long as it is not detrimental to the advantages of the present invention. When the solvent used for the hole injection layer is a mixed solvent of two or more solvents, it is preferable to heat at least one of the solvents at a temperature equal to or greater than the boiling point of the solvent. Considering increase of the solvent boiling point, heating in the heat step is performed preferably at 120°C or more, preferably 410°C or less.

The heating time in the heating step is not particularly limited, provided that the heating temperature is equal to or greater than the boiling point of the solvent of the hole injection layer forming composition, and that the coating is not insolubilized to a sufficient degree. However, heating time is preferably 10 seconds or more, typically 180 minutes or less. When the heating time is too long, the components of the other layers tend to diffuse. When too short, the hole injection layer tends to be non-uniform. Heating may be performed as two separate procedures.

### Formation of Hole Injection Layer 3 by Vacuum evaporation method

When forming the hole injection layer 3 by using a vacuum evaporation, one or more constituent materials (such as the hole transporting compound, and the electron-accepting compound) of the hole injection layer 3 are placed in a crucible installed in a vacuum chamber (in separate crucibles when two or more materials are used), and inside of the vacuum chamber is evacuated with a suitable vacuum pump to about 10⁻⁴ Pa. The crucible (each of the crucibles when two or more materials are used) is heated to evaporate the content in controlled evaporation amounts (evaporation amounts are independently controlled when two or more materials are used), and form the hole injection layer 3 on the anode 2 formed on the substrate 1 disposed opposite the crucible. When two or more materials are used, the hole injection layer 3 may be formed by heating and evaporating the mixture of these materials placed in a crucible.

The degree of vacuum in the evaporation is not particularly limited, as long as it is not detrimental to the advantages of the present invention, and is typically 0.1 × 10⁻⁶ Torr (0.13 × 10⁻⁴ Pa) or more, typically 9.0 × 10⁻⁶ Torr (12.0 × 10⁻⁴ Pa) or less. The evaporation rate is not limited, as long as it is not detrimental to the advantages of the present invention, and is typically 0.1 Å/second or more, typically 5.0 Å/second or less. The evaporation temperature in the evaporation is not limited, as long as it is not detrimental to the advantages of the present invention, and is preferably 10°C or more, preferably 50°C or less.

### Hole Transport Layer

The hole transport layer 4 may be formed on the hole injection layer 3 when the hole injection layer 3 is present, and on the anode 2 when the hole injection layer 3 is not present. The organic electroluminescent element of the present invention may be configured without the hole transport layer 4. However, as described above, the organic electroluminescent element of the present invention preferably has the hole transport layer.

The method used to form the hole transport layer 4 is not particularly limited, and may be a vacuum evaporation method or a wet film forming method. However, from the standpoint of reducing dark spots, it is preferable to form the hole transport layer 4 by using a wet film forming method.

The material forming the hole transport layer 4 is preferably one that has high hole transportability, and that can efficiently transport the injected holes. It is therefore preferable that the material has small ionization potential, high transparency for visible light, large hole mobility, and excellent stability, and does not easily generate trapping impurities during production or use. Further, because the hole transport layer 4 is often in contact with the light emitting layer 5, the material preferably does not quench the emission from the light emitting layer 5, or form an exciplex between the hole transport layer 4 and the light emitting layer 5 so that there is no lowering of efficiency.

Conventional materials usable as constituent material of the hole transport layer 4 may be used as the material of the hole transport layer 4. For example, the materials exemplified above as the hole transporting compounds used for the hole injection layer 3 may be used. Examples include arylamine derivatives, fluorene derivatives, spiro derivatives, carbazole derivatives, pyridine derivatives, pyrazine derivatives, pyrimidine derivatives, triazine derivatives, quinoline derivatives, phenanthroline derivatives, phthalocyanine derivatives, porphyrin derivatives, silole derivatives, oligothiophene derivatives, condensed polycyclic aromatic derivatives, and metal complexes.

Other examples include polyvinylcarbazole derivatives, polyarylamine derivatives, polyvinyltriphenylamine derivatives, polyfluorene derivatives, polyarylene derivatives, tetraphenylbenzidine-containing polyarylene ether sulfone derivatives, polyarylenevinylene derivatives, polysiloxane derivatives, polythiophene derivatives, and poly(p-phenylenevinylene) derivatives. These may be alternate copolymers, random polymers, block polymers, or graft copolymers. Further, these may be polymers having a branched main chain with three terminal portions, or may be compounds commonly referred to as dendrimers.

Polyarylamine derivatives, and polyarylene derivatives are preferred.

Preferably, the polyarylamine derivatives are polymers having the repeating unit of the following formula (II), particularly preferably polymers formed of the repeating unit of the following formula (II). In this case, Ar^{a} and Ar^{b} in the repeating unit may be different. 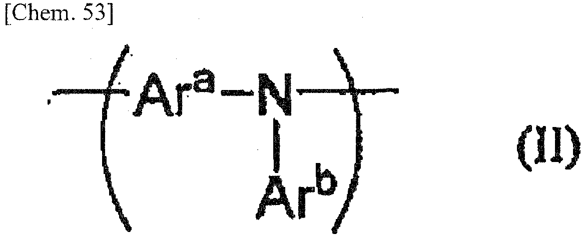 (In the formula (II), Ar^{a} and Ar^{b} each independently represent an aromatic hydrocarbon group that may have a substituent, or an aromatic heterocyclic group that may have a substituent.)

Examples of the optionally substituted aromatic hydrocarbon group represented by Ar^{a} and Ar^{b} include groups derived from a six-membered monocyclic ring or fused rings of 2 to 5 six-membered rings, such as a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a fluoranthene ring, and a fluorene ring, and groups containing two or more of these rings joined to each other via a direct bond.

Examples of the optionally substituted aromatic heterocyclic group include groups derived from a five- or six-membered monocyclic ring or fused rings of 2 to 4 five- or six-membered rings, such as a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzoisooxazole ring, a benzoisothiazole ring, a benzoimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a perimidine ring, a quinazoline ring, a quinazolinone ring, and an azulene ring, and groups containing two or more of these rings joined to each other via a direct bond.

For solubility and heat resistance, Ar^{a} and Ar^{b} are preferably each independently groups derived from a ring selected from a benzene ring, a naphthalene ring, an anthracene ring, a phenanthrene ring, a triphenylene ring, a pyrene ring, a thiophene ring, a pyridine ring, and a fluorene ring, or groups containing two or more benzene rings joined to each other (for example, a biphenyl group, and a terphenylene group).

Particularly preferred are benzene ring-derived groups (phenyl), groups containing two benzene rings joined to each other (biphenyl), and fluorene ring-derived groups (fluorenyl).

Examples of the substituent of the aromatic hydrocarbon group and the aromatic heterocyclic group represented by Ar^{a} and Ar^{b} include alkyl, alkenyl, alkynyl, alkoxy, aryloxy, alkoxycarbonyl, dialkylamino, diarylamino, acyl, halogen atom, haloalkyl, alkylthio, arylthio, silyl, siloxy, cyano, aromatic hydrocarbon ring, and aromatic heterocyclic group.

Examples of the polyarylene derivatives include polymers in which an arylene group such as the optionally substituted aromatic hydrocarbon group or aromatic heterocyclic group exemplified for Ar^{a} and Ar^{b} in the formula (II) is contained as a repeating unit.

The polyarylene derivatives are preferably polymers having a repeating unit represented by the following formulae (V-1) and/or (V-2). 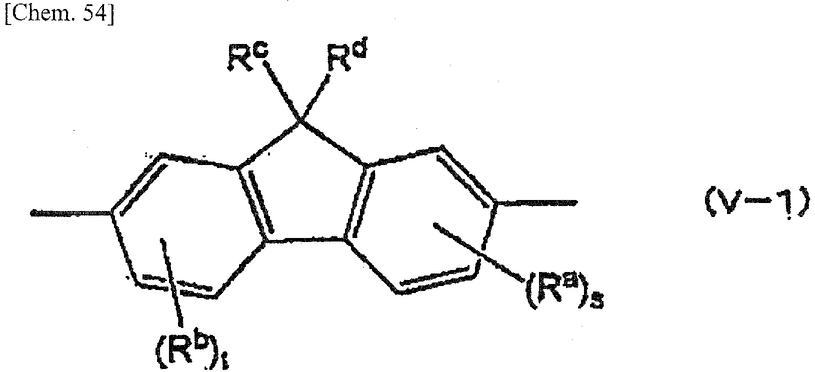 (In the formula (V-1), R^{a}, R^{b}, R^{c}, and R^{d} each independently represent alkyl, alkoxy, phenylalkyl, phenylalkoxy, phenyl, phenoxy, alkylphenyl, alkoxyphenyl, alkylcarbonyl, alkoxycarbonyl, and carboxy. t and s each independently represent an integer of 0 to 3. When t or s is 2 or more, the plurality of R^{a} or R^{b} contained in a single molecule may be the same or different, and the adjacent R^{a} or R^{b} may together form a ring.) 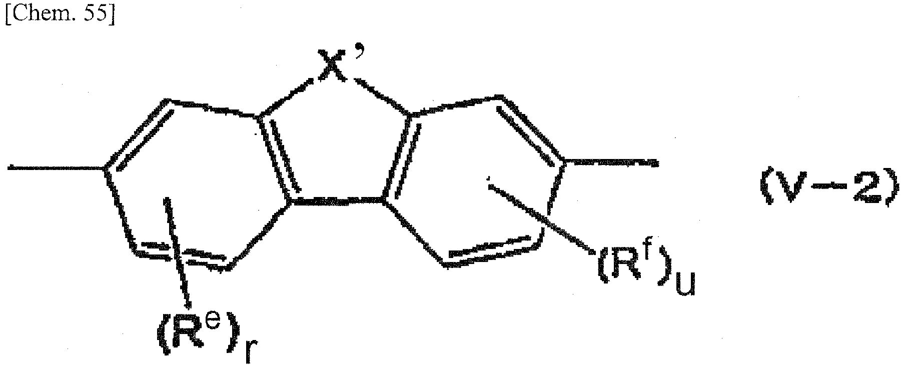 (In the formula (V-2), R^{e} and R^{f} each independently have the same meaning as R^{a} of the formula (V-1). r and u each independently represent an integer of 0 to 3. When r or u is 2 or more, the plurality of R^{e} and R^{f} contained in a single molecule may be the same or different, and the adjacent R^{e} or R^{f} may together form a ring. X' represents an atom or a group of atoms that forms a five-membered ring or a six-membered ring.)

Specific examples of X' include -O-, -BR-, -NR-, -SiR₂-, -PR-, -SR-, -CR₂-, and groups formed by binding of these groups. R represents a hydrogen atom, or any organic group. The organic groups in the present invention are groups that contain at least one carbon atom.

The polyarylene derivatives preferably have the repeating unit of the following formula (V-3), in addition to the repeating unit represented by the formulae (V-1) and/or (V-2). 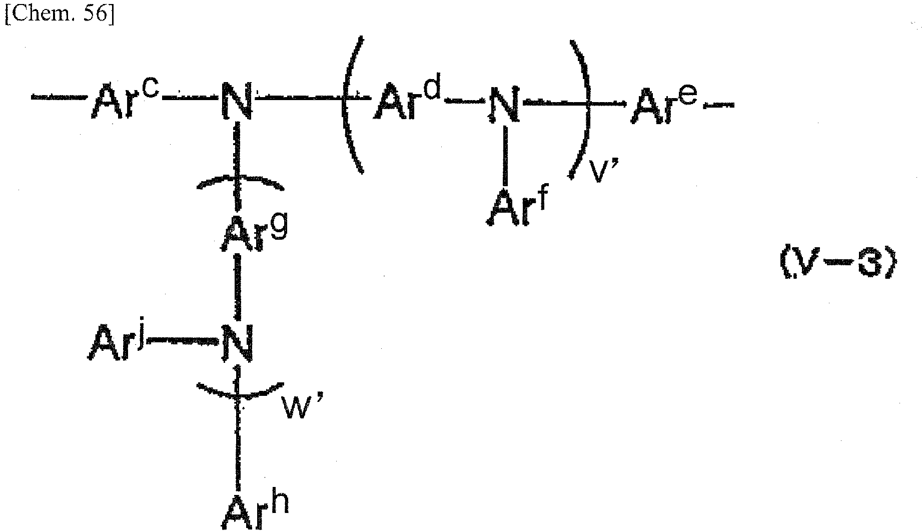 (In the formula (V-3), Ar^{c} to Ar^{h}, and Ar^{j} each independently represent an aromatic hydrocarbon group that may have a substituent, or an aromatic heterocyclic group that may have a substituent. v' and w' each independently represent 0 or 1.)

Specific examples of Ar^{c} to Ar^{h}, and Ar^{j} are the same as those exemplified for Ar^{a} in the formula (II).

Specific examples of the formulae (V-1) to (V-3), and specific examples of the polyarylene derivatives include those described in JP-A-2008-98619.

When the hole transport layer 4 is formed by using a wet film forming method, the hole transport layer forming composition is prepared first, and this is followed by wet film formation and heat drying, as with the case of the hole injection layer 3.

The hole transport layer forming composition contains a solvent, in addition to the hole transporting compound. The same solvent used for the hole injection layer forming composition is used. The film formation conditions, and heating and drying conditions are also the same as for the hole injection layer 3.

When using a vacuum evaporation method to form the hole transport layer 4, the evaporation and other conditions are the same as for the hole injection layer 3.

The hole transport layer 4 may contain components such as various light emitting materials, electron transporting compounds, binder resins, and coat improvers, in addition to the hole transporting compound.

The hole transport layer 4 may be a layer formed by crosslinking a crosslinking compound. The crosslinking compound is a compound having a crosslinking group, and forms a meshed polymer compound upon being crosslinked.

Examples of the crosslinking group include cyclic ether-derived groups such as oxetane, and epoxy; unsaturated double bond-derived groups such as vinyl, trifluorovinyl, styryl, acryl, methacryloyl, and cinnamoyl; and benzocyclobutene-derived groups.

The crosslinking compound may be a monomer, an oligomer, or a polymer. The crosslinking compound may be used either alone, or in any combination and proportion of two or more.

Preferably, a hole transporting compound having a crosslinking group is used as the crosslinking compound. The hole transporting compound may be one exemplified above, for example, one in which a crosslinking group is bound to the main chain or side chain of the hole transporting compound. Preferably, the crosslinking group is bound to the main chain via a linking group such as an alkylene group. The hole transporting compound is preferably a polymer that contains a repeating unit having a crosslinking group, preferably a polymer having the repeating unit of the formula (II) or formula (V-1), (V-2), or (V-3) with a crosslinking group bound thereto either directly or via a linking group.

Examples of the hole transporting compound having a crosslinking group include nitrogen-containing aromatic compound derivatives such as pyridine derivatives, pyrazine derivatives, pyrimidine derivatives, triazine derivatives, quinoline derivatives, phenanthroline derivatives, carbazole derivatives, phthalocyanine derivatives, and porphyrin derivatives; triphenylamine derivatives; silole derivatives; oligothiophene derivatives, condensed polycyclic aromatic derivatives, and metal complexes. Preferred are nitrogen-containing aromatic derivatives such as pyridine derivatives, pyrazine derivatives, pyrimidine derivatives, triazine derivatives, quinoline derivatives, phenanthroline derivatives, and carbazole derivatives; triphenylamine derivatives, silole derivatives, condensed polycyclic aromatic derivatives, and metal complexes. Particularly preferred are triphenylamine derivatives.

The hole transport layer 4 is formed by crosslinking the crosslinking compound, typically as follows. A hole transport layer forming composition prepared by dissolving or dispersing the crosslinking compound in a solvent is deposited by wet film formation to crosslink the crosslinking compound.

The hole transport layer forming composition may contain additives that promote the crosslink reaction, in addition to the crosslinking compound. Examples of the additives that promote the crosslink reaction include polymerization initiators and polymerization promoting agents such as alkylphenone compounds, acylphosphine oxide compounds, metallocene compounds, oxime ester compounds, azo compounds, and onium salts; and photo sensitizers such as condensed polycyclic hydrocarbon, porphyrin compounds, and diarylketone compounds.

The hole transport layer forming composition may also contain additives such as coat improvers (such as leveling agents, and defoaming agents), electron-accepting compounds, and binder resins.

The hole transport layer forming composition contains the crosslinking compound typically in 0.01 weight% or more, preferably 0.05 weight% or more, further preferably 0.1 weight% or more, typically 50 weight% or less, preferably 20 weight% or less, further preferably 10 weight% or less.

The hole transport layer forming composition containing the crosslinking compound in these concentration ranges is deposited on the underlayer (typically, the hole injection layer 3), and irradiated with activation energy (for example, heat and/or light) to crosslink the crosslinking compound and form the meshed polymer compound.

The temperature, humidity, and other film formation conditions are the same as those used in the wet film formation of the hole injection layer.

The technique used for the heating after the film formation is not particularly limited. Heating is performed under the temperature condition of typically 120°C or more, preferably 400°C or less.

Heating time is typically 1 minute or more, preferably 24 hours or less. The heating means is not particularly limited, and a laminate with the deposited layers may be heated on a hot plate, or in an oven. For example, heating may be performed on a hot plate at 120°C or more for at least 1 minute.

Irradiation of activation energy such as light may be performed by using methods that directly make use of ultraviolet, visible, and infrared light sources such as a ultra high-pressure mercury lamp, a high-pressure mercury lamp, a halogen lamp, and an infrared lamp, or methods that use a mask aligner and a conveyor-type photoirradiator equipped with these light sources.

Irradiation of activation energy other than light may be performed, for example, by irradiating microwaves generated by a magnetron, specifically by using an irradiation method that uses a microwave.

Irradiation time is preferably set to satisfy conditions required to lower the film solubility, and is typically 0.1 seconds or more, preferably 10 hours or less.

Irradiation of activation energy such as heat and light may be performed either alone or in combination. When performed in combination, the order is not particularly limited.

The hole transport layer 4 formed as above has a thickness of typically 5 nm or more, preferably 10 nm or more, and typically 300 nm or less, preferably 100 nm or less.

### Light Emitting Layer

The light emitting layer 5 is provided on the hole injection layer 3, or on the hole transport layer 4 when the hole transport layer 4 is provided. The light emitting layer 5 is a layer that serves as the main light source upon being excited by the recombination of the holes injected from the anode 2 and the electrons injected from the cathode 9 between the electrodes under applied electric field.

The light emitting layer 5 is as described in the foregoing Light Emitting Layer section.

### Hole Blocking Layer

The hole blocking layer 6 is provided between the light emitting layer 5 and the electron injection layer 8 (described later). The hole blocking layer 6 is a layer laminated on the light emitting layer 5 in contact therewith at the interface of the light emitting layer 5 on the cathode 9 side. The hole blocking layer 6 is as described in the foregoing Hole Blocking Layer section.

### Electron Transport Layer

The electron transport layer 7 may be provided between the hole blocking layer 6 and the electron injection layer 8 (described later).

The electron transport layer 7 is provided to further improve the luminescence efficiency of the element, and is formed of a compound that can efficiently transport the injected electrons from the cathode 9 toward the light emitting layer 5 between the electrodes under applied electric field.

The electron transporting compound used for the electron transport layer 7 is typically a compound having high injection efficiency for the electrons from the cathode 9 or the electron injection layer 8, and high electron mobility, capable of efficiently transporting the injected electrons. Examples of the compounds satisfying such conditions include metal complexes (such as an aluminum complex of 8-hydroxyquinoline) (JP-A-59-194393), metal complexes of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trisbenzimidazolylbenzene (US Patent 5645948), quinoxaline compounds (JP-A-6-207169), phenanthroline derivatives (JP-A-5-331459), 2-t-butyl-9,10-N,N'-dicyanoanthraquinone diimine, n-type hydrogenated amorphous silicon carbide, n-type zinc sulfide, and n-type zinc selenide.

The material of the electron transport layer 7 may be used either alone, or in any combination and proportion of two or more.

The method used to form the electron transport layer 7 is not limited, and may be any method, including a wet film forming method, and a vapor evaporation method.

The electron transport layer 7 may have any thickness, as long as it is not detrimental to the advantages of the present invention. The thickness of the electron transport layer 7 is typically 1 nm or more, preferably 5 nm or more, and typically 300 nm or less, preferably 100 nm or less.

### Electron Injection Layer

The electron injection layer 8 has a role of efficiently injecting the injected electrons from the cathode 9 to the layers on the side of the light emitting layer 5. For efficient electron injection, metals having small work functions are preferably used as the material of the electron injection layer 8. For example, alkali metals such as sodium and cesium, and alkali earth metals such as barium and calcium are used. Typically, the thickness is preferably 0.1 nm or more, and 5 nm or less.

Organic electron transport compounds as represented by nitrogen-containing heterocyclic compounds such as bathophenanthroline, and metal complexes such as an 8-hydroxyquinoline aluminum complex may be doped with an alkali metal such as sodium, potassium, cesium, lithium, and rubidium (described in JP-A-10-270171, JP-A-2002-100478, JP-A-2002-100482, and elsewhere). This is preferable, because it can improve electron injectability and transportability while providing excellent film quality at the same time. In this case, the thickness is typically 5 nm or more, preferably 10 nm or more, and typically 200 nm or less, preferably 100 nm or less.

Methods that use a ultrathin insulating film (0.1 to 5 nm) formed of materials, for example, such as lithium fluoride (LiF), magnesium fluoride (MgF₂), lithium oxide (Li₂O), and cesium(II) carbonate (CsCO₃) are also effective at improving the element efficiency (see, for example, Applied Physics Letters, 1997, Vol. 70, pp. 152; JP-A-10-74586; IEEE Transactions on Electron Devices, 1997, Vol. 44, pp. 1245; and SID 04 Digest, pp. 154).

The material of the electron injection layer 8 may be used either alone, or in any combination and proportion of two or more.

The method used to form the electron injection layer 8 is not limited, and may be any method, including a wet film forming method, and a vapor evaporation method.

### Cathode

The cathode 9 has a role of injecting electrons to the layers (such as the electron injection layer 8, and the hole blocking layer 6) on the side of the light emitting layer 5.

The same materials used for the anode 2 may be used for the cathode 9. However, for efficient electron injection, metals having small work functions, for example, such as suitable metals (e.g., tin, magnesium, indium, calcium, aluminum, and silver), and alloys thereof are preferably used. Specific examples include small-work-function alloy electrodes such as a magnesium-silver alloy, a magnesium-indium alloy, and an aluminum-lithium alloy.

The material of the cathode 9 may be used either alone, or in any combination and proportion of two or more.

The cathode 9 typically may have the same thickness as the anode 2.

For the protection of the cathode 9 formed of small-work-function metal, it is preferable to laminate an atmosphere-stable metal layer having a large work function, because it makes the element more stable. For this purpose, metals, for example, such as aluminum, silver, copper, nickel, chromium, gold, and platinum are used. These materials may be used either alone, or in any combination and proportion of two or more.

### Other Layers

The organic electroluminescent element according to the present invention may have other configurations, provided that such changes do not depart from the gist of the present invention. For example, any layer different from the layers described above may be provided between the anode 2 and the cathode 9, or any of the layers may be omitted, provided that the performance is maintained.

An example of such an additional layer is an electron blocking layer.

The electron blocking layer is provided between the hole injection layer 3 or the hole transport layer 4 and the light emitting layer 5, and prevents the incoming electrons from the light emitting layer 5 from reaching the hole injection layer 3 to increase the probability of hole and electron recombination in the light emitting layer 5, and confine the generated excitons in the light emitting layer 5. Another role of the electron blocking layer is to efficiently transport the injected holes from the hole injection layer 3 toward the light emitting layer 5. It is particularly effective to provide the electron blocking layer when a phosphorescent material is used as the light emitting material, or when blue emitting material is used.

Some of the properties required of the electron blocking layer include high hole transportability, large energy gap (the difference between HOMO and LUMO), and high excited triplet level (Tl). In the present invention, the electron blocking layer needs to have compatibility to wet film formation when the light emitting layer 5 is produced as the organic layer of the present invention by using a wet film forming method. Examples of such materials of the electron blocking layer include the dioctylfluorene and triphenylamine copolymer as represented by F8-TFB (WO2004/084260).

The material of the electron blocking layer may be used either alone, or in any combination and proportion of two or more.

The method used to form the electron blocking layer is not limited, and may be any method, including a wet film forming method, and a vapor evaporation method.

In the layer configuration described above, the constituting elements, except for the substrate, may be laminated in the reversed order. For example, referring to the layer configuration shown in FIG. 1, the cathode 9, the electron injection layer 8, the electron transport layer 7, the hole blocking layer 6, the light emitting layer 5, the hole transport layer 4, the hole injection layer 3, and the anode 2 may be formed on the substrate 1 in this order.

Further, the organic electroluminescent element according to the present invention may be formed by laminating the constituting elements other than the substrate between a pair of substrates at least one of which is transparent.

It is also possible to have a structure in which the constituting elements (emission units) other than the substrate are laminated in multiple stages (a structure with laminated emission units). In this case, it is preferable to provide a carrier generation layer (CGL) of, for example, vanadium pentoxide (V₂O₅) instead of the interface layers (ITO and A1 when these are used for anode and cathode, respectively) between the different stages (between the emission units), because it creates fewer barriers between the stages, and improves luminescence efficiency and driving voltage.

Further, the organic electroluminescent element according to the present invention may be configured as a single organic electroluminescent element, or may be applied to a configuration in which a plurality of organic electroluminescent elements is disposed in an array, or a configuration in which the anode and the cathode are disposed in an X-Y matrix.

The layers described above may contain components other than the materials described above, provided that such addition is not detrimental to the advantages of the present invention.

### Organic EL Display

The organic EL display of the present invention uses the organic electroluminescent element of the present invention. The type and structure of the organic EL display of the present invention are not particularly limited, and the organic EL display may be assembled according to an ordinary method with the organic electroluminescent element of the present invention.

For example, the organic EL display of the present invention may be formed by using the method described in Organic EL Display (Ohm, published August 20, 2004, Shizuo Tokito, Chihaya Adachi, Hideyuki Murata).

### Organic EL Lighting

The organic EL lighting of the present invention uses the organic electroluminescent element of the present invention. The type and structure of the organic EL lighting of the present invention are not particularly limited, and the organic EL lighting may be formed according to an ordinary method with the organic electroluminescent element of the present invention.

### Examples

The present invention is described below in greater detail using Examples. It should be noted, however, that the present invention is not limited to the descriptions of the following Examples, as long as the contents of the invention do not depart from the gist of the present invention.

### Example 1

An organic electroluminescent element of the configuration shown in FIG. was produced.

### Anode

The anode 2 was formed on a glass substrate by patterning a deposited indium tin oxide (ITO) transparent conductive film (thickness 150 nm; deposited by sputtering; sheet resistance 15 Ω) into 2 mm-wide stripe patterns by using a common photolithography technique. The substrate 1 with the anode 2 was then subjected to a series of treatments, starting with ultrasonic washing with purified water, and water washing with purified water, followed by blow drying with nitrogen, and finally UV ozone washing.

### Hole Injection Layer

The hole injection layer 3 was formed on the anode 2 by using a wet film forming method, as follows.

A composition containing 2.5 weight% of a hole transporting corsslinking polymer compound (P1) having the repeating structure below, and 0.5 weight% of 4-isopropyl-4'-methyldiphenyl iodonium tetrakis(pentafluorophenyl)borate (electron-accepting compound) was prepared as a hole injection layer forming composition by dissolving these components in ethyl benzoate. The composition was then deposited on the ITO substrate by spin coating.

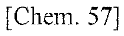

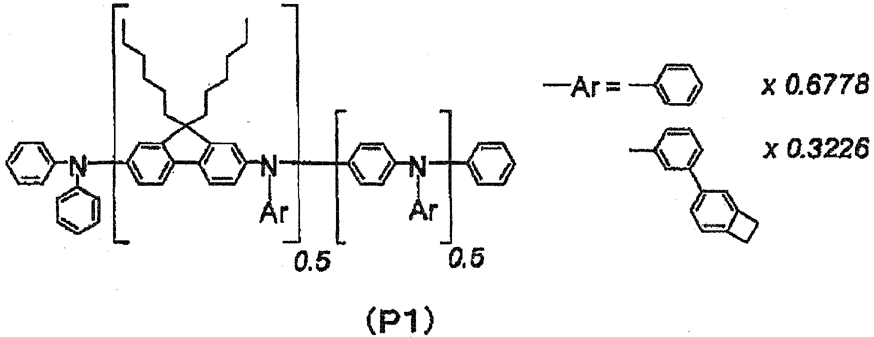

Spin coating was performed in two steps at a spinner rotation speed of 500 rpm for 2 seconds, and then 2,200 rpm for 30 seconds. The composition was dried by being heated in a 230°C clean oven for 60 min to cure the polymer compound (P1) in a crosslinking reaction. The resulting hole injection layer 3 had a thickness of 40 nm.

### Hole Transport Layer

The hole transport layer 4 was formed on the hole injection layer 3 by using a wet film forming method, as follows.

A hole transport layer forming composition as a solution of 1.0 weight% of a hole transporting crosslinking polymer compound (HT-1) having the repeating structure below (weight average molecular weight: 45,000) in cyclohexylbenzene was prepared. The composition was then deposited on the hole injection layer 3 by spin coating in a nitrogen atmosphere. In the following structural formula, "Hex" represents a hexyl group.

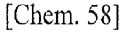

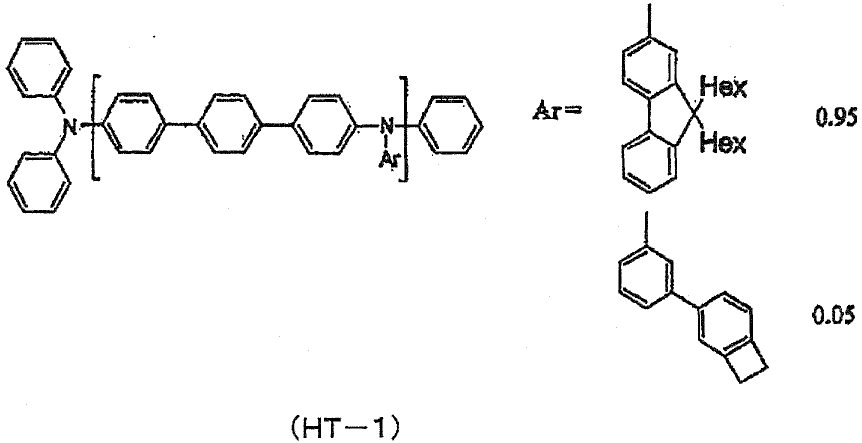

Spin coating was performed in two steps at a spinner rotation speed of 500 rpm for 2 seconds, and then 2,200 rpm for 120 seconds. The composition was dried by being heated in a 230°C clean oven for 60 min to cure the polymer compound (HT-1) in a crosslinking reaction. The resulting hole transport layer 4 had a thickness of 10 nm.

### Coated Light Emitting Layer

The coated light emitting layer was formed on the hole transport layer 4 by using a wet film forming method, as follows.

The compounds (GH-5), (GH-4), (GD-1), and (RD-2) below were mixed at a 25:75:10:1 weight ratio, and a composition dissolving 3 weight% of the mixture in cyclohexylbenzene was prepared. The composition was then deposited on the hole transport layer 4 by spin coating in a nitrogen atmosphere.

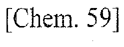

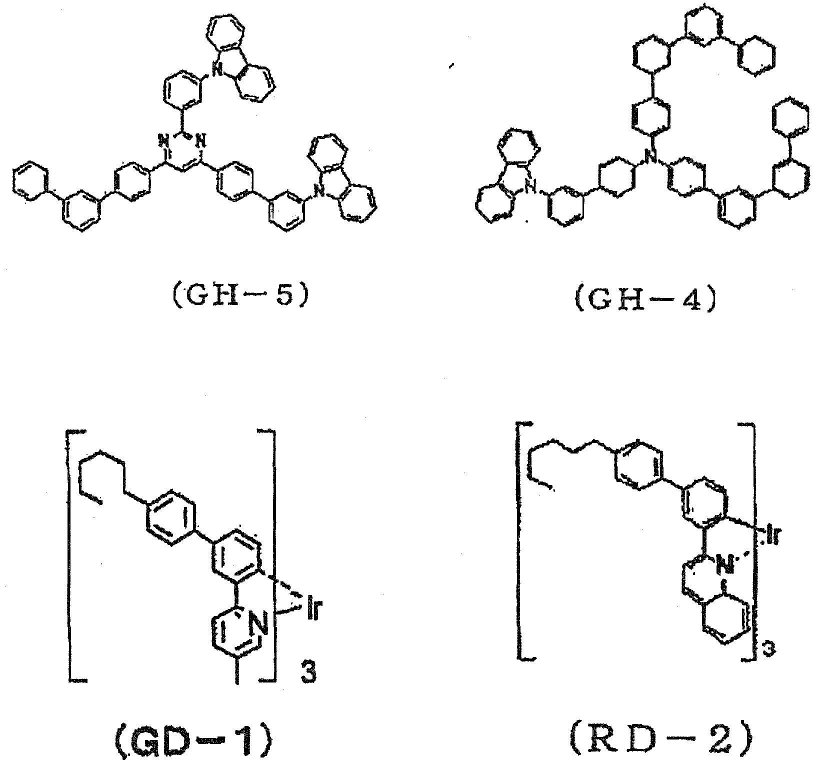

Spin coating was performed in two steps at a spinner rotation speed of 500 rpm for 2 seconds, and then 2,300 rpm for 120 seconds. The composition was dried at 120°C for 30 min. The resulting coated light emitting layer had a thickness of 30 nm.

### Vapor Deposited Light Emitting Layer

The vapor deposited light emitting layer was formed on the coated light emitting layer by using a vacuum evaporation method, as follows.

The compounds (BH-1) and (BD-1) below were co-vapor deposited at an evaporation rate ratio of 100:5 by using a vacuum evaporation method. The resulting vapor deposited light emitting layer had a thickness of 25 nm.

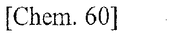

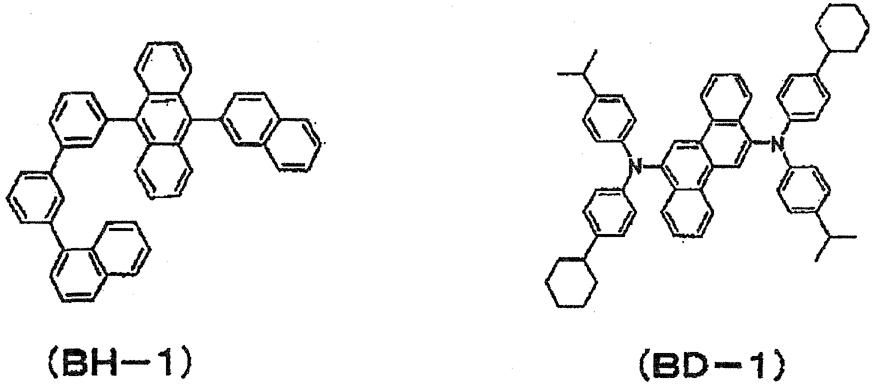

### Hole Blocking Layer

The compound (HB-1) below was deposited on the vapor deposited light emitting layer by using a vacuum evaporation method. The resulting hole blocking layer 6 had a thickness of 10 nm.

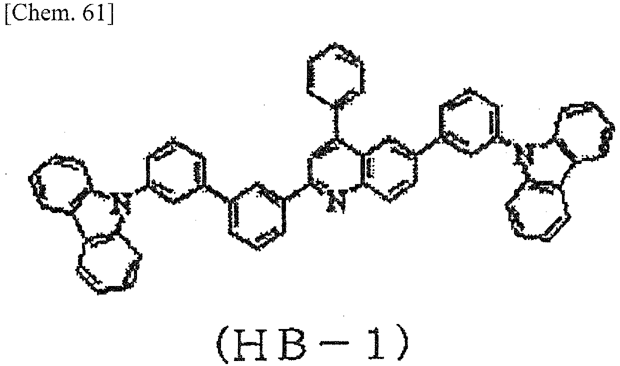

### Electron Transport Layer

The compound (ET-1) below was formed on the hole blocking layer 6 by using a vacuum evaporation method. The resulting electron transport layer 7 had a thickness of 15 nm.

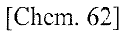

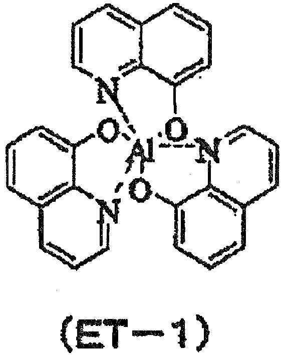

### Electron Injection Layer and Cathode

The element after the evaporation of the electron transport layer 7 was taken out of the vacuum evaporation apparatus into the atmosphere. Then, a stripe shadow mask measuring 2 mm in width and shaped to orthogonally cross the ITO stripes of the anode 2 was attached to the element as a cathode evaporation mask, and the element was installed in a separate vacuum evaporation apparatus. Lithium fluoride (LiF) and aluminum were then laminated as the electron injection layer 8 (0.5 nm thick) and the cathode 9 (80 nm thick), respectively, using the same vacuum evaporation method used for the electron transport layer 7.

### Sealing

In order to prevent the element from being deteriorated by the moisture or other atmosphere conditions during storage, sealing was performed according to the following method.

A light-curable resin, about 1 mm wide, was applied to the periphery of a 23 mm × 23 mm glass plate in a nitrogen atmosphere glove box, and a moisture getter sheet was placed at the central portion of the glass plate. The substrate with the finished cathode was then attached to the plate with the vapor deposited surface facing the desiccant sheet. Thereafter, only the light-curable resin applied regions were irradiated with ultraviolet rays to cure the resin. As a result, an organic electroluminescent element having a 2 mm × 2 mm emission area was obtained.

### Example 2

An organic electroluminescent element was produced in the same manner as in Example 1, except that the compound (HB-2) below was used as the material of the hole blocking layer 6.

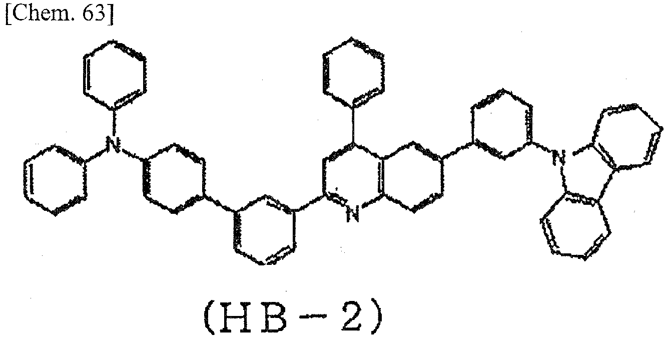

### Example 3

An organic electroluminescent element was produced in the same manner as in Example 1, except that the compound (HB-3) below was used as the material of the hole blocking layer 6.

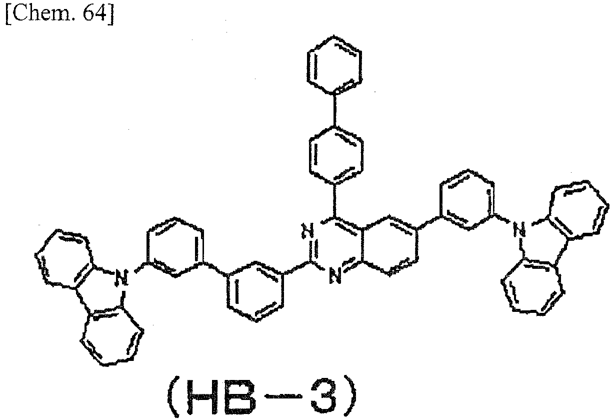

### Example 4

An organic electroluminescent element was produced in the same manner as in Example 1, except that the compound (HB-4) below was used as the material of the hole blocking layer 6.

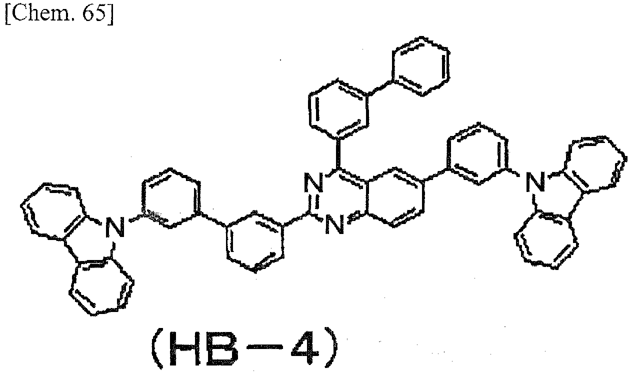

### Comparative Example 1

An organic electroluminescent element was produced in the same manner as in Example 1, except that the compound (HB-5) below was used as the material of the hole blocking layer 6.

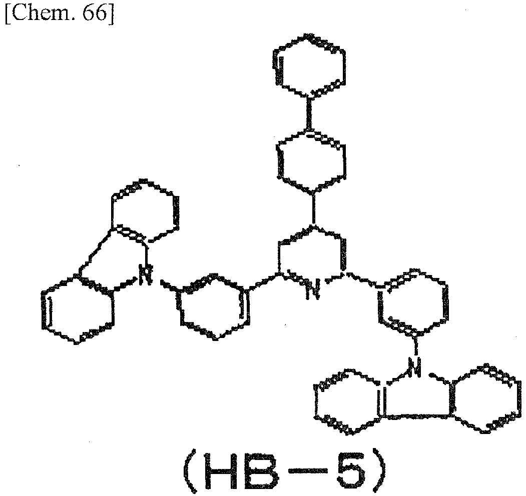

### Comparative Example 2

An organic electroluminescent element was produced in the same manner as in Example 1, except that the compound (HB-6) below was used as the material of the hole blocking layer 6.

| |
|---|
| [Chem. 67] |
| 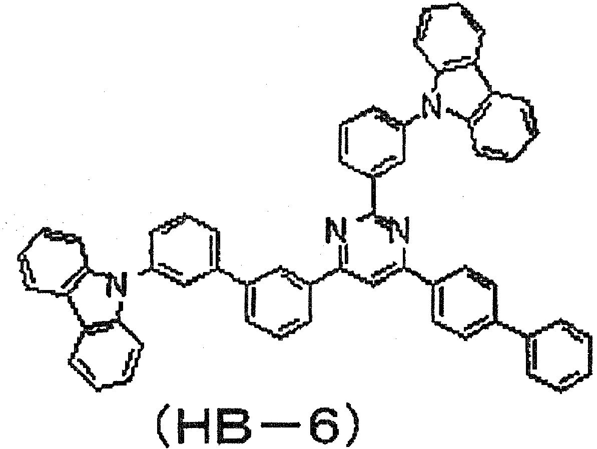 |

### Evaluation of Organic Electroluminescent Elements

The elements obtained in Examples 1 to 4 and Comparative Examples 1 and 2 were measured for driving voltage (VI) at 1 cd/m². The measured values were used to find V1-V₀ (hereinafter, "voltage change 1"), relative to the voltage V1 of Comparative Example 1 (V₀). The results are presented in Table 1.

**[Table 1]**

| | Hole blocking layer material | Voltage change 1 (V) |
|---|---|---|
| Ex. 1 | HB-1 | -0.26 |
| Ex. 2 | HB-2 | -0.26 |
| Ex. 3 | HB-3 | -0.19 |
| Ex. 4 | HB-4 | -0.18 |
| Com. Ex. 1 | HB-5 | 0 |
| Com. Ex. 2 | HB-6 | -0.12 |

The driving voltage is clearly lower in the organic electroluminescent elements of Examples 1 to 4 in which the compounds represented by the formula (1) were used as the hole blocking layer than in Comparative Examples 1 and 2 in which the hole blocking layer used the pyridine or pyrimidine compound.

The organic electroluminescent elements obtained in Examples 1 to 4 and Comparative Examples 1 and 2 all had maximum emission wavelengths at 462 nm, 519 nm, and 585 to 587 nm in the emission spectra.

### Example 5

An organic electroluminescent element was produced in the same manner as in Example except for the following.

### Hole Transport Layer

The hole transport layer was produced in the same manner as in Example 1, except that the compound (HT-2) below was used as the hole transport layer material, and that the spin coating was performed under different conditions.

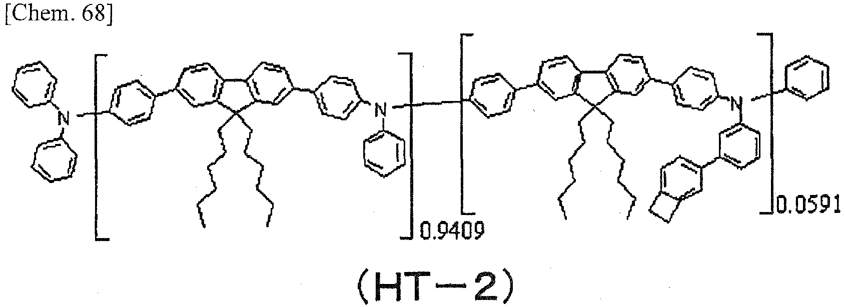

Spin coating was performed in two steps at a spinner rotation speed of 500 rpm for 2 seconds, and then 2,350 rpm for 120 seconds.

### Coated Light Emitting Layer

The coated light emitting layer was produced in the same manner as in Example 1, except that a 25:75:10 weight ratio mixture of (HB-5), (GH-4), and (RD-2) was used as the coated light emitting layer material.

### Vapor Deposited Light Emitting Layer

The vapor deposited light emitting layer was produced in the same manner as in Example 1, except that (BD-1) was used with the (BH-2) below as the vapor deposited light emitting layer material, and that the evaporation rate ratio was changed to 100:10.

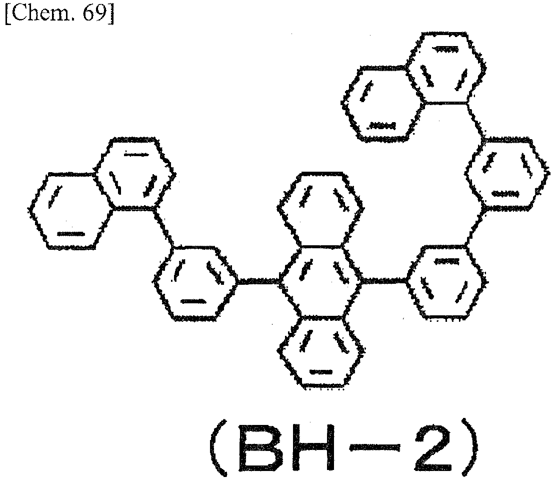

### Comparative Example 3

An organic electroluminescent element was produced in the same manner as in Example 5, except that (HB-6) was used as the material of the hole blocking layer 6.

### Comparative Example 4

An organic electroluminescent element was produced in the same manner as in Example 5 except for the following.

### Coated Light Emitting Layer

A 100:10 weight ratio mixture of (BH-2) and (BD-1) was prepared, and used as the coated light emitting layer material. A composition as the solution of 1.0 weight% of the mixture in cyclohexylbenzene was prepared, and spin coated under a nitrogen atmosphere.

Spin coating was performed in two steps at a spinner rotation speed of 500 rpm for 2 seconds, and then 1,500 rpm for 120 seconds. The composition was dried at 120°C for 30 min. The resulting coated light emitting layer had a thickness of 15 nm.

### Vapor Deposited Light Emitting Layer

The vapor deposited light emitting layer was formed in the same manner as in Example 5, except that (HB-5), (GH-4), and (RD-2) were used as the vapor deposited light emitting layer material at an evaporation rate ratio of 90:10:10, and that the layer was formed in a thickness of 30 nm.

### Evaluation of Organic Electroluminescent Elements

Voltage change 1 was determined relative to the voltage V1 of Comparative Example 3 (V₀). The elements of Example 5 and Comparative Examples 3 and 4 were each measured for driving voltage (V1K) at 1,000 cd/m², and the measured values were used to find V1K-V₀' (hereinafter, "voltage change 1 K"), where V₀' is the V1K of Comparative Example 3.

**[Table 2]**

| | Hole blocking layer material | Voltage change 1 (V) | Voltage change 1K (V) |
|---|---|---|---|
| Ex. 5 | HB-1 | -0.44 | -0.44 |
| Com. Ex. 3 | HB-6 | 0 | 0 |
| Com. Ex. 4 | HB-1 | 1.18 | 2.11 |

The results for Example 5 and Comparative Example 3 clearly demonstrate that using the compounds represented by formula (1) of the present invention for the hole blocking layer lowers the driving voltage of the organic electroluminescent element, regardless of the materials used for the hole transport layer, the coated light emitting layer, and the vapor deposited light emitting layer.

The organic electroluminescent elements obtained in Example 5 and Comparative Example 3 both had maximum emission wavelengths at 464 nm and 593 nm in the emission spectra.

It was also clearly demonstrated that the driving voltage of the organic electroluminescent element overly increased with the layer configuration of Comparative Example 4, in which the phosphorescent material used for the coated light emitting layer of Example 5, and the fluorescent material used for the vapor deposited light emitting layer of Example 5 were used for the vapor deposited light emitting layer and the coated light emitting layer, respectively.

The organic electroluminescent element obtained in Comparative Example 4 had maximum emission wavelengths at 464 nm and 576 nm in the emission spectrum.

### Example 6

An organic electroluminescent element was produced in the same manner as in Example 2 except for the following.

### Coated Light Emitting Layer

The coated light emitting layer was produced in the same manner as in Example 2, except that a 25:75:10:1 weight ratio mixture of (HB-6), (GH-4), (GD-2), and (RD-3) was used as the coated light emitting layer material.

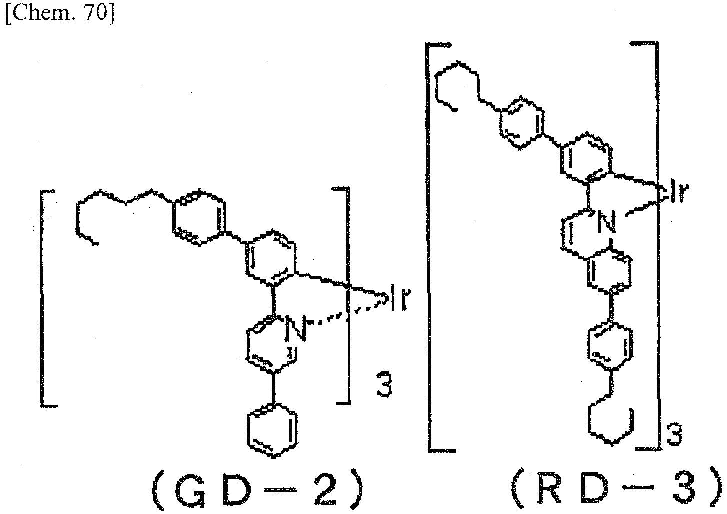

### Vapor Deposited Light Emitting Layer

The vapor deposited light emitting layer was produced in the same manner as in Example 2, except that (BH-2) and (BD-2) were used as the vapor deposited light emitting layer material, and that these were co-vapor deposited at an evaporation rate ratio of 100:5 by using a vacuum evaporation method.

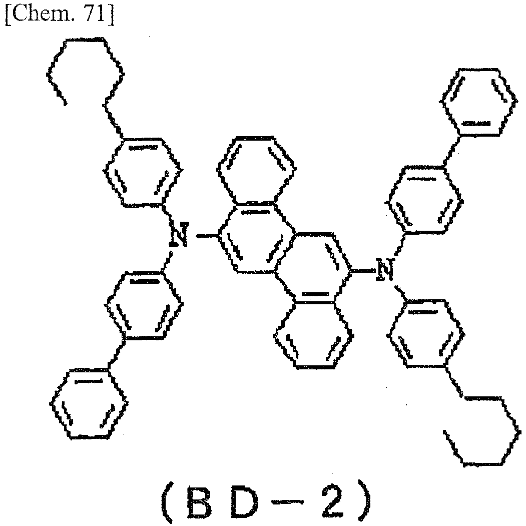

### Comparative Example 5

An organic electroluminescent element was produced in the same manner as in Example 6, except that the following compound (HB-7) was used as the material of the hole blocking layer 6.

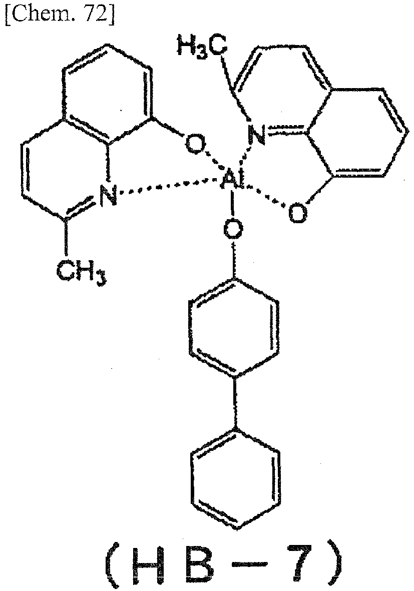

### Evaluation of Organic Electroluminescent Elements

Voltage change 1 was determined relative to the voltage V1 of Comparative Example 5 (V₀). Voltage change 1K was determined relative to the V1K of Comparative Example 5 (V₀'). The results are presented in Table 3.

**[Table 3]**

| | Hole blocking layer material | Voltage change 1 (V) | Voltage change 1K (V) |
|---|---|---|---|
| Ex. 6 | HB-2 | -0.54 | -0.66 |
| Com. Ex. 5 | HB-7 | 0 | 0 |

The driving voltage was clearly lower in the organic electroluminescent element that used the hole blocking layer material of the present invention than in the organic electroluminescent element in which the common hole blocking layer material (HB-7) was used.

The organic electroluminescent elements obtained in Example 6 and Comparative Example 5 both had maximum emission wavelengths at 463 to 464 nm, 557 to 558 nm, and 593 to 594 nm in the emission spectra.

### Example 7

An organic electroluminescent element was produced in the same manner as in Example 2, except for the following.

### Coated Light Emitting Layer

The coated light emitting layer was produced in the same manner as in Example 2, except that a 25:75:10:1 weight ratio mixture of (GH-5), (GH-6), (GD-3), and (RD-4) was used as the coated light emitting layer material.

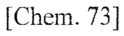

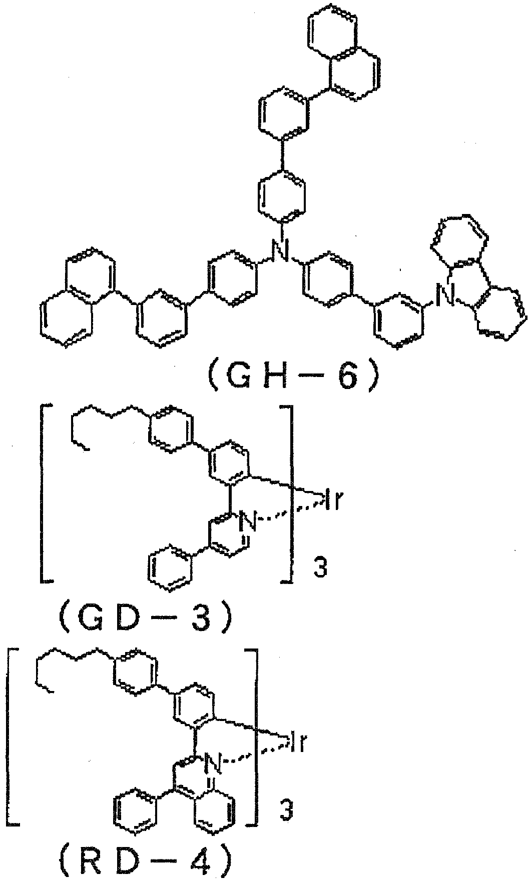

### Vapor Deposited Light Emitting Layer

The vapor deposited light emitting layer was produced in the same manner as in Example 2, except that (BH-2) and (BD-2) were used as the vapor deposited light emitting layer material, and that these were co-vapor deposited at an evaporation rate ratio of 100:5 by using a vacuum evaporation method.

### Comparative Example 6

An organic electroluminescent element was produced in the same manner as in Example 7, except that (HB-5) was used as the material of the hole blocking layer 6.

### Evaluation of Organic Electroluminescent Elements

Voltage change 1 was determined relative to the voltage V1 of Comparative Example 6 (V₀). Voltage change 1K was determined relative to the V1K of Comparative Example 6 (V₀'). The results are presented in Table 4.

**[Table 4]**

| | Hole blocking layer material | Voltage change 1 (V) | Voltage change 1K (V) |
|---|---|---|---|
| Ex. 7 | HB-2 | -0.28 | -0.53 |
| Com. Ex. 6 | HB-5 | 0 | 0 |

The driving voltage clearly decreased in the organic electroluminescent element of the present invention, regardless of the materials used for the coated light emitting layer and the vapor deposited light emitting layer.

The organic electroluminescent elements obtained in Example 7 and Comparative Example 6 both had maximum emission wavelengths at 464 nm and 599 nm in the emission spectra.

### Example 8

An organic electroluminescent element was produced in the same manner as in Example 2, except for the following.

### Coated Light Emitting Layer

The coated light emitting layer was produced in the same manner as in Example 2, except that a 25:75:10:1 weight ratio mixture of (GH-7), (GH-6), (GD-4), and (RD-3) was used as the coated light emitting layer material.

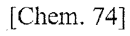

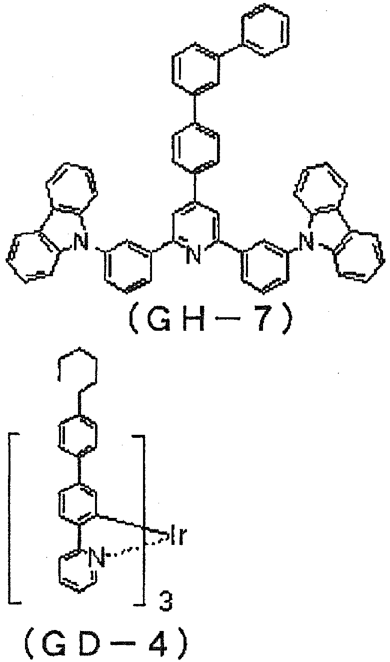

### Vapor Deposited Light Emitting Layer

The vapor deposited light emitting layer was produced in the same manner as in Example 2, except that (BH-2) and (BD-3) were used as the vapor deposited light emitting layer material, and that these were co-vapor deposited at an evaporation rate ratio of 100:5 by using a vacuum evaporation method.

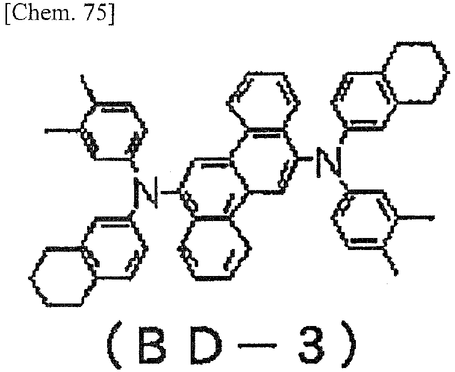

### Comparative Example 7

An organic electroluminescent element was produced in the same manner as in Example 8, except that (HB-5) was used as the material of the hole blocking layer 6.

### Evaluation of Organic Electroluminescent Elements

Voltage change 1 was determined relative to the voltage V1 of Comparative Example 7 (V₀). Voltage change 1K was determined relative to the voltage V1K of Comparative Example 7 (V₀'). The results are presented in Table 5.

**[Table 5]**

| | Hole blocking layer material | Voltage change 1 (V) | Voltage change 1K (V) |
|---|---|---|---|
| Ex. 8 | HB-2 | -0.17 | -0.44 |
| Com. Ex. 7 | HB-5 | 0 | 0 |

The driving voltage clearly decreased in the organic electroluminescent element of the present invention, regardless of the materials used for the coated light emitting layer and the vapor deposited light emitting layer.

The organic electroluminescent elements obtained in Example 8 and Comparative Example 7 both had maximum emission wavelengths at 467 nm, 534 nm, and 592 nm in the emission spectra.

The embodiments and concrete examples of implementation discussed in the foregoing detailed explanation serve solely to illustrate the details of the present invention, which may be applied in many variations or modifications within the spirit of the present invention as would be obvious to one skilled in the art.

The present application is based on Japanese Patent Application No. 2012-220399 filed October 2, 2012, and Japanese Patent Application No. 2013-146649 filed July 12, 2013, the entire contents of which are herein incorporated by reference.

### Reference Signs List

- 1: Substrate
- 2: Anode
- 3: Hole injection layer
- 4: Hole transport layer
- 5: Light emitting layer
- 6: Hole blocking layer
- 7: Electron transport layer
- 8: Electron injection layer
- 9: Cathode
- 10: Organic electroluminescent element

## Claims

1. An organic electroluminescent element comprising an anode, a cathode, and a plurality of light emitting layers formed between the anode and the cathode,
wherein the plurality of light emitting layers includes a first light emitting layer formed by using a wet film forming method, and a second light emitting layer formed by using a vacuum evaporation method, in this order from the anode side,
the first light emitting layer contains a phosphorescent material and a first charge transporting material, both of which are a low-molecular-weight compound,
the second light emitting layer contains a fluorescent material and a second charge transporting material, both of which are a low-molecular-weight compound,
the organic electroluminescent element includes a hole blocking layer adjacent to the cathode side of the second light emitting layer, and
the hole blocking layer contains a compound represented by the following formula (1): 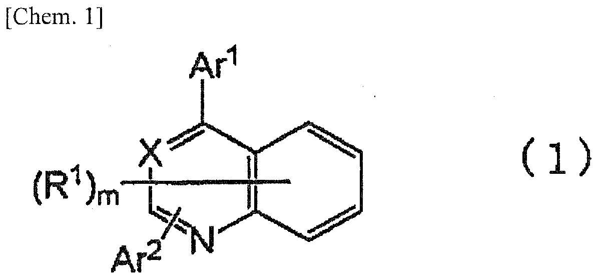 wherein X represents C or N, Ar¹ and Ar² each independently represents an optionally substituted aromatic ring group, R¹ represents an optionally substituted organic group of 50 or less carbon atoms, and may be the same or different when a plurality of R¹ exists, and m represents an integer of 0 to 5.

2. The organic electroluminescent element according to claim 1, wherein the compound represented by the formula (1) is a compound represented by the following formula (2): 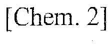 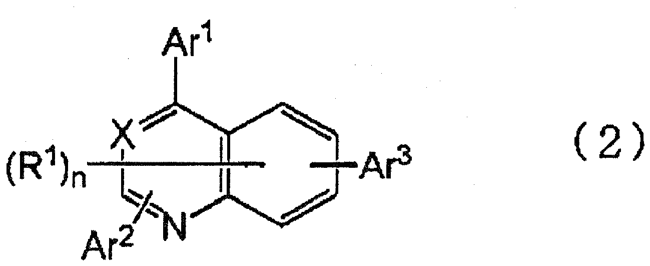 wherein X represents C or N, Ar¹ to Ar³ each independently represents an optionally substituted aromatic ring group, R¹ represents an optionally substituted organic group of 50 or less carbon atoms, and may be the same or different when a plurality of R¹ exists, and n represents an integer of 0 to 4.

3. The organic electroluminescent element according to claim 2, wherein the compound represented by the formula (2) is a compound represented by the following formula (3): 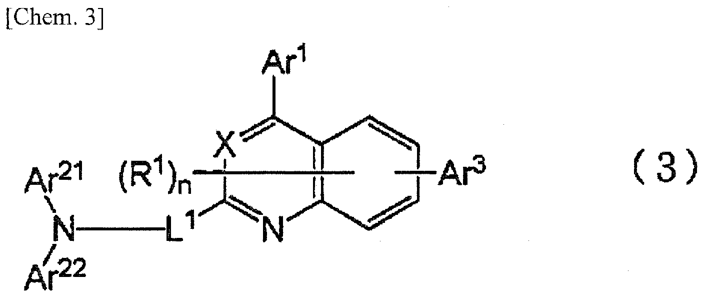 wherein X represents C or N, Ar¹, Ar³, Ar²¹, and Ar²² each independently represents an optionally substituted aromatic ring group, and Ar²¹ and Ar²² may be bonded to each other to form a ring, R¹ represents an optionally substituted organic group of 50 or less carbon atoms, and may be the same or different when a plurality of R¹ exists, L¹ represents a single bond, or an optionally substituted aromatic ring group of 25 or less carbon atoms, and n represents an integer of 0 to 4.

4. The organic electroluminescent element according to claim 3, wherein the compound represented by the formula (3) is a compound represented by the following formula (4): 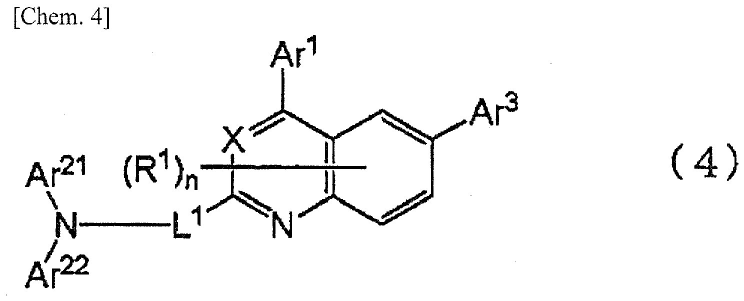 wherein X represents C or N, Ar¹, Ar³, Ar²¹, and Ar²² each independently represents an optionally substituted aromatic ring group, and Ar²¹ and Ar²² may be bonded to each other to form a ring, R¹ represents an optionally substituted organic group of 50 or less carbon atoms, and may be the same or different when a plurality of R¹ exists, L¹ represents a single bond, or an optionally substituted aromatic ring group of 25 or less carbon atoms, and n represents an integer of 0 to 4.

5. The organic electroluminescent element according to any one of claims 1 to 4, wherein Ar¹ in at least one of the formulae (1) to (4) is an aromatic hydrocarbon group.

6. The organic electroluminescent element according to any one of claims 1 to 5, wherein the organic electroluminescent element has an emission spectrum having a maximum emission wavelength in at least two of the 440 to 500 nm region, the 500 to 580 nm region, and the 580 to 630 nm region.

7. The organic electroluminescent element according to any one of claims 1 to 6, which comprises a hole transport layer between the anode and the light emitting layers.

8. The organic electroluminescent element according to claim 7, wherein the hole transport layer is a layer formed by using a wet film forming method.

9. An organic EL lighting comprising the organic electroluminescent element of any one of claims 1 to 8.

10. An organic EL display comprising the organic electroluminescent element of any one of claims 1 to 8.
